# EUROPEAN PATENT SPECIFICATION

(11) **EP 3 109 914 B1**
(45) Date of publication and mention of the grant of the patent: **28.04.2021**
(21) Application number: 15752676.5
(22) Date of filing: 16.02.2015
(51) Int. Cl.: C09D 5/24, C09D 11/52, C09D 165/00, C09D 179/02, C08K 5/42, H01B 1/12, H01L 51/00, H01L 51/50, H05B 33/10

(54) **CHARGE-TRANSPORTING VARNISH**
LADUNGSTRANSPORTLACK
VERNIS À TRANSPORT DE CHARGE

(30) Priority: 18.02.2014 JP 2014028462; 03.10.2014 JP 2014204996
(43) Date of publication of application: 28.12.2016
(73) Proprietor: Nissan Chemical Corporation, Tokyo (JP)
(72) Inventor: NAKAIE Naoki, Funabashi-shi Chiba 274-0052 (JP)
(74) Representative: Mewburn Ellis LLP
(86) International application number: PCT/JP2015/054084
(87) International publication number: WO 2015/125721

(56) References cited:
- EP-A1- 0 982 974
- EP-A1- 3 053 910
- WO-A1-02/42361
- WO-A1-2006/052246
- WO-A1-2012/026452
- WO-A2-03/018552
- CN-A- 101 328 256
- JP-A- 2008 243 557
- JP-A- 2014 238 564
- US-A- 5 981 695
- US-A1- 2011 042 661
- ULRIKE WENZEL: "Charakterisierung eines ultrahochmolekularen Polymethacrylats mit flüssigkristalliner Seitengruppe in verdünnter Lösung", DISSERTATION , vol. D83/2000 5 July 2000 (2000-07-05), page 78pp, XP007912815, Retrieved from the Internet: URL:http://opus.kobv.de/tuberlin/volltexte /2000/171/pdf/wenzel_ulrike.pdf [retrieved on 2010-04-26]
- Anonymus: "Polymer analysis by GPC-SEC Introduction", , 1 October 2000 (2000-10-01), pages 1-8, XP055396158, Retrieved from the Internet: URL:https://polymer.ustc.edu.cn/_upload/ar ticle/files/23/46/8007190f4e29a2673dc0b5c2 92ba/P020110906263097250048.pdf [retrieved on 2017-08-04]

## Description

### TECHNICAL FIELD

This invention relates to a charge-transporting varnish. More specifically, the invention relates to a charge-transporting varnish which reproducibly provides high-flatness thin-films.

### BACKGROUND ART

Organic electroluminescent (EL) devices are expected to see practical application in such fields as displays and lighting. A variety of research is being carried out on materials and device structures with the aim of achieving such properties as low-voltage driving, high brightness and longevity.

A plurality of functional thin-films are used in organic EL devices, one of which, the hole injection layer, is responsible for transferring charge between an anode and a hole-transporting layer or an emissive layer, and thus serves an important function in achieving low-voltage driving and high brightness in organic EL devices.

Processes for forming the hole injection layer are broadly divided into dry processes such as vapor deposition and wet processes such as spin coating. On comparing these processes, wet processes are better able to efficiently produce thin-films having a high flatness over a large surface area and therefore are often used particularly in the field of displays.

In view of the above, improvements in the wet process materials for hole injection layers are constantly being demanded. In particular, because they can help improve the brightness characteristics and longevity characteristics of organic EL devices, there has been a steady increase in the desire for materials which provide charge-transporting thin-films of excellent flatness.

### PRIOR ART DOCUMENTS

### PATENT DOCUMENTS

Patent Document 1: JP-A 2012-113101

### SUMMARY OF THE INVENTION

### PROBLEMS TO BE SOLVED BY THE INVENTION

Accordingly, there exists a desire for a charge-transporting varnish which reproducibly provides charge-transporting thin-films of excellent flatness.

### MEANS FOR SOLVING THE PROBLEMS

The inventor has conducted extensive investigations, discovering as a result that given amide derivatives are good at dissolving charge-transporting substances such as aniline derivatives and thiophene derivatives, that varnishes obtained by dissolving a charge-transporting substance in such an acid amide derivative are able to maintain the liquid film state, including a tendency to not agglomerate, required to achieve a thin-film of high flatness on electrodes made of, for example, indium-tin oxide (ITO) or indium-zinc oxide (IZO), and that charge-transporting thin-films of excellent flatness can therefore be reproducibly obtained.

Patent Document 1 discloses an acid amide-containing photoresist stripper composition, but does not disclose a charge-transporting varnish that uses such an acid amide as a good solvent. Moreover, this document neither teaches nor suggests that a charge-transporting thin-film of excellent flatness can be reproducibly obtained from such a varnish.

Accordingly, the disclosure provides the following charge-transporting varnish. The invention as claimed is specified in the appended claims.
1. A charge-transporting varnish comprising a charge-transporting substance and an organic solvent, which charge-transporting varnish is characterized in that the organic solvent includes, as a good solvent, an acid amide derivative of formula (A) below 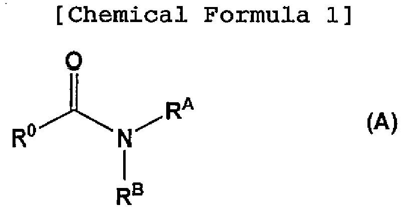 (wherein R⁰ is a propyl or isopropyl group, and R^{A} and R^{B} are each independently an alkyl group of 1 to 4 carbon atoms).
2. The charge-transporting varnish of 1 above, wherein the acid amide derivative is N,N-dimethylisobutyramide.
3. The charge-transporting varnish of 1 or 2 above, wherein the charge-transporting substance includes at least one compound selected from among aniline derivatives and thiophene derivatives.
4. The charge-transporting varnish of any one of 1 to 3 above which further comprises a dopant.
5. A charge-transporting thin-film produced using the charge-transporting varnish of any one of 1 to 4 above.
6. An organic electroluminescent device comprising the charge-transporting thin-film of 5 above.
7. A method of producing a charge-transporting thin-film, which method is characterized by using the charge-transporting varnish of any one of 1 to 4 above.
8. A method of fabricating an organic electroluminescent device, which method is characterized by using the charge-transporting thin-film of 5 above.
9. A method of planarizing a charge-transporting thin-film produced from a charge-transporting varnish containing a charge-transporting substance and an organic solvent, which method is characterized by using an acid amide derivative of formula (A) below as the organic solvent 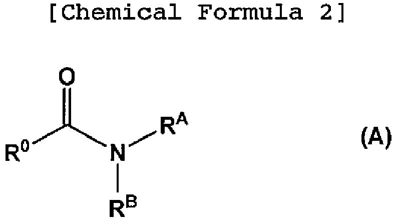 (wherein R⁰ is a propyl or isopropyl group, and R^{A} and R^{B} are each independently an alkyl group of 1 to 4 carbon atoms).

### ADVANTAGEOUS EFFECTS OF THE INVENTION

It is possible to employ the charge-transporting varnish of the invention in a variety of coating methods. By using this varnish, a charge-transporting thin-film of excellent flatness and uniformity can be reproducibly obtained by various types of wet processes. Moreover, because the charge-transporting thin-film obtained from the charge-transporting varnish of the invention has excellent flatness and uniformity, when employed as a hole injection layer in an organic EL device, a thin-film capable of achieving excellent brightness characteristics can be obtained. Additionally, use as, for example, a protective film for capacitor electrodes, an antistatic film, and an anode buffer layer in organic thin-film solar cells is also anticipated.

### BRIEF DESCRIPTION OF THE DIAGRAMS

[FIG. 1] Fig. 1 shows micrographs of thin-films produced in Working Example 2-1 and Comparative Examples 2-1 and 2-2.
[FIG. 2] Fig. 2 shows micrographs of thin-films produced in Working Example 2-2 and Comparative Examples 2-3 and 2-4.
[FIG. 3] Fig. 3 shows micrographs of thin-films produced in Working Example 2-3 and Comparative Examples 2-5 and 2-6.
[FIG. 4] Fig. 4 shows micrographs of thin-films produced in Working Example 2-4 and Comparative Examples 2-7 and 2-8.
[FIG. 5] Fig. 5 shows micrographs of thin-films produced in Working Example 2-5 and Comparative Examples 2-9 and 2-10.
[FIG. 6] FIG. 6 shows micrographs of thin-films produced in Working Examples 2-6 and 2-7.
[FIG. 7] FIG. 7 shows micrographs of thin-films produced in Working Examples 2-8 to 2-10.
[FIG. 8] FIG. 8 shows micrographs of thin-films produced in Working Examples 2-11 to 2-13.
[FIG. 9] FIG. 9 shows micrographs of thin-films produced in Working Examples 2-14 to 2-16.
[FIG. 10] FIG. 10 shows images obtained with a CCD camera of the light-emitting surfaces of organic EL devices produced in Working Example 3-1 and Comparative Examples 3-1 and 3-2.
[FIG. 11] FIG. 11 shows images obtained with a CCD camera of the light-emitting surfaces of organic EL devices produced in Working Example 3-2 and Comparative Examples 3-3 and 3-4.

### EMBODIMENT FOR CARRYING OUT THE INVENTION

The charge-transporting varnish of the invention includes a charge-transporting substance and an organic solvent. As used herein, "charge transportability" is synonymous with electrical conductivity, and is also synonymous with hole transportability. The charge-transporting varnish may itself have charge transportability, or a solid film obtained using the varnish may have charge transportability.

### [Organic Solvent]

The organic solvent includes, as a good solvent, an acid amide derivative of formula (A) below.

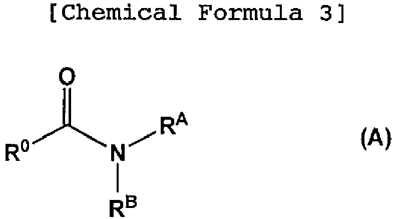

In the formula, R⁰ is a propyl or isopropyl group, with an isopropyl group being preferred. R^{A} and R^{B} are each independently an alkyl group of 1 to 4 carbon atoms. The alkyl group of 1 to 4 carbon atoms may be linear, branched or cyclic, and is exemplified by methyl, ethyl, propyl, isopropyl, cyclopropyl, n-butyl, isobutyl, s-butyl, t-butyl and cyclobutyl groups. Of these, R^{A} and R^{B} are preferably methyl or ethyl groups.

Examples of acid amide derivatives of formula (A) include N,N-dimethylbutyramide, N,N-diethylbutyramide, N,N-methylethylbutyramide, N,N-dimethylisobutyramide, N,N-diethylisobutyramide and N-ethyl-N-methylisobutyramide. Of these, N,N-dimethylisobutyramide is especially preferred.

The acid amide derivative of formula (A) may be synthesized by a substitution reaction between the corresponding carboxylic acid ester and amine, or a commercial product may be used.

Because the charge-transporting varnish of the invention includes an acid amide derivative of formula (A), using this varnish enables charge-transporting thin-films of excellent flatness and uniformity to be more reproducibly obtained by various types of wet processes than conventional varnishes.

The organic solvent used in this invention may include also other organic solvents in addition to the acid amide derivative of formula (A). Such organic solvents are exemplified by, but not limited to, the following:
amides such as N-methylformamide, N,N-dimethylformamide, N,N-diethylformamide, N-methylacetamide, N,N-dimethylacetamide, N-methylpropionamide, 1,3-dimethyl-2-imidazolidinone and N-methylpyrrolidone;
glycols such as diethylene glycol, triethylene glycol, tetraethylene glycol, dipropylene glycol, 1,2-ethanediol (ethylene glycol), 1,2-propanediol (propylene glycol), 1,2-butanediol, 2,3-butanediol, 1,3-butandiol, 1,4-butanediol, 1,5-pentanediol, 2-methyl-2,4-pentanediol (hexylene glycol), 1,3-octylene glycol and 3,6-octylene glycol;
triols such as glycerol;
alkylene glycol monoalkyl ethers, including ethylene glycol monoalkyl ethers such as ethylene glycol monomethyl ether, ethylene glycol monoethyl ether, ethylene glycol monopropyl ether, ethylene glycol monoisopropyl ether, ethylene glycol monobutyl ether, ethylene glycol monoisobutyl ether and ethylene glycol monohexyl ether, and propylene glycol monoalkyl ethers such as propylene glycol monomethyl ether, propylene glycol monoethyl ether, propylene glycol monopropyl ether, propylene glycol monoisopropyl ether, propylene glycol monobutyl ether, propylene glycol monoisobutyl ether and propylene glycol monohexyl ether;
alkylene glycol monoaryl ethers, including ethylene glycol monoaryl ethers such as ethylene glycol monophenyl ether, and propylene glycol monoaryl ethers such as propylene glycol monophenyl ether;
alkylene glycol monoaralkyl ethers, including ethylene glycol monoaralkyl ethers such as ethylene glycol monobenzyl ether, and propylene glycol monoaralkyl ethers such as propylene glycol monobenzyl ether;
alkylene glycol alkoxyalkyl ethers, including ethylene glycol alkoxyalkyl ethers such as ethylene glycol butoxyethyl ether, and propylene glycol alkoxyalkyl ethers such as propylene glycol butoxyethyl ether;
alkylene glycol dialkyl ethers, including ethylene glycol dialkyl ethers such as ethylene glycol dimethyl ether, ethylene glycol diethyl ether, ethylene glycol dipropyl ether, ethylene glycol diisopropyl ether and ethylene glycol dibutyl ether, and propylene glycol dialkyl ethers such as propylene glycol dimethyl ether, propylene glycol diethyl ether, propylene glycol dipropyl ether, propylene glycol diisopropyl ether and propylene glycol dibutyl ether;
alkylene glycol monoalkyl ether acetates, including ethylene glycol monoalkyl ether acetates such as ethylene glycol monomethyl ether acetate, ethylene glycol monoethyl ether acetate, ethylene glycol monopropyl ether acetate, ethylene glycol monoisopropyl ether acetate and ethylene glycol monobutyl ether acetate, and propylene glycol monoalkyl ether acetates such as propylene glycol monomethyl ether acetate, propylene glycol monoethyl ether acetate, propylene glycol monopropyl ether acetate, propylene glycol monoisopropyl ether acetate and propylene glycol monobutyl ether acetate;
alkylene glycol monoacetates, including ethylene glycol monoacetates such as ethylene glycol monoacetate and propylene glycol monoacetates such as propylene glycol monoacetate;
alkylene glycol diacetates, including ethylene glycol diacetates such as ethylene glycol diacetate and propylene glycol diacetates such as propylene glycol diacetate;
dialkylene glycol monoalkyl ethers, including diethylene glycol monoalkyl ethers such as diethylene glycol monomethyl ether, diethylene glycol monoethyl ether, diethylene glycol monopropyl ether, diethylene glycol monoisopropyl ether, diethylene glycol monobutyl ether, diethylene glycol monoisobutyl ether and diethylene glycol monohexyl ether, and dipropylene glycol monoalkyl ethers such as dipropylene glycol monomethyl ether, dipropylene glycol monoethyl ether, dipropylene glycol monopropyl ether, dipropylene glycol monoisopropyl ether, dipropylene glycol monobutyl ether, dipropylene glycol monoisobutyl ether and dipropylene glycol monohexyl ether;
dialkylene glycol monoaryl ethers, including diethylene glycol monoaryl ethers such as diethylene glycol monophenyl ether, and dipropylene glycol monoaryl ethers such as dipropylene glycol monophenyl ether;
dialkylene glycol dialkyl ethers, including diethylene glycol dialkyl ethers such as diethylene glycol dimethyl ether, diethylene glycol diethyl ether, diethylene glycol dipropyl ether, diethylene glycol diisopropyl ether and diethylene glycol dibutyl ether, and dipropylene glycol dialkyl ethers such as dipropylene glycol dimethyl ether, dipropylene glycol diethyl ether, dipropylene glycol dipropyl ether, dipropylene glycol diisopropyl ether and dipropylene glycol dibutyl ether;
dialkylene glycol monoalkyl ether acetates, including diethylene glycol monoalkyl ether acetates such as diethylene glycol monomethyl ether acetate, diethylene glycol monoethyl ether acetate, diethylene glycol monopropyl ether acetate, diethylene glycol monoisopropyl ether acetate, diethylene glycol monobutyl ether acetate, diethylene glycol monoisobutyl ether acetate and diethylene glycol monohexyl ether acetate, and dipropylene glycol monoalkyl ether acetates such as dipropylene glycol monomethyl ether acetate, dipropylene glycol monoethyl ether acetate, dipropylene glycol monopropyl ether acetate, dipropylene glycol monoisopropyl ether acetate, dipropylene glycol monobutyl ether acetate, dipropylene glycol monoisobutyl ether acetate and dipropylene glycol monohexyl ether acetate;
trialkylene glycol monoalkyl ethers, including triethylene glycol monoalkyl ethers such as triethylene glycol monomethyl ether and triethylene glycol monoethyl ether, and tripropylene glycol monoalkyl ethers such as tripropylene glycol monomethyl ether and tripropylene glycol monoethyl ether;
trialkylene glycol dialkyl ethers, Including triethylene glycol dialkyl ethers such as triethylene glycol dimethyl ether and triethylene glycol diethyl ether, and tripropylene glycol dialkyl ethers such as tripropylene glycol dimethyl ether and tripropylene glycol diethyl ether;
aliphatic alcohols, including linear aliphatic alcohols such as 1-propanol, 2-propanol, 1-butanol, 2-butanol, 1-pentanol, 1-hexanol, 1-heptanol, 1-nonanol, 1-decanol, 1-undecanol, 1-dodecanol and 1-tetradecanol, and cyclic aliphatic alcohols such as cyclohexanol and 2-methylcyclohexanol;
phenols such as phenol;
aromatic alcohols such as benzyl alcohol;
heterocycle-containing alcohols such as furfuryl alcohol;
hydrogenated heterocycle-containing alcohols such as tetrahydrofurfuryl alcohol;
dialkyl ethers such as diisopropyl ether, di-n-butyl ether and di-n-hexyl ether;
alkyl aryl ethers such as methyl phenyl ether, ethyl phenyl ether, n-butyl phenyl ether, benzyl (3-methylbutyl) ether, (2-methylphenyl) methyl ether, (3-methylphenyl) methyl ether and (4-methylphenyl) methyl ether;
alkyl aralkyl ethers such as ethyl benzyl ether;
cyclic alkyl monoethers such as 2-methylfuran, tetrahydrofuran and tetrahydropyran;
cyclic alkyl diethers such as 1,4-dioxane;
cyclic alkyl triethers such as trioxane;
diepoxyalkyl ethers such as diglycidyl ether;
alkyl acetates, including linear or branched alkyl acetates such as ethyl acetate, n-propyl acetate, isopropyl acetate, n-butyl acetate, isobutyl acetate, s-butyl acetate, t-butyl acetate, n-pentyl acetate, (3-methylbutyl) acetate, n-hexyl acetate, (2-ethylbutyl) acetate and (2-ethylhexyl) acetate, and cyclic alkyl acetates such as cyclohexyl acetate and 2-methylcyclohexyl acetate; alkyl propionates, including linear or cyclic alkyl propionates such as ethyl propionate, n-propyl propionate, isopropyl propionate, n-butyl propionate, isobutyl propionate, s-butyl propionate, t-butyl propionate, n-pentyl propionate, (3-methylbutyl) propionate, n-hexyl propionate, (2-ethylbutyl) propionate and (2-ethylhexyl) propionate, and cyclic alkyl propionates such as cyclohexyl propionate and 2-methylcyclohexyl propionate; alkyl butyrates, including linear or branched alkyl butyrates such as ethyl butyrate, n-propyl butyrate, isopropyl butyrate, n-butyl butyrate, isobutyl butyrate, s-butyl butyrate, t-butyl butyrate, n-pentyl butyrate, (3-methylbutyl) butyrate, n-hexyl butyrate and (2-ethylbutyl) butyrate, (2-ethylhexyl) butyrate, and cyclic alkyl butyrates such as cyclohexyl butyrate and 2-methylcyclohexyl butyrate; and alkyl lactates, including linear or branched alkyl lactates such as ethyl lactate, n-propyl lactate, isopropyl lactate, n-butyl lactate, isobutyl lactate, s-butyl lactate, t-butyl lactate, n-pentyl lactate, (3-methylbutyl) lactate, n-hexyl lactate, (2-ethylbutyl) lactate and (2-ethylhexyl) lactate, and cyclic alkyl lactates such as cyclohexyl lactate and 2-methylcyclohexyl lactate;
aralkyl alkyl esters, including aralkyl acetates such as benzyl acetate, aralkyl propionates such as benzyl propionate, aralkyl butyrates such as benzyl butyrate, and aralkyl lactates such as benzyl lactate;
dialkyl ketones such as diethyl ketone, diisobutyl ketone, methyl ethyl ketone, methyl n-propyl ketone, methyl n-butyl ketone, methyl isobutyl ketone, methyl n-propyl ketone, methyl n-hexyl ketone, ethyl n-butyl ketone and di-n-propyl ketone;
cyclic alkenyl ketones such as isophorone;
cyclic alkyl ketones such as cyclohexanone;
hydroxydialkyl ketones such as 4-hydroxy-4-methyl-2-pentanone (diacetone alcohol);
heterocyclic-containing aldehydes such as furfural;
linear or branched alkanes such as heptane, octane, 2,2,3-trimethylhexane, decane and dodecane;
alkylbenzenes such as toluene, xylene, o-xylene, m-xylene, p-xylene, mesitylene, tetralin and cyclohexylbenzene; and
cyclic alkanes such as cyclohexane, methylcyclohexane and ethylcyclohexane.
These solvents may be used singly, or two or more may be used together.

When an acid amide derivative of formula (A) and another organic solvent are used as the organic solvent, from the standpoint of reproducibly achieving film flatness and uniformity, the content of the acid amide derivative in the overall organic solvent is preferably at least 35 wt%, more preferably at least 50 wt%, even more preferably at least 55 wt%, still more preferably at least 60 wt%, and still yet more preferably at least 70 wt%, with a content of at least 75 wt%, or even at least 80 wt% being yet more preferable in this order.

When the charge-transporting varnish of the invention includes an organic solvent other than the acid amide derivative of formula (A), examples of the other organic solvent preferably include glycols, triols, alkylene glycols, alkylene glycol monoalkyl ethers, alkylene glycol dialkyl ethers, dialkylene glycol monoalkyl ethers and dialkylene glycol dialkyl ethers; more preferably include glycols, alkylene glycol monoalkyl ethers and dialkylene glycol monoalkyl ethers; still more preferably include diethylene glycol, triethylene glycol, dipropylene glycol, 1,2-ethanediol, 1,2-propanediol, 1,2-butanediol, 2,3-butanediol, 1,3-butanediol, 1,4-butanediol, ethylene glycol monomethyl ether, ethylene glycol monoethyl ether, ethylene glycol propyl ether, ethylene glycol isopropyl ether, ethylene glycol monobutyl ether, ethylene glycol monoisobutyl ether, propylene glycol monomethyl ether, propylene glycol monoethyl ether, propylene glycol monopropyl ether, propylene glycol monoisopropyl ether, propylene glycol monobutyl ether, propylene glycol monoisobutyl ether, diethylene glycol monomethyl ether, diethylene glycol monoethyl ether, diethylene glycol propyl ether, diethylene glycol isopropyl ether, diethylene glycol monobutyl ether, diethylene glycol monoisobutyl ether, dipropylene glycol monomethyl ether, dipropylene glycol monoethyl ether, dipropylene glycol monopropyl ether, dipropylene glycol monoisopropyl ether, dipropylene glycol monobutyl ether and dipropylene glycol monoisobutyl ether; and still yet more preferably include diethylene glycol, triethylene glycol, dipropylene glycol, 1,2-ethanediol, 1,2-propanediol, 1,2-butanediol, 2,3-butanediol, 1,3-butanediol, 1,4-butanediol, ethylene glycol monomethyl ether, propylene glycol monomethyl ether, diethylene glycol monomethyl ether and dipropylene glycol monomethyl ether.

In this invention, from the standpoint of reproducibly obtaining a high-flatness thin-film, it is desirable for the charge-transporting varnish to be obtained by dissolving the charge-transporting substance, dopant and the like in the organic solvent, then filtering the solution using a submicron-order filter or the like.

### [Charge-Transporting Substance]

In this disclosure, substances that have hitherto been used in, for example, the organic EL field may be used as the charge-transporting substance. Such substances are exemplified by various types of charge-transporting compounds, including arylamine derivatives (aniline derivatives) such as oligoaniline derivatives, N,N'-diarylbenzidine derivatives and N,N,N',N'-tetraarylbenzidine derivatives; thiophene derivatives such as oligothiophene derivatives, thienothiophene derivatives and thienobenzothiophene derivatives; and pyrrole derivatives such as oligopyrroles. Of these, arylamine derivatives and thiophene derivatives are preferred.

In the invention, from the standpoint of preparing a uniform varnish that provides thin-films having a high flatness, the molecular weight of the charge-transporting compound is from 200 to 9,000. However, to obtain thin-films having even better charge transportability, the molecular weight is preferably at least 300, and more preferably at least 400; to prepare a uniform varnish that more reproducibly gives thin-films having a high flatness, the molecular weight is preferably not more than 8,000, more preferably not more than 7,000, even more preferably not more than 6,000, and still more preferably not more than 5,000. To prevent separation of the charge-transporting substance when the varnish has been rendered into a thin-film, the charge-transporting compound preferably does not have a molecular weight distribution (dispersity = 1); i.e., it preferably has a single molecular weight.

The aniline derivative is exemplified by compounds of formula (1) or (2) below.

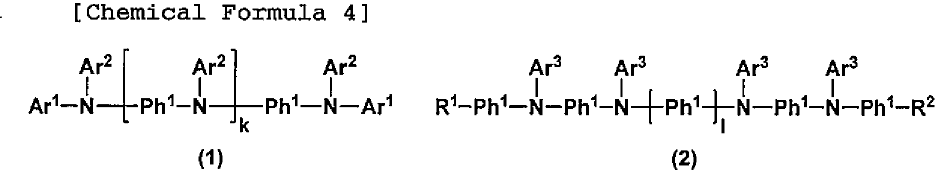

In formula (2), R¹ and R² are each independently a hydrogen atom, a halogen atom, a nitro group, a cyano group, or an alkyl group of 1 to 20 carbon atoms, alkenyl group of 2 to 20 carbon atoms, alkynyl group of 2 to 20 carbon atoms, aryl group of 6 to 20 carbon atoms or heteroaryl group of 2 to 20 carbon which may be substituted with a halogen atom.

Examples of the halogen atom include fluorine, chlorine, bromine and iodine atoms, with a fluorine atom being preferred.

The alkyl group of 1 to 20 carbon atoms may be linear, branched or cyclic. Examples include linear or branched alkyl groups of 1 to 20 carbon atoms, such as methyl, ethyl, n-propyl, isopropyl, n-butyl, isobutyl, s-butyl, t-butyl, n-pentyl, n-hexyl, n-heptyl, n-octyl, n-nonyl and n-decyl; and cyclic alkyl groups of 3 to 20 carbon atoms, such as cyclopropyl, cyclobutyl, cyclopentyl, cyclohexyl, cycloheptyl, cyclooctyl, cyclononyl, cyclodecyl, bicyclobutyl, bicyclopentyl, bicyclohexyl, bicycloheptyl, bicyclooctyl, bicyclononyl and bicyclodecyl.

Examples of alkenyl group of 2 to 20 carbon atoms include ethenyl, n-1-propenyl, n-2-propenyl, 1-methylethenyl, n-1-butenyl, n-2-butenyl, n-3-butenyl, 2-methyl-1-propenyl, 2-methyl-2-propenyl, 1-ethylethenyl, 1-methyl-1-propenyl, 1-methyl-2-propenyl, n-1-pentenyl, n-1-decenyl and n-1-eicosenyl.

Examples of alkynyl groups of 2 to 20 carbons include ethynyl, n-1-propynyl, n-2-propynyl, n-1-butynyl, n-2-butynyl, n-3-butynyl, 1-methyl-2-propynyl, n-1-pentynyl, n-2-pentynyl, n-3-pentynyl, n-4-pentynyl, 1-methyl-n-butynyl, 2-methyl-n-butynyl, 3-methyl-n-butynyl, 1,1-dimethyl-n-propynyl, n-1-hexynyl, n-1-decynyl, n-1-pentadecynyl and n-1-eicosynyl.

Examples of aryl groups of 6 to 20 carbon atoms include phenyl, 1-naphthyl, 2-naphthyl, 1-anthryl, 2-anthryl, 9-anthryl, 1-phenanthryl, 2-phenanthryl, 3-phenanthryl, 4-phenanthryl and 9-phenanthryl.

Examples of heteroaryl groups of 2 to 20 carbon atoms include oxygen-containing heteroaryl groups such as 2-thienyl, 3-thienyl, 2-furanyl, 3-furanyl, 2-oxazolyl, 4-oxazolyl, 5-oxazolyl, 3-isooxazolyl, 4-isooxazolyl and 5-isooxazolyl; sulfur-containing heteroaryl groups such as 2-thiazolyl, 4-thiazolyl, 5-thiazolyl, 3-isothiazolyl, 4-isothiazolyl and 5-isothiazolyl; and nitrogen-containing heteroaryl groups such as 2-imidazolyl, 4-imidazolyl, 2-pyridyl, 3-pyridyl, 4-pyridyl, 2-pyrazyl, 3-pyrazyl, 5-pyrazyl, 6-pyrazyl, 2-pyrimidyl, 4-pyrimidyl, 5-pyrimidyl, 6-pyrimidyl, 3-pyridazyl, 4-pyridazyl, 5-pyridazyl, 6-pyridazyl, 1,2,3-triazin-4-yl, 1,2,3-triazin-5-yl, 1,2,4-triazin-3-yl, 1,2,4-triazin-5-yl, 1,2,4-triazin-6-yl, 1,3,5-triazin-2-yl, 1,2,4,5-tetrazin-3-yl, 1,2,3,4-tetrazin-5-yl, 2-quinolinyl, 3-quinolinyl, 4-quinolinyl, 5-quinolinyl, 6-quinolinyl, 7-quinolinyl, 8-quinolinyl, 1-isoquinoinyl, 3-isoquinolinyl, 4-isoquinolinyl, 5-isoquinolinyl, 6-isoquinolinyl, 7-isoquinolinyl, 8-isoquinolinyl, 2-quinoxanyl, 5-quinoxanyl, 6-quinoxanyl, 2-quinazolinyl, 4-quinazolinyl, 5-quinazolinyl, 6-quinazolinyl, 7-quinazolinyl, 8-quinazolinyl, 3-cinnolinyl, 4-cinnolinyl, 5-cinnolinyl, 6-cinnolinyl, 7-cinnolinyl and 8-cinnolinyl.

Of these, R¹ and R² are each preferably a hydrogen atom, a fluorine atom, a cyano group, an alkyl group of 1 to 20 carbon atoms which may be substituted with a halogen atom, an aryl group of 6 to 20 carbon atoms which may be substituted with a halogen atom, or a heteroaryl group of 2 to 20 carbon atoms which may be substituted with a halogen atom; more preferably a hydrogen atom, a fluorine atom, a cyano group, an alkyl group of 1 to 10 carbon atoms which may be substituted with a halogen atom, or a phenyl group which may be substituted with a halogen atom; even more preferably a hydrogen atom, a fluorine atom, a methyl group or a trifluoromethyl group; and most preferably a hydrogen atom.

In formulas (1) and (2), Ph¹ represents a group of the formula (P1).

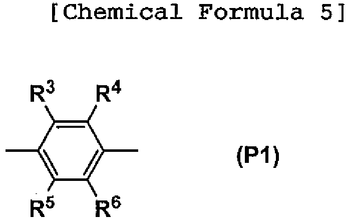

In the formula, R³ to R⁶ are each independently a hydrogen atom, a halogen atom, a nitro group, a cyano group, or an alkyl group of 1 to 20 carbon atoms, alkenyl group of 2 to 20 carbon atoms, alkynyl group of 2 to 20 carbon atoms, aryl group of 6 to 20 carbon atoms or heteroaryl group of 2 to 20 carbon atoms which may be substituted with a halogen atom. These groups are exemplified in the same way as described above for R¹ and R².

In particular, R³ to R⁶ are each preferably a hydrogen atom, a fluorine atom, a cyano group, an alkyl group of 1 to 20 carbon atoms which may be substituted with a halogen atom, an aryl group of 6 to 20 carbon atoms which may be substituted with a halogen atom, or a heteroaryl group of 2 to 20 carbon atoms which may be substituted with a halogen atom; more preferably a hydrogen atom, a fluorine atom, a cyano group, an alkyl group of 1 to 10 carbon atoms which may be substituted with a halogen atom, or a phenyl group which may be substituted with a halogen atom; even more preferably a hydrogen atom, a fluorine atom, a methyl group or a trifluoromethyl group; and most preferably a hydrogen atom.

Groups which are suitable as Ph¹ include, but are not limited to, the following.

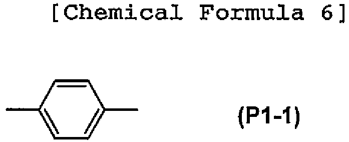

In formula (1), each Ar¹ is independently a group represented by any of formulas (B1) to (B11), with a group represented by any of formulas (B1') to (B11") being especially preferred.

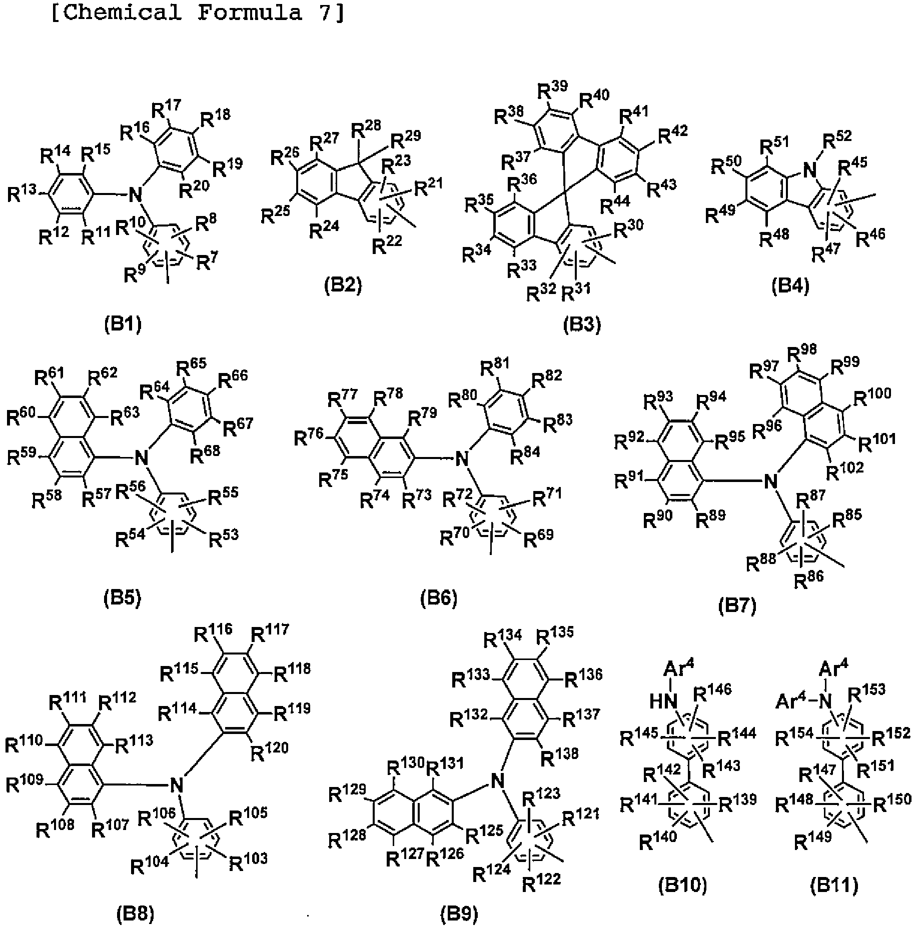

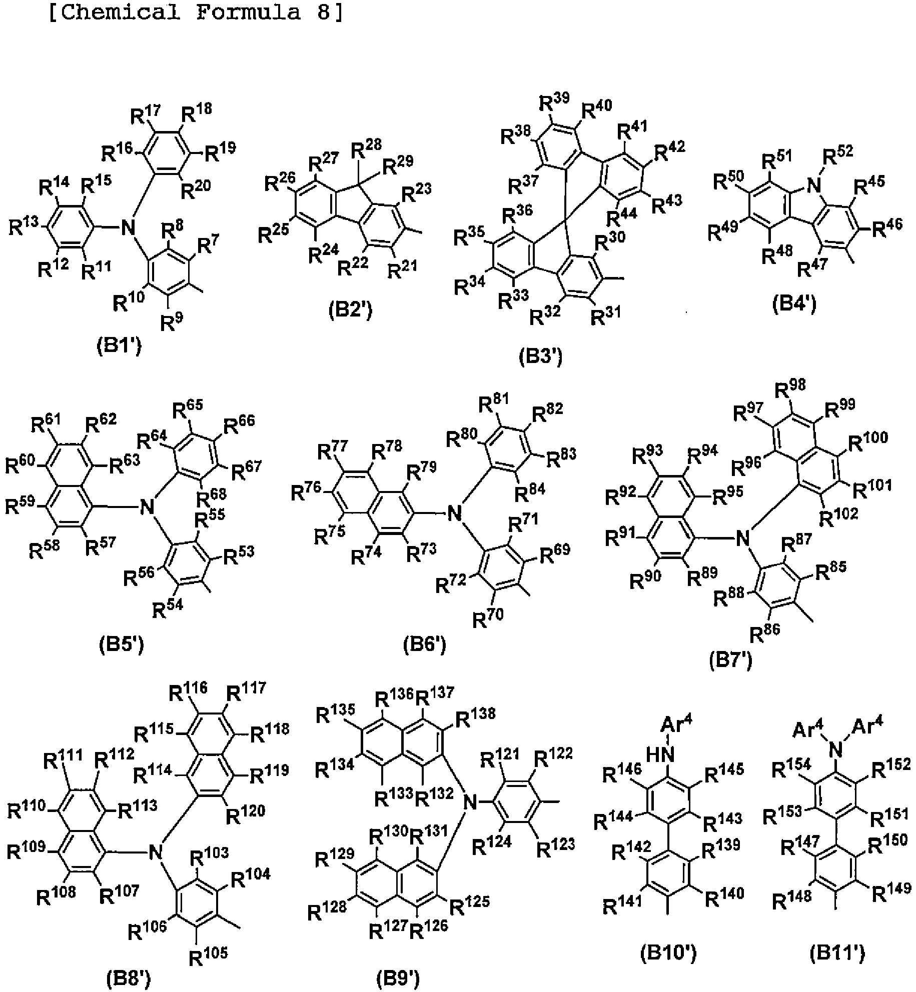

In these formulas, R⁷ to R²⁷, R³⁰ to R⁵¹ and R⁵³ to R¹⁵⁴ are each independently a hydrogen atom, a halogen atom, a nitro group, a cyano group, or a diphenylamino group, alkyl group of 1 to 20 carbon atoms, alkenyl group of 2 to 20 carbon atoms, alkynyl group of 2 to 20 carbon atoms, aryl group of 6 to 20 carbon atoms or heteroaryl group of 2 to 20 carbon atoms which may be substituted with a halogen atom; R²⁸ and R²⁹ are each independently an aryl group of 6 to 20 carbon atoms or a heteroaryl group of 2 to 20 carbon atoms which may be substituted with Z¹; R⁵² is a hydrogen atom, an alkyl group of 1 to 20 carbon atoms, alkenyl group of 2 to 20 carbon atoms or alkynyl group of 2 to 20 carbon atoms which may be substituted with Z⁴, or an aryl group of 6 to 20 carbons or heteroaryl group of 2 to 20 carbon atoms which may be substituted with Z¹; Z¹ is a halogen atom, a nitro group, a cyano group, or an alkyl group of 1 to 20 carbon atoms, alkenyl group of 2 to 20 carbon atoms or alkynyl group of 2 to 20 carbon atoms which may be substituted with Z²; Z² is a halogen atom, a nitro group, a cyano group, or an aryl group of 6 to 20 carbon atoms or heteroaryl group of 2 to 20 carbon atoms which may be substituted with Z³; Z³ is a halogen atom, a nitro group or a cyano group; Z⁴ is a halogen atom, a nitro group, a cyano group, or an aryl group of 6 to 20 carbon atoms or heteroaryl group of 2 to 20 carbon atoms which may be substituted with Z⁵; and Z⁵ is a halogen atom, a nitro group, a cyano group, or an alkyl group of 1 to 20 carbon atoms, alkenyl group of 2 to 20 carbon atoms or alkynyl group of 2 to 20 carbon atoms which may be substituted with Z³. These halogen atoms, alkyl groups of 1 to 20 carbon atoms, alkenyl groups of 2 to 20 carbon atoms, alkynyl groups of 2 to 20 carbon atoms, aryl groups of 6 to 20 carbon atoms and heteroaryl groups of 2 to 20 carbon atoms are exemplified in the same way as described above for R¹ and R².

In particular, R⁷ to R²⁷, R³⁰ to R⁵¹ and R⁵³ to R¹⁵⁴ are each preferably a hydrogen atom, a fluorine atom, a cyano group, a diphenylamino group which may be substituted with a halogen atom, an alkyl group of 1 to 20 carbon atoms which may be substituted with a halogen atom, an aryl group of 6 to 20 carbon atoms which may be substituted with a halogen atom, or a heteroaryl group of 2 to 20 carbon atoms which may be substituted with a halogen atom; more preferably a hydrogen atom, a fluorine atom, a cyano group, an alkyl group of 1 to 10 carbon atoms which may be substituted with a halogen atom, or a phenyl group which may be substituted with a halogen atom; even more preferably a hydrogen atom, a fluorine atom, a methyl group or a trifluoromethyl group; and most preferably a hydrogen atom.

R²⁸ and R²⁹ are each preferably an aryl group of 6 to 14 carbon atoms which may be substituted with Z¹ or a heteroaryl group of 2 to 14 carbon atoms which may be substituted with Z¹; more preferably an aryl group of 6 to 14 carbon atoms which may be substituted with Z¹; and even more preferably a phenyl group which may be substituted with Z¹, a 1-naphthyl group which may be substituted with Z¹ or a 2-naphthyl group which may be substituted with Z¹.

R⁵² is preferably a hydrogen atom, an aryl group of 6 to 20 carbon atoms which may be substituted with Z¹, a heteroaryl group of 2 to 20 carbon atoms which may be substituted with Z¹ or an alkyl group of 1 to 20 carbon atoms which may be substituted with Z⁴; more preferably a hydrogen atom, an aryl group of 6 to 14 carbon atoms which may be substituted with Z¹, a heteroaryl group of 2 to 14 carbon atoms which may be substituted with Z¹, or an alkyl group of 1 to 10 carbon atoms which may be substituted with Z⁴; even more preferably a hydrogen atom, an aryl group of 6 to 14 carbon atoms which may be substituted with Z¹, a nitrogen-containing heteroaryl group of 2 to 14 carbons which may be substituted with Z¹, or an alkyl group of 1 to 10 carbon atoms which may be substituted with Z⁴; and most preferably a hydrogen atom, a phenyl group which may be substituted with Z¹, a 1-naphthyl group which may be substituted with Z¹, a 2-naphthyl group which may be substituted with Z¹, a 2-pyridyl group which may be substituted with Z¹, a 3-pyridyl group which may be substituted with Z¹, a 4-pyridyl group which may be substituted with Z¹, or a methyl group which may be substituted with Z⁴.

Each Ar⁴ independently represents an aryl group of 6 to 20 carbon atoms which may be substituted with a diarylamino group wherein each aryl group is an aryl group of 6 to 20 carbon atoms. Specific examples of aryl groups of 6 to 20 carbon atoms include the same as those mentioned for R¹ and R². Specific examples of the diarylamino groups include diphenylamino, 1-naphthylphenylamino, di(1-naphthyl)amino, 1-naphthyl-2-naphthylamino and di(2-naphthyl)amino groups.

Ar⁴ is preferably a phenyl, 1-naphthyl, 2-naphthyl, 1-anthryl, 2-anthryl, 9-anthryl, 1-phenanthryl, 2-phenanthryl, 3-phenanthryl, 4-phenanthryl, 9-phenanthryl, p-(diphenylamino)phenyl, p-(1-naphthylphenylamino)phenyl, p-(di(1-naphthyl)amino)phenyl, p-(1-naphthyl-2-naphthylamino)phenyl or p-(di(2-naphthyl)amino)phenyl group; and more preferably a p-(diphenylamino)phenyl group.

Suitable examples of Ar¹ include, but are not limited to, those shown below. In the formulas below, DPA stands for a diphenylamino group and R⁵² is as defined above.

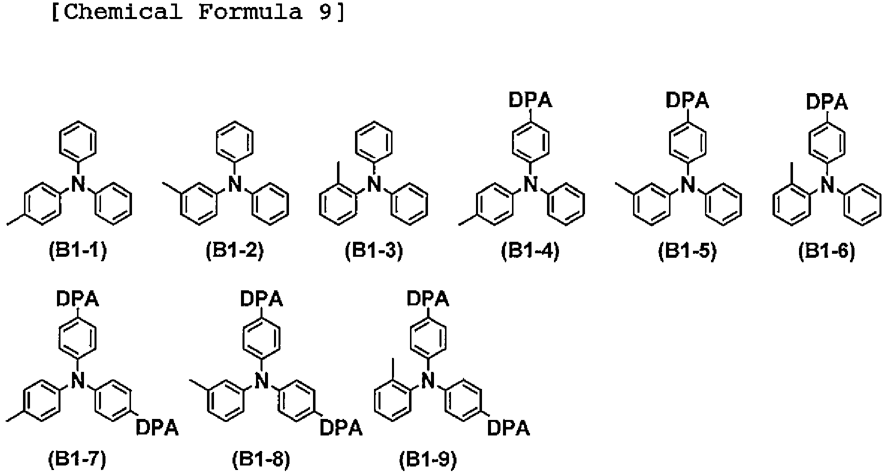

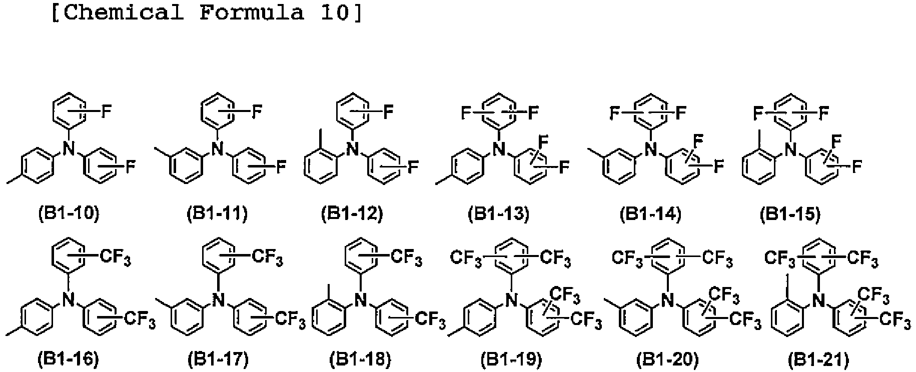

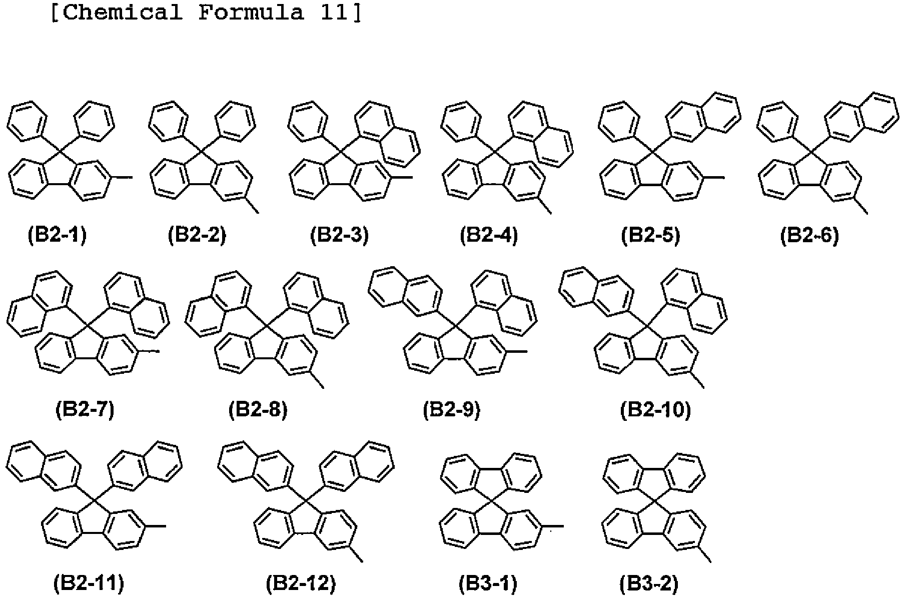

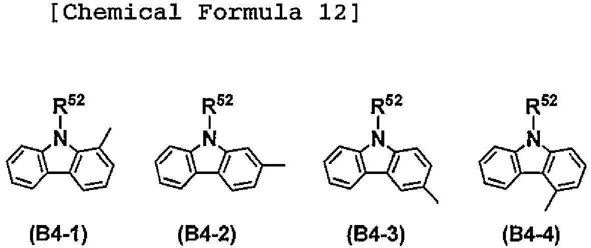

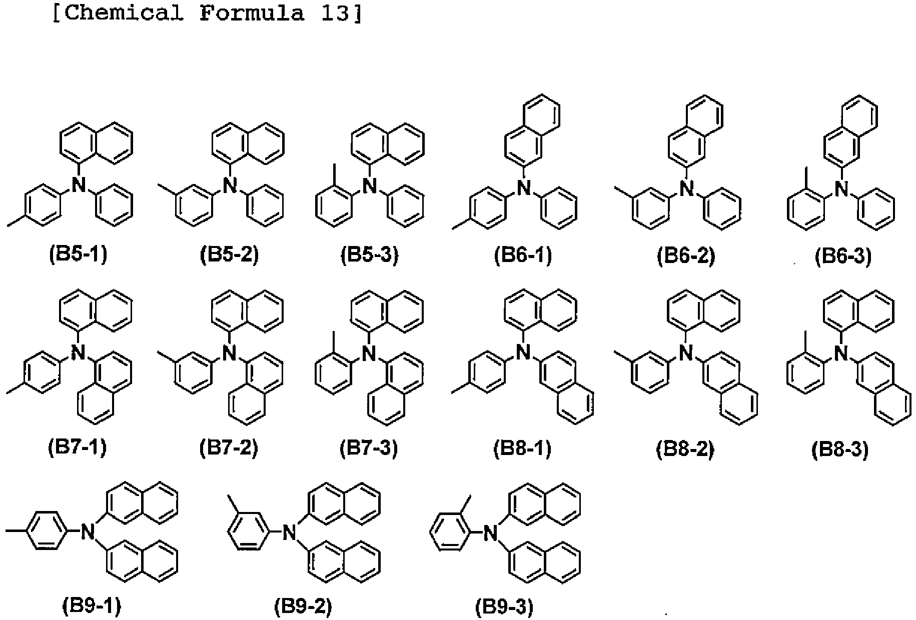

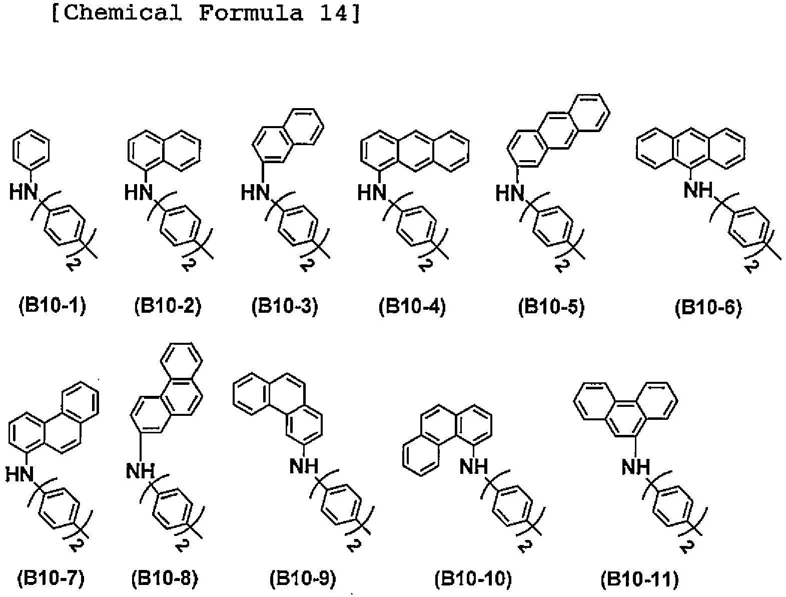

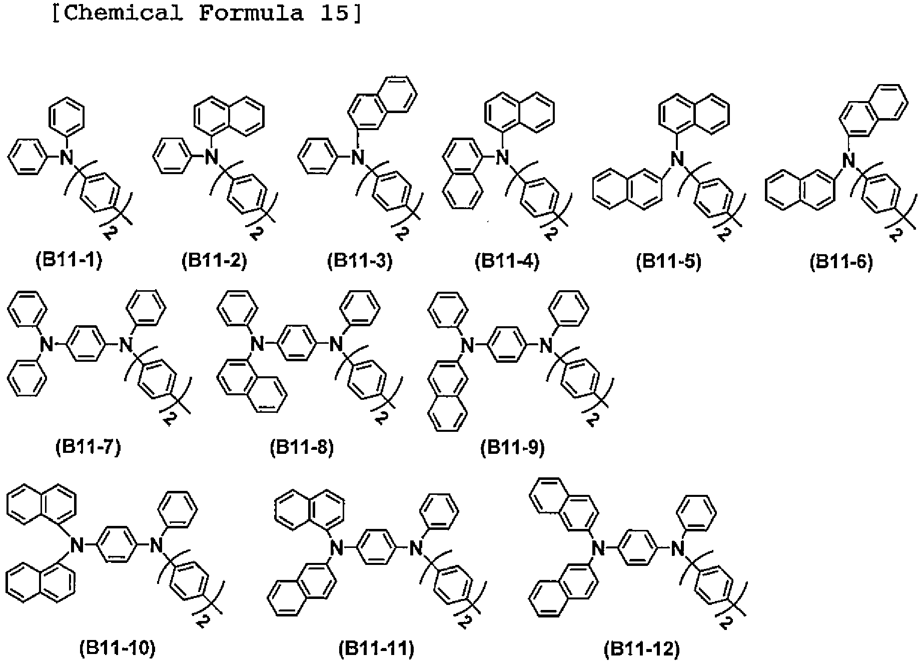

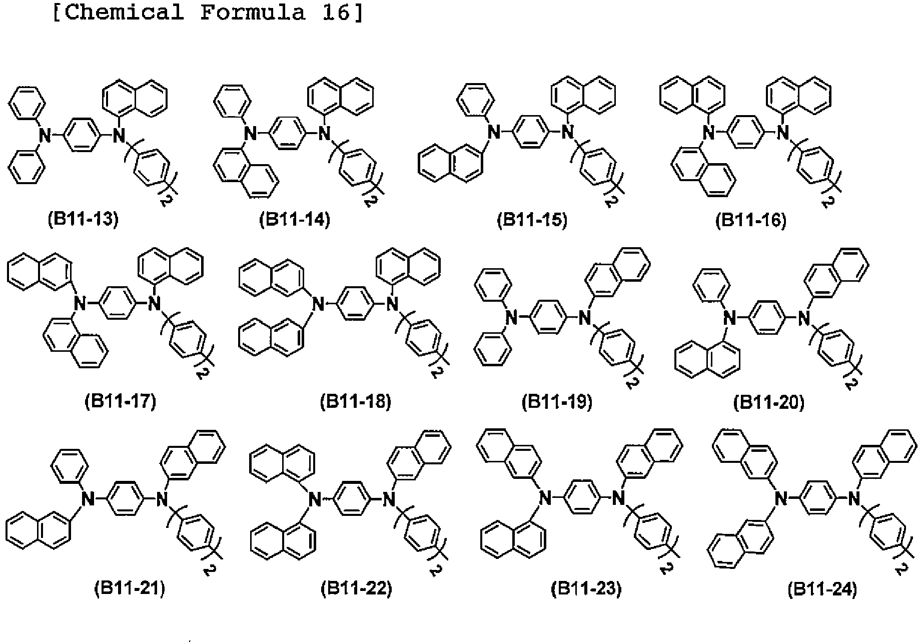

In formula (1), each Ar² is independently a group of any one of formulas (A1) to (A18).

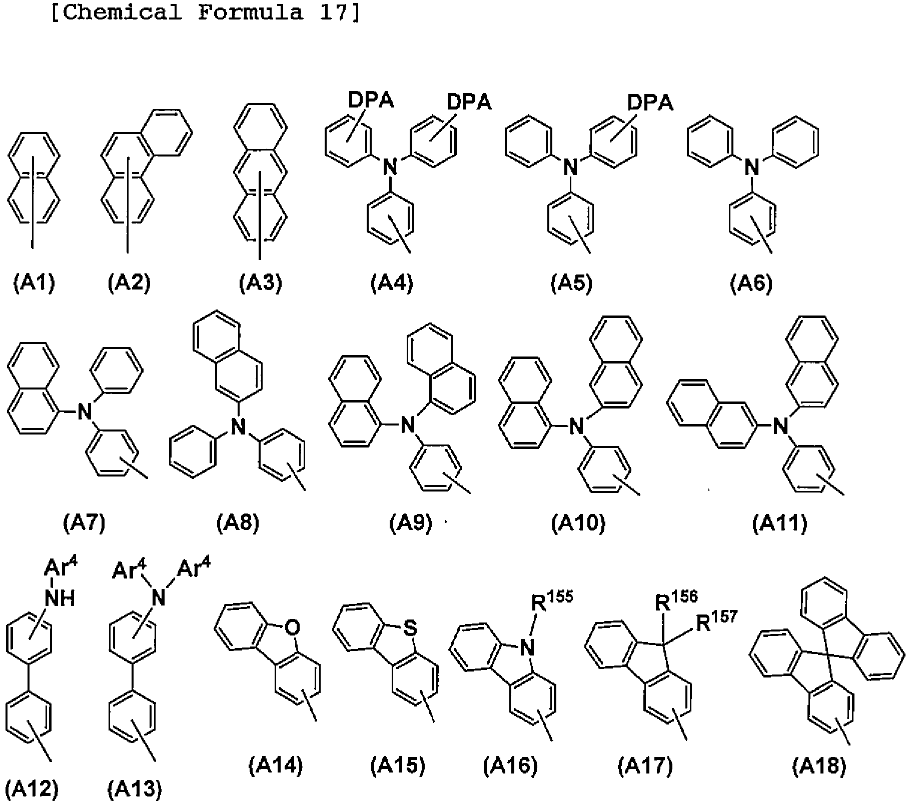

In these formulas, R¹⁵⁵ is a hydrogen atom, an alkyl group of 1 to 20 carbon atoms, alkenyl group of 2 to 20 carbon atoms or alkynyl group of 2 to 20 carbon atoms which may be substituted with Z⁴, or an aryl group of 6 to 20 carbons or heteroaryl group of 2 to 20 carbon atoms which may be substituted with Z¹; R¹⁵⁶ and R¹⁵⁷ are each independently an aryl group of 6 to 20 carbon atoms or heteroaryl group of 2 to 20 carbon atoms which may be substituted with Z¹; and DPA, Ar⁴, Z¹ and Z⁴ are as defined above. These halogen atoms, alkyl groups of 1 to 20 carbon atoms, alkenyl groups of 2 to 20 carbon atoms, alkynyl group of 2 to 20 carbon atoms, aryl groups of 6 to 20 carbon atoms and heteroaryl groups of 2 to 20 carbon atoms are exemplified in the same way as described above for R¹ and R².

In particular, R¹⁵⁵ is preferably a hydrogen atom, an aryl group of 6 to 20 carbon atoms which may be substituted with Z¹, a heteroaryl group of 2 to 20 carbon atoms which may be substituted with Z¹, or an alkyl group of 1 to 20 carbon atoms which may be substituted with Z⁴; more preferably a hydrogen atom, an aryl group of 6 to 14 carbon atoms which may be substituted with Z¹, a heteroaryl group of 2 to 14 carbon atoms which may be substituted with Z¹, or an alkyl group of 1 to 10 carbon atoms which may be substituted with Z⁴; even more preferably a hydrogen atom, an aryl group of 6 to 14 carbon atoms which may be substituted with Z¹, a nitrogen-containing heteroaryl group of 2 to 14 carbon atoms which may be substituted with Z¹, or an alkyl group of 1 to 10 carbon atoms which may be substituted with Z⁴; and still more preferably a hydrogen atom, a phenyl group which may be substituted with Z¹, a 1-naphthyl group which may be substituted with Z¹, a 2-napthyl group which may be substituted with Z¹, a 2-pyridyl group which may be substituted with Z¹, a 3-pyridyl group which may be substituted with Z¹, a 4-pyridyl group which may be substituted with Z¹, or a methyl group which may be substituted with Z⁴.

R¹⁵⁶ and R¹⁵⁷ are each preferably an aryl group of 6 to 14 carbon atoms which may be substituted with Z¹ or a heteroaryl group of 2 to 14 carbon atoms which may be substituted with Z¹; more preferably an aryl group of 6 to 14 carbon atoms which may be substituted with Z¹; and even more preferably a phenyl group which may be substituted with Z¹, a 1-naphthyl group which may be substituted with Z¹ or a 2-naphthyl group which may be substituted with Z¹.

Specific examples of groups which are suitable as Ar² include, but are not limited to, those shown below. In the following formulas, R¹⁵⁵ and DPA are as defined above.

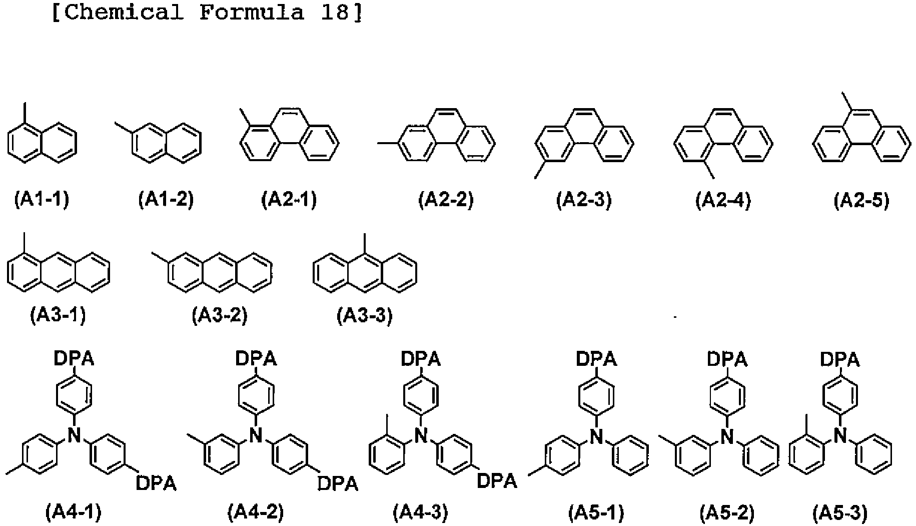

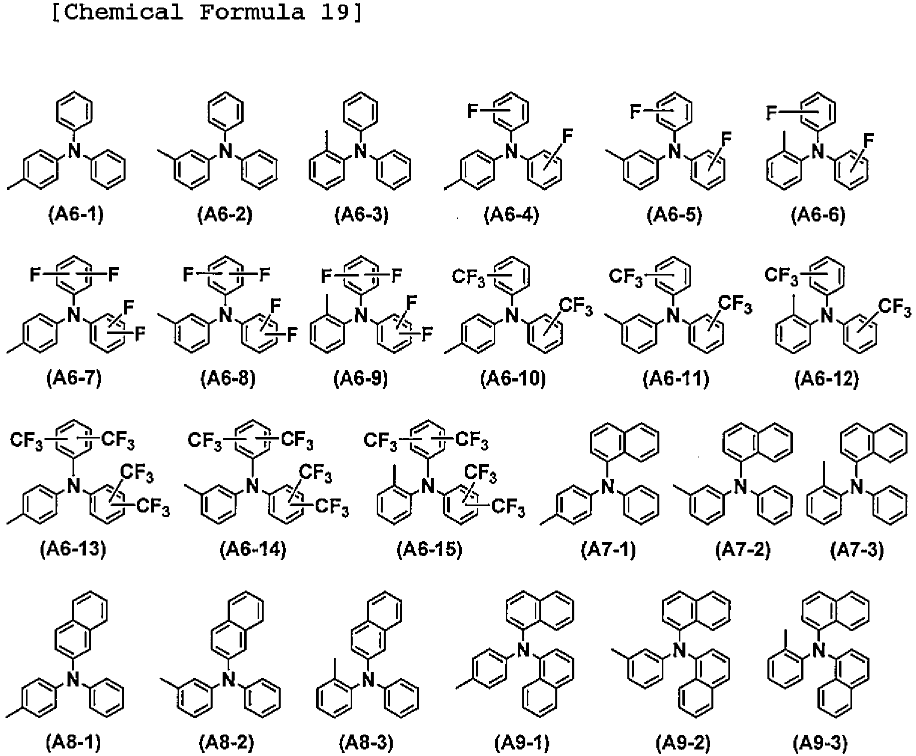

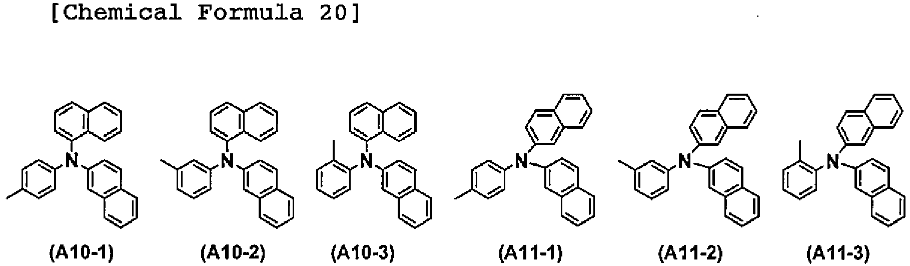

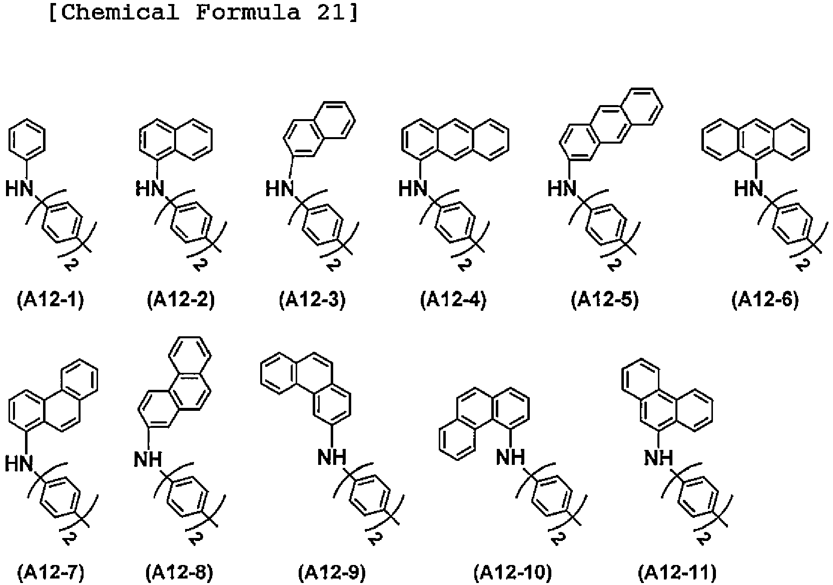

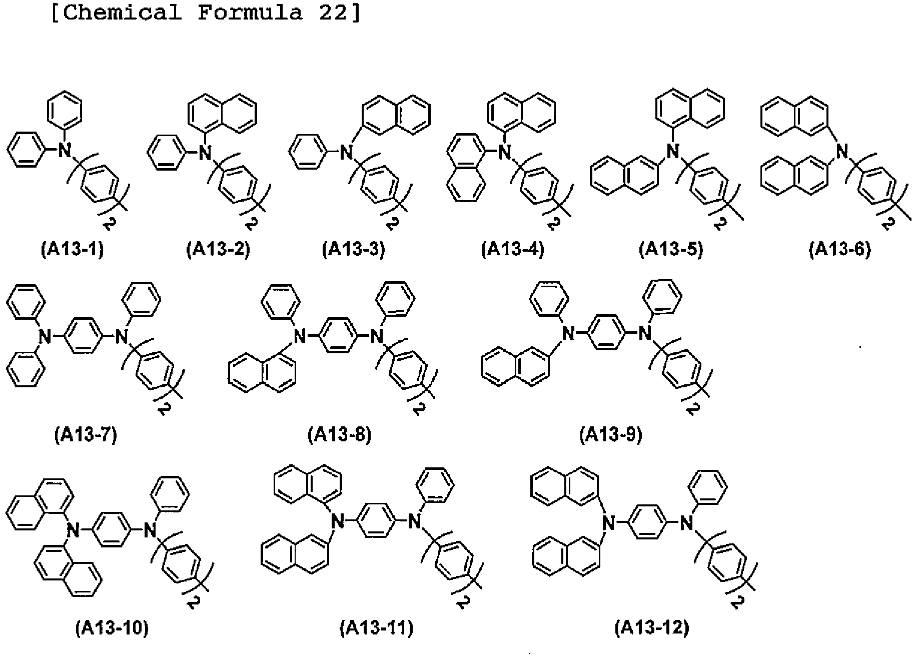

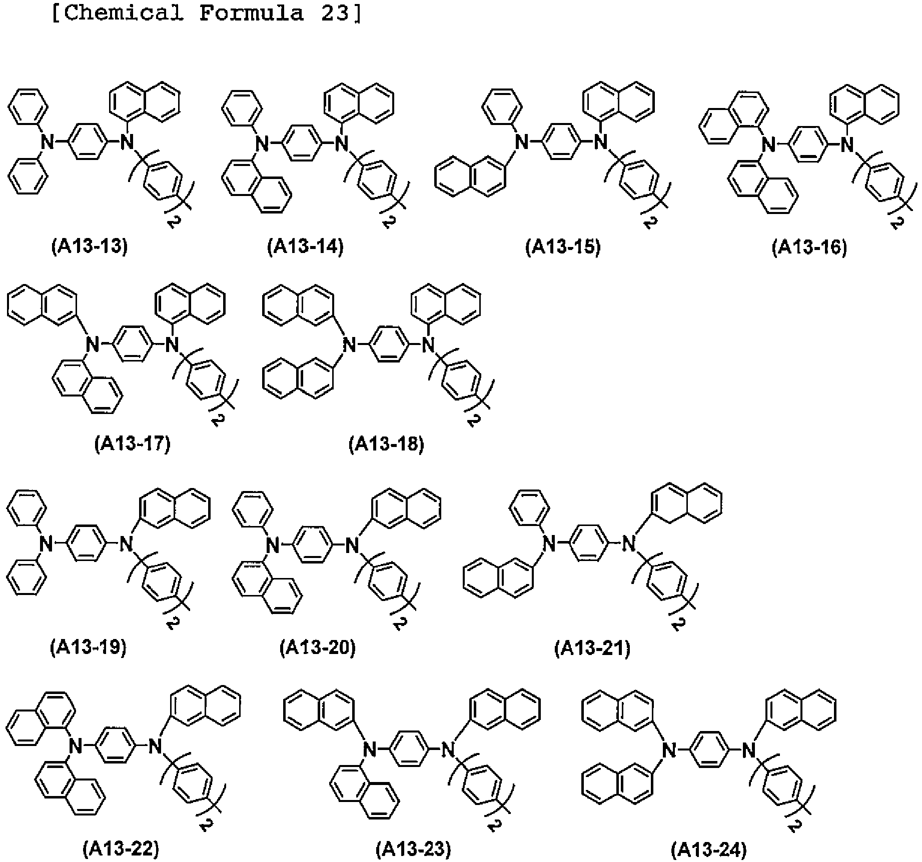

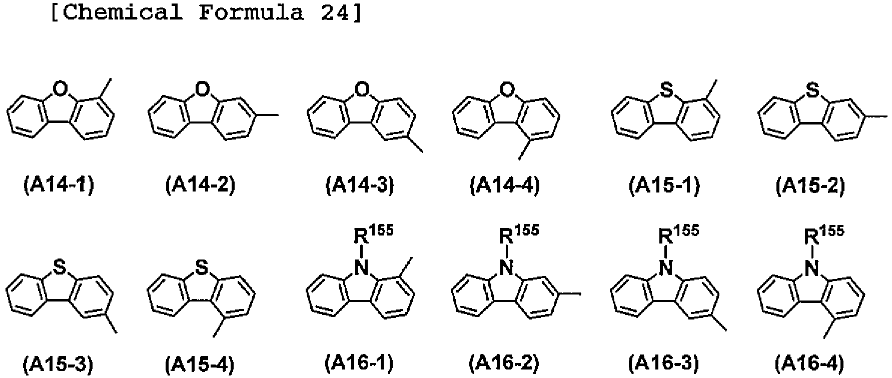

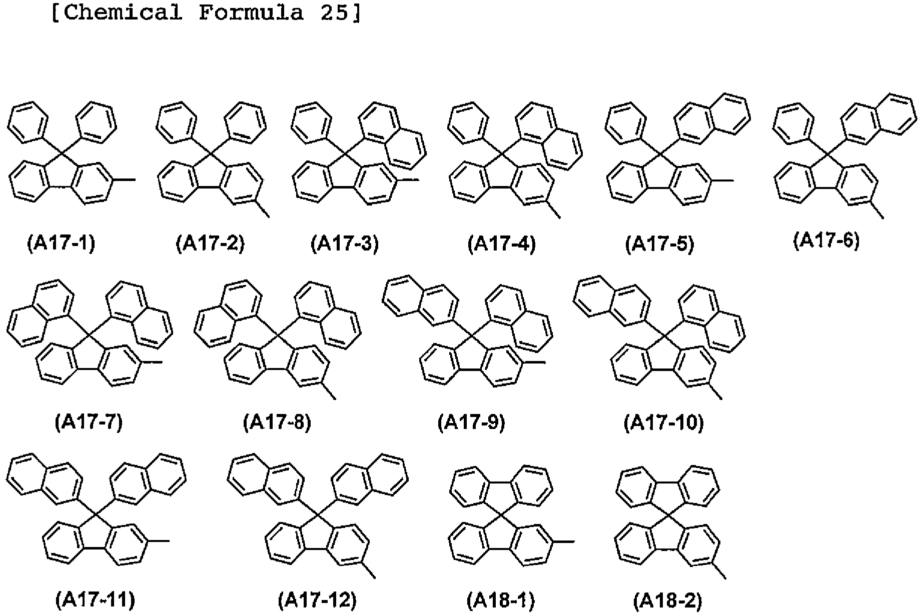

In formula (1), taking into account the ease of synthesizing the resulting aniline derivative, it is preferable for all the Ar¹ groups to be the same group and for all the Ar² groups to be the same group, and more preferable for all the Ar¹ and Ar² groups to be the same group. That is, the aniline derivative of formula (1) is more preferably an aniline derivative of formula (1-1) below.

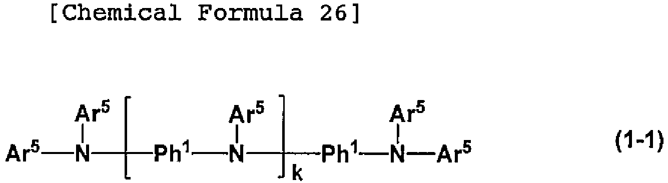

In formula (1-1), Ph¹ and k are as defined above and Ar⁵ is at the same time a group of any of formulas (D1) to (D13) below, with a group of any of formulas (D1') to (D13') being preferred. In the following formulas, R²⁸, R²⁹, R⁵², Ar⁴ and DPA are as defined above. Ar⁵ is exemplified by the same groups as mentioned above as suitable examples of Ar¹.

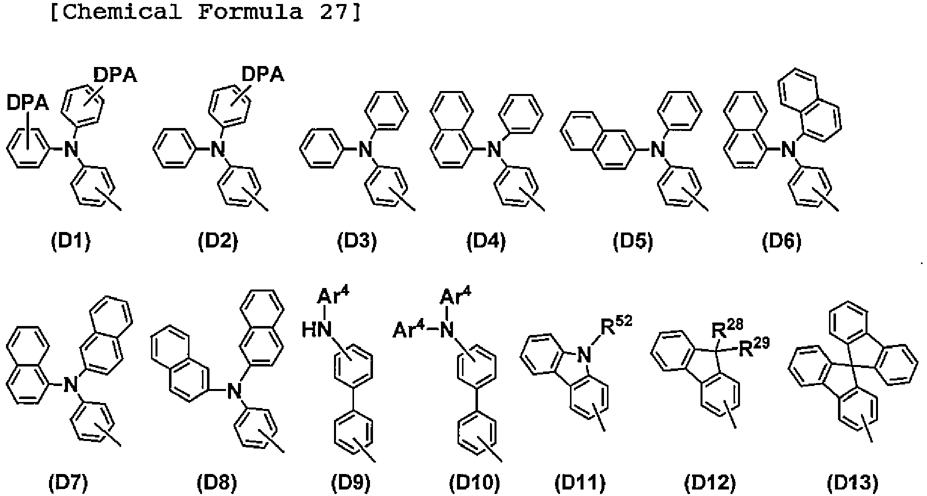

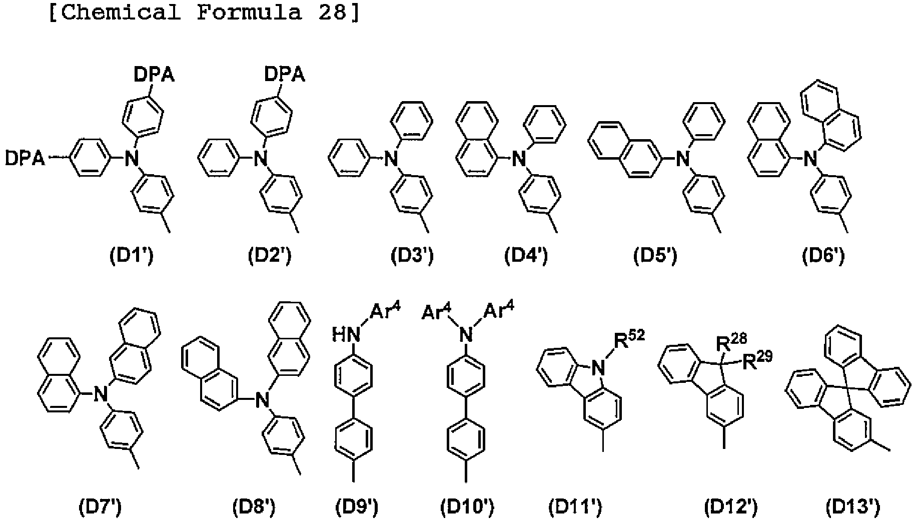

The aniline derivative of formula (1) is preferably an aniline derivative of formula (1-2), both because, as subsequently described, it can be synthesized with relative ease using the relatively inexpensive bis(4-aminophenyl)amine as the starting compound, and because the resulting aniline derivative has an excellent solubility in organic solvents.

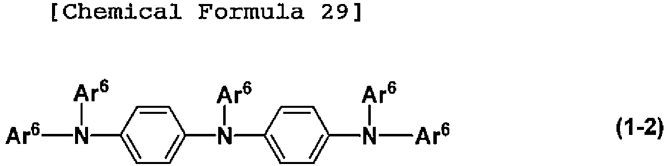

In the formula, Ar⁶ at the same time represents a group of any one of formulas (E1) to (E14). Also, in the following formulas, R⁵² is as defined above.

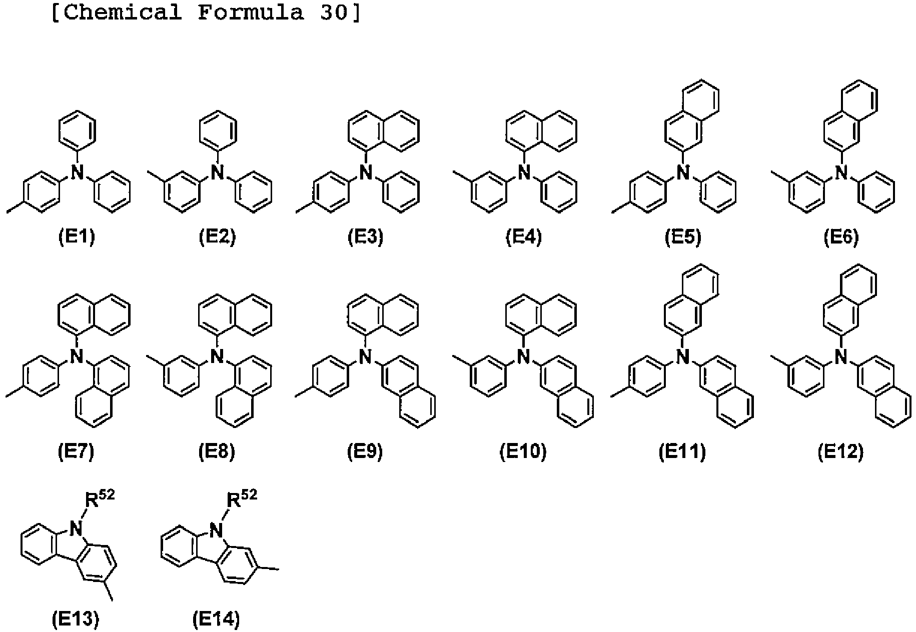

In formula (2), Ar³ is a group of any of formulas (C1) to (C8), with a group of any of formulas (C1') to (C8') being especially preferred. In the following formulas, DPA is as defined above.

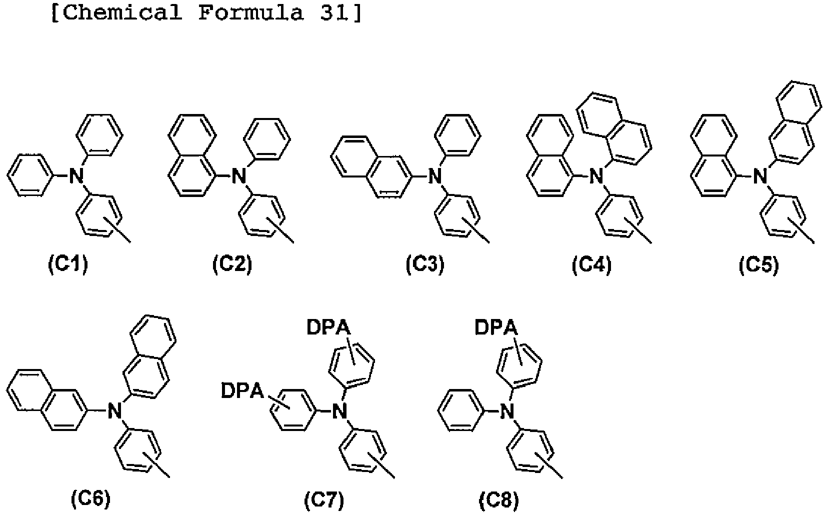

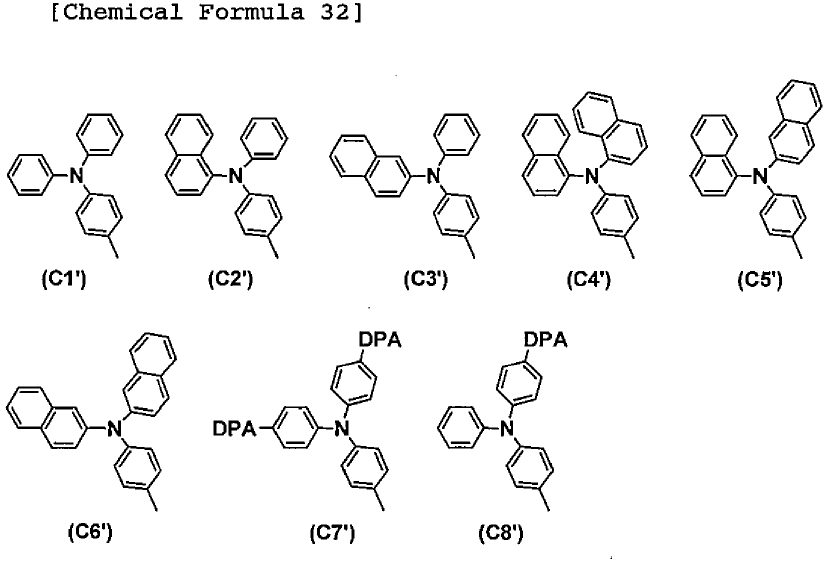

In formula (1), k is an integer from 1 to 10. However, from the standpoint of increasing the solubility of the compound in the organic solvent, k is preferably from 1 to 5, more preferably from 1 to 3, even more preferably 1 or 2, and most preferably 1. In formula (2), the letter "l" represents 1 or 2.

In R²⁸, R²⁹, R⁵² and R¹⁵⁵ to R¹³⁷, Z¹ is preferably a halogen atom, a nitro group, a cyano group, an alkyl group of 1 to 10 carbon atoms which may be substituted with Z², an alkenyl group of 2 to 10 carbon atoms which may be substituted with Z² or an alkynyl group of 2 to 10 carbon atoms which may be substituted with Z²; more preferably a halogen atom, a nitro group, a cyano group, an alkyl group of 1 to 3 carbon atoms which may be substituted with Z², an alkenyl group of 2 or 3 carbon atoms which may be substituted with Z², or an alkynyl group of 2 or 3 carbon atoms which may be substituted with Z²; and even more preferably a fluorine atom, an alkyl group of 1 to 3 carbon atoms which may be substituted with Z², an alkenyl group of 2 or 3 carbon atoms which may be substituted with Z², or an alkynyl group of 2 or 3 carbon atoms which may be substituted with Z².

In R²⁸, R²⁹, R⁵² and R¹⁵⁵ to R¹⁵⁷, Z⁴ is preferably a halogen atom, a nitro group, a cyano group or an aryl group of 6 to 14 carbon atoms which may be substituted with Z⁵; more preferably a halogen atom, a nitro group, a cyano group, or an aryl group of 6 to 10 carbon atoms which may be substituted with Z⁵; even more preferably a fluorine atom or an aryl group of 6 to 10 carbon atoms which may be substituted with Z⁵; and yet more preferably a fluorine atom or a phenyl group which may be substituted with Z⁵.

In R²⁸, R²⁹, R⁵² and R¹⁵⁵ to R¹⁵⁷, Z² is preferably a halogen atom, a nitro group, a cyano group, or an aryl group of 6 to 14 carbon atoms which may be substituted with Z³; more preferably a halogen atom, a nitro group, a cyano group, or an aryl group of 6 to 10 carbon atoms which may be substituted with Z³; even more preferably a fluorine atom or an aryl group of 6 to 10 carbon atoms which may be substituted with Z³; and still more preferably a fluorine atom or a phenyl group which may be substituted with Z³.

In R²⁸, R²⁹, R⁵² and R¹⁵⁵ to R¹⁵⁷, Z⁵ is preferably a halogen atom, a nitro group, a cyano group, an alkyl group of 1 to 10 carbon atoms which may be substituted with Z³, an alkenyl group of 2 to 10 carbon atoms which may be substituted with Z³, or an alkynyl group of 2 to 10 carbon atoms which may be substituted with Z³; more preferably a halogen atom, a nitro group, a cyano group, an alkyl group of 1 to 3 carbon atoms which may be substituted with Z³, an alkenyl group of 2 or 3 carbon atoms which may be substituted with Z³, or an alkynyl group of 2 or 3 carbon atoms which may be substituted with Z³; and even more preferably a fluorine atom, an alkyl group of 1 to 3 carbon atoms which may be substituted with Z³, an alkenyl group of 2 or 3 carbon atoms which may be substituted with Z³, or an alkynyl group of 2 or 3 carbon atoms which may be substituted with Z³.

In R²⁸, R²⁹, R⁵² and R¹⁵⁵ to R¹⁵⁷, Z³ is preferably a halogen atom, and more preferably a fluorine atom.

In R⁷ to R²⁷, R³⁰ to R⁵¹ and R⁵³ to R¹⁵⁴, Z¹ is preferably a halogen atom, a nitro group, a cyano group, an alkyl group of 1 to 3 carbon atoms which may be substituted with Z², an alkenyl group of 2 or 3 carbon atoms which may be substituted with Z², or an alkynyl group of 2 or 3 carbon atoms which may be substituted with Z²; more preferably a halogen atom or an alkyl group of 1 to 3 carbon atoms which may be substituted with Z²; and even more preferably a fluorine atom or a methyl group which may be substituted with Z².

In R⁷ to R²⁷, R³⁰ to R⁵¹ and R⁵³ to R¹⁵⁴, Z⁴ is preferably a halogen atom, a nitro group, a cyano group, or an aryl group of 6 to 10 carbon atoms which may be substituted with Z⁵; more preferably a halogen atom or an aryl group of 6 to 10 carbon atoms which may be substituted with Z⁵; and even more preferably a fluorine atom or a phenyl group which may be substituted with Z⁵.

In R⁷ to R²⁷, R³⁰ to R⁵¹ and R⁵³ to R¹⁵⁴, Z² is preferably a halogen atom, a nitro group, a cyano group, or an aryl group of 6 to 10 carbon atoms which may be substituted with Z³; more preferably a halogen atom or an aryl group of 6 to 10 carbon atoms which may be substituted with Z³; and even more preferably a fluorine atom or a phenyl group which may be substituted with Z³.

In R⁷ to R²⁷, R³⁰ to R⁵¹ and R⁵³ to R¹⁵⁴, Z⁵ is preferably a halogen atom, a nitro group, a cyano group, an alkyl group of 1 to 3 carbon atoms which may be substituted with Z³, an alkenyl group of 2 or 3 carbon atoms which may be substituted with Z³, or an alkynyl group of 2 or 3 carbon atoms which may be substituted with Z³; more preferably a halogen atom or an alkyl group of 1 to 3 carbon atoms which may be substituted with Z³; and even more preferably a fluorine atom or a methyl group which may be substituted with Z³.

In R⁷ to R²⁷, R³⁰ to R⁵¹ and R⁵³ to R¹⁵⁴, Z³ is preferably a halogen atom, and more preferably a fluorine atom.

In this invention, specific examples of groups that are suitable as R⁵² and R¹⁵⁵ include, but are not limited to, those shown below.

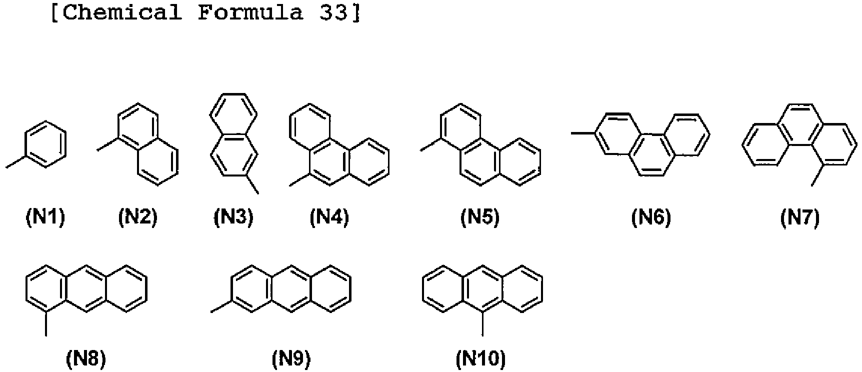

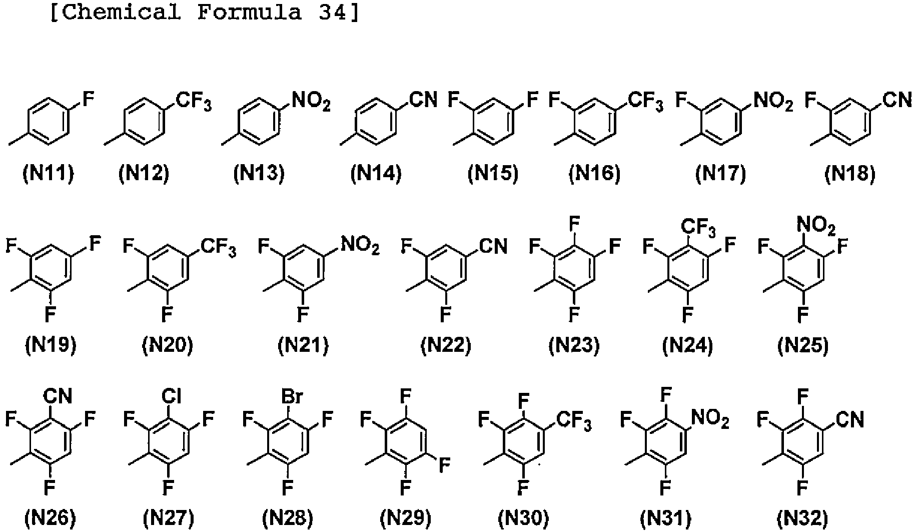

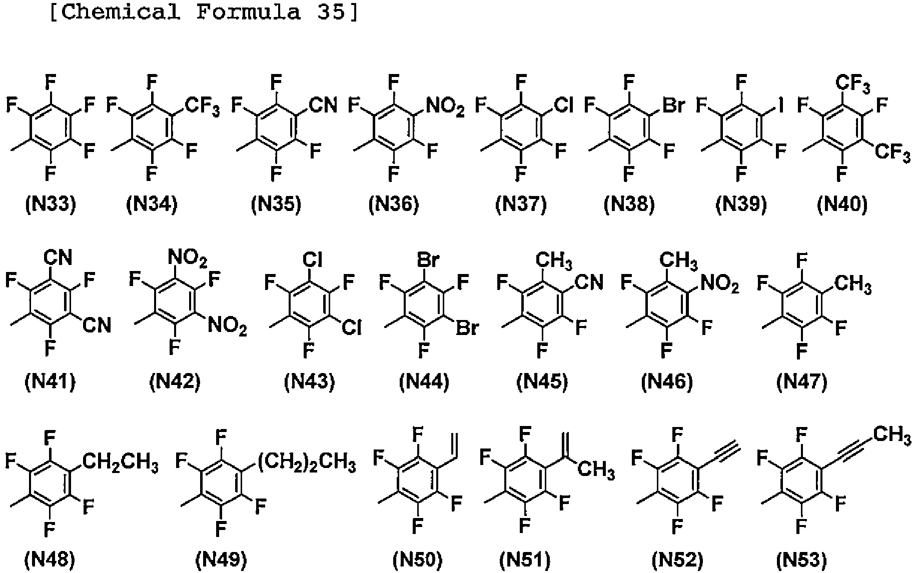

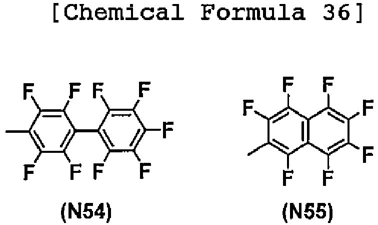

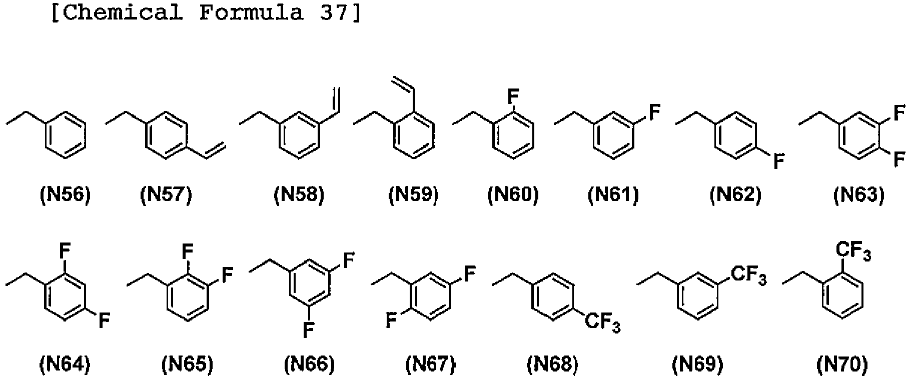

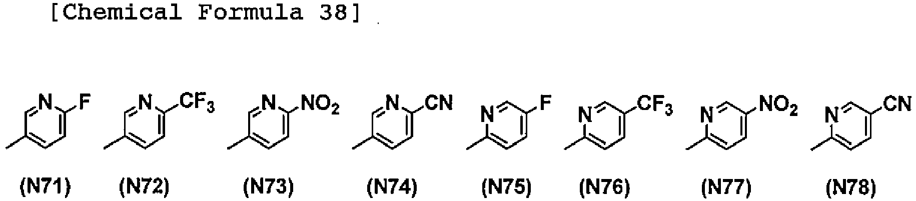

In this invention, the number of carbon atoms on the above alkyl, alkenyl and alkynyl groups is preferably not more than 10, more preferably not more than 6, and even more preferably not more than 4. The number of carbon atoms on the above aryl groups and heteroaryl groups is preferably not more than 14, more preferably not more than 10, and even more preferably not more than 6.

Aniline derivatives of formula (1) can be prepared by reacting an amine compound of formula (3) with an aryl compound of formula (4) in the presence of a catalyst. 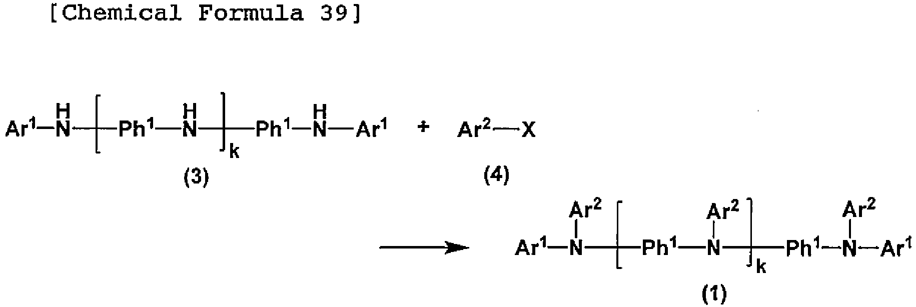 Here, X is a halogen atom or a pseudo-halogen group; and Ar¹, Ar², Ph¹ and k are as defined above.

In particular, aniline derivatives of formula (1-1) can be prepared by reacting an amine compound of formula (7) with an aryl compound of formula (8) in the presence of a catalyst. 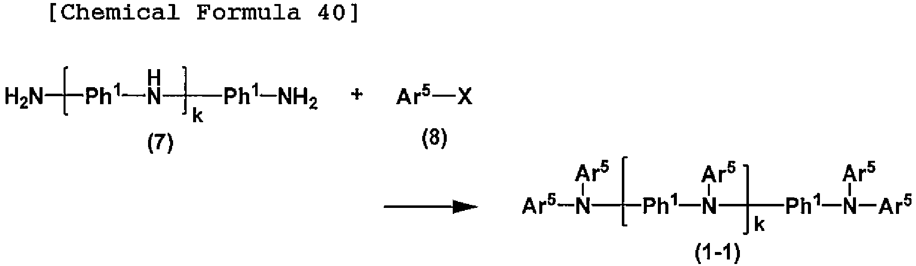 Here, X, Ar⁵, Ph¹ and k are as defined above.

Aniline derivatives of formula (1-2) can be prepared by reacting bis(4-aminophenyl)amine with an aryl compound of formula (9) in the presence of a catalyst. 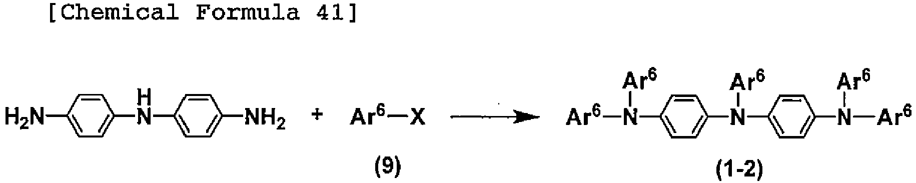 Here, X and Ar⁶ are as defined above.

Aniline derivatives of formula (2) can be prepared by reacting an amine compound of formula (5) with an aryl compound of formula (6) in the presence of a catalyst. 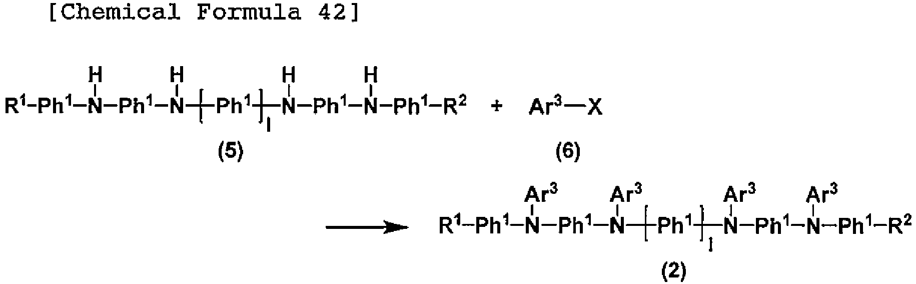 Here, X, R¹, R², Ar³, Ph¹ and the letter "l" are as defined above.

Examples of the halogen atom include the same as those mentioned above. Examples of pseudo-halogen groups include (fluoro)alkylsulfonyloxy groups such as methanesulfonyloxy, trifluoromethanesulfonyloxy and nonafluorobutanesulfonyloxy groups; and aromatic sulfonyloxy groups such as benzenesulfonyloxy and toluenesulfonyloxy groups.

The charging ratio of the amine compound of formula (3), (5) or (7) or bis(4-aminophenyl)amine to the aryl compound of formula (4), (6), (8) or (9) may be set so as to make the amount of the aryl compound at least 1 equivalent, and preferably about 1 to 1.2 equivalents, with respect to the molar amount of all NH groups on the amine compound or bis(4-aminophenyl)amine.

The catalyst used in the reaction is exemplified by copper catalysts such as copper chloride, copper bromide and copper iodide; and palladium catalysts such as tetrakis(triphenylphosphine)palladium (Pd(PPh₃)₄), bis(triphenylphosphine)dichloropalladium (Pd(PPh₃)₂Cl₂), bis(dibenzylideneacetone)palladium (Pd(dba)₂), tris(dibenzylideneacetone)palladium (Pd₂(dba)₃), bis(tri(t-butylphosphine)palladium (Pd(P-t-Bu₃)₂), and palladium acetate (Pd(OAc)₂). These catalysts may be used singly, or two or more may be used in combination. Also, these catalysts may be used together with suitable known ligands.

Illustrative examples of such ligands include tertiary phosphines such as triphenylphosphine, tri-o-tolylphosphine, diphenylmethylphosphine, phenyldimethylphosphine, trimethylphosphine, triethylphosphine, tributylphosphine, tri-t-butylphosphine, di-t-butyl(phenyl)phosphine, di-t-butyl(4-dimethylaminophenyl)phosphine, 1,2-bis(diphenylphosphino)ethane, 1,3-bis(diphenylphosphino)propane, 1,4-bis(diphenylphosphino)butane and 1,1'-bis(diphenylphosphino)ferrocene; and tertiary phosphites such as trimethylphosphite, triethylphosphite and triphenylphosphite.

The amount of catalyst used may be set to about 0.2 mole per mole of the aryl compound of formula (4), (6), (8) or (9), with about 0.15 mole being preferred. When ligands are used, the amount thereof may be set to from 0.1 to 5 equivalents, and preferably from 1 to 2 equivalents, with respect to the metal catalyst used.

When the starting compounds are all solids, or from the standpoint of efficiently obtaining the target aniline derivative, each of the above reactions is carried out in a solvent. When a solvent is used, the type of solvent is not particularly limited, provided it does not have an adverse effect on the reaction. Illustrative examples include aliphatic hydrocarbons (pentane, n-hexane, n-octane, n-decane, decalin, etc.), halogenated aliphatic hydrocarbons (chloroform, dichloromethane, dichloroethane, carbon tetrachloride, etc.), aromatic hydrocarbons (benzene, nitrobenzene, toluene, o-xylene, m-xylene, p-xylene, mesitylene, etc.), halogenated aromatic hydrocarbons (chlorobenzene, bromobenzene, o-dichlorobenzene, m-dichlorobenzene, p-dichlorobenzene, etc.), ethers (diethyl ether, diisopropyl ether, t-butyl methyl ether, tetrahydrofuran, dioxane, 1,2-dimethoxyethane, 1.2-diethoxyethane, etc.), ketones (acetone, methyl ethyl ketone, methyl isobutyl ketone, di-n-butyl ketone, cyclohexanone, etc.), amides (N,N-dimethylformamide, N,N-dimethylacetamide, etc.), lactams and lactones (N-methylpyrrolidone, γ-butyrolactone, etc.), ureas (N,N-dimethylimidazolidinone, tetramethylurea, etc.), sulfoxides (dimethylsulfoxide, sulfolane, etc.), and nitriles (acetonitrile, propionitrile, butyronitrile, etc.). These solvents may be used singly, or two or more may be used in admixture.

The reaction temperature may be suitably set in the range of the melting point to the boiling point of the solvent used, with a temperature of about 0°C to 200°C being preferred, and a temperature of 20 to 150°C being more preferred.

Following reaction completion, the target aniline derivative can be obtained by work-up in the usual manner.

In the method of preparing an aniline derivative of formula (1) above, the amine compound of formula (3') that may be used as a starting material can be efficiently prepared by reacting an amine compound of formula (10) with an aryl compound of formula (11) in the presence of a catalyst. 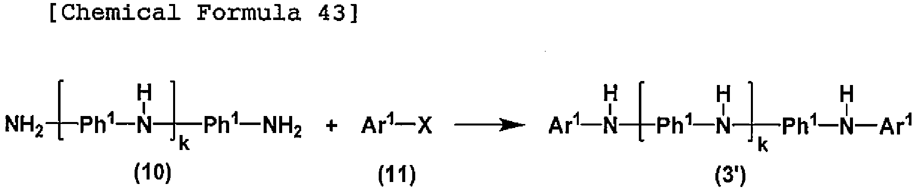 Here, X, Ar¹, Ph¹ and k are as defined above, provided that the two Ar¹ are not both groups of formula (B1).

The above method for preparing an amine compound of formula (3') involves carrying out a coupling reaction between an amine compound of formula (10) and an aryl compound of formula (11). The amine compound of formula (10) and the aryl compound of formula (11) are charged in a molar ratio of preferably about 2 to 2.4 moles of the aryl compound per mole of the amine compound.

Various conditions relating to, for example, the catalyst, ligand, solvent and reaction temperature in the above coupling reaction are the same as the conditions described above for the method of preparing the aniline derivative of formula (1).

When preparing the aniline derivative of the invention wherein, in formula (1), Ar¹ is a group of the formula (B4) in which R⁵² represents a hydrogen atom or a group of formula (B10), or Ar² is a group of formula (A12) or a group of formula (A16) in which R¹⁵⁵ (including R⁵² in formula (1-1)) represents a hydrogen atom, an aryl compound having a protective group on the amino group may be used in the above reaction.

Specifically, in the above reaction, in place of an aryl compound of formula (4) wherein Ar² is a group of formula (A12) (formula (G1)), an aryl compound of formula (4) wherein Ar² is a group of formula (A16) and R¹⁵⁵ is a hydrogen atom (formula (G2)), an aryl compound of formula (8) wherein Ar⁵ is a group of formula (D9) (formula (G1)), an aryl compound of formula (8) wherein Ar⁵ is a group of formula (D11) and R⁵² is a hydrogen atom (formula G2)), an aryl compound of formula (9) wherein Ar⁶ is a group of formula (E13) and R⁵² is a hydrogen atom (formula (G3)), an aryl compound of formula (9) wherein Ar⁶ is a group of formula (E14) and R⁵² is a hydrogen atom (formula (G4)), an aryl compound of formula (11) wherein Ar¹ is a group of formula (B4) and R⁵² is a hydrogen atom (formula (G5)) or an aryl compound of formula 11 wherein Ar¹ is a group of formula (B10) (formula (G6)), use is made instead of aryl compounds wherein the amino group on these respective aryl compounds has been protected (formulas (G1P) to (G6P)). The protected aryl compounds and the above-indicated amine compounds are reacted in the presence of a catalyst, and are subsequently de-protected under suitable timing. 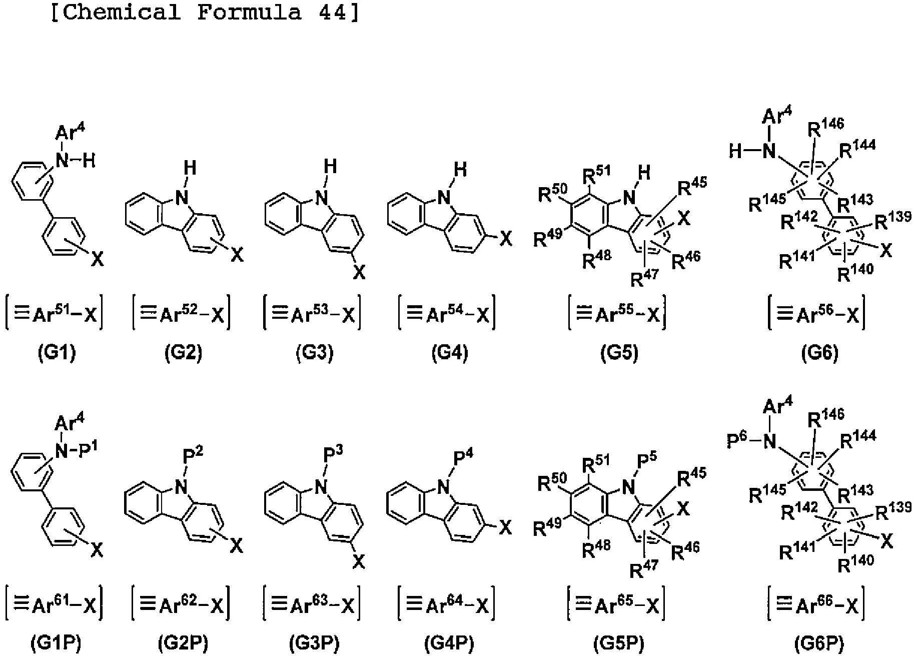 Here, X, R⁴⁵ to R⁵¹, R¹³⁹ to R¹⁴⁶ and Ar⁴ are as defined above.

P¹ to P⁶ are each independently amino-protecting groups. Conventional protective groups may be used as such protective groups. Specific examples include, but are not limited to, oxycarbonyl-type protective groups, such as substituted or unsubstituted alkoxycarbonyl groups (e.g., methoxycarbonyl, ethoxycarbonyl, t-butoxycarbonyl, 2,2,2-trichloroethoxycarbonyl, allyloxycarbonyl and 9-fluorenylmethyloxycarbonyl), substituted or unsubstituted aralkyloxycarbonyl groups (e.g., benzyloxycarbonyl), and substituted or unsubstituted aryloxycarbonyl groups (e.g., phenoxycarbonyl); formyl groups; carbonyl-type protective groups, such as substituted or unsubstituted alkanoyl groups (e.g., acetyl, trifluoroacetyl, t-butanoyl), and substituted or unsubstituted arylcarbonyl groups (e.g., benzoyl); alkyl-type protective groups, such as substituted or unsubstituted alkyl groups (e.g., t-butyl), substituted or unsubstituted aralkyl groups (e.g., benzyl, benzhydryl, trityl); and substituted or unsubstituted sulfonyl-type protective groups (e.g., benzenesulfonyl, p-toluenesulfonyl, 2-nitrobenzenesulfonyl). Of these, oxycarbonyl-type protective groups, carbonyl-type protective groups and alkyl-type protective groups are preferred.

Ar⁵¹ to Ar⁵⁶ and Ar⁶¹ to Ar⁶⁶ are each monovalent groups represented by removing X (a halogen atom or a pseudo-halogen group) from the respective aryl compounds. For example, Ar⁶¹ to Ar⁶⁶ respectively indicate the following groups. 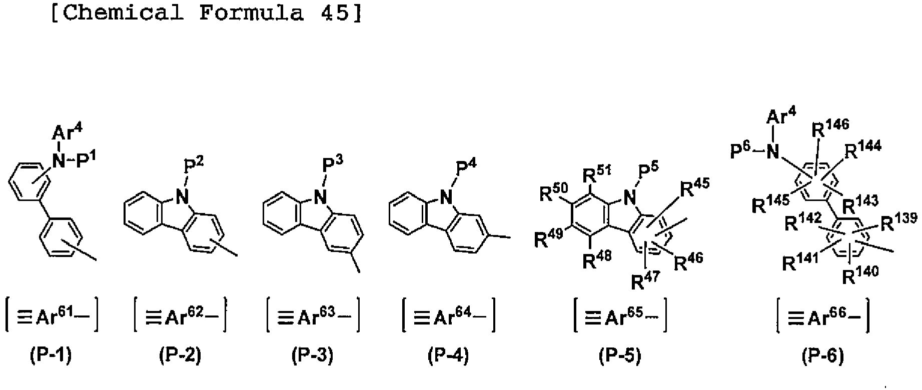 Here, P¹ to P⁶, R⁴⁵ to R⁵¹, R¹³⁹ to R¹⁴⁶ and Ar⁴ are as defined above.

Illustrative examples of preparation methods that use aryl compounds having the above amino-protecting groups include, but are not limited to, those shown below.

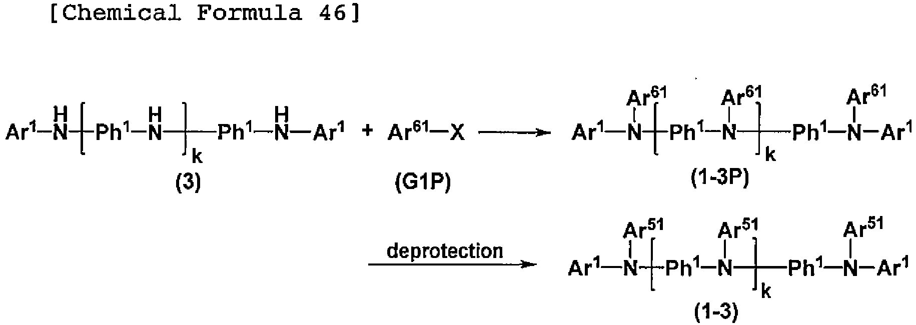

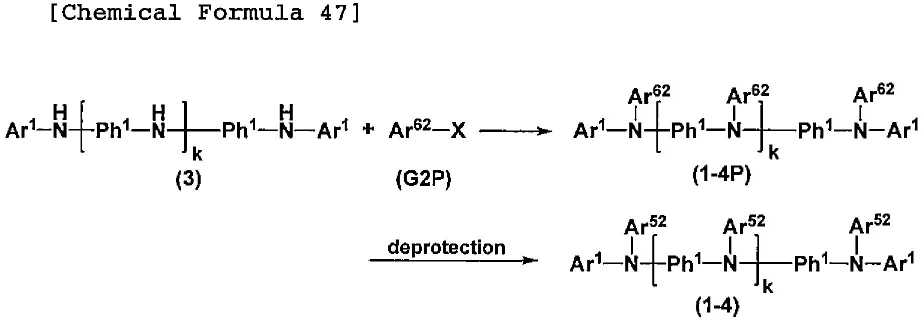

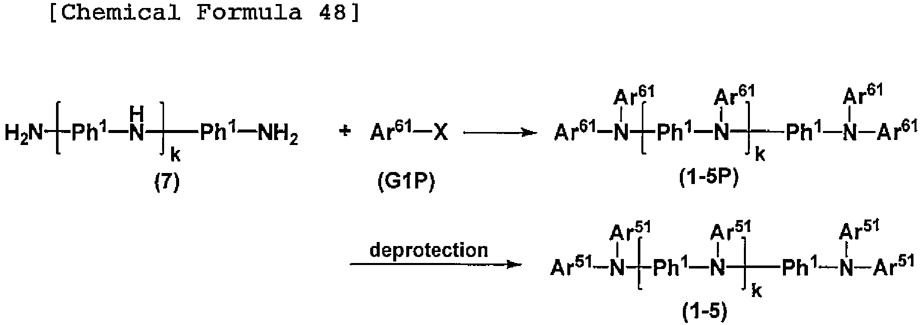

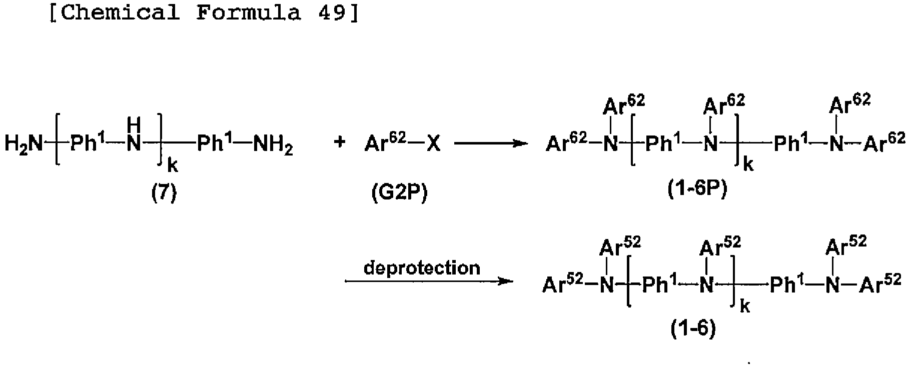

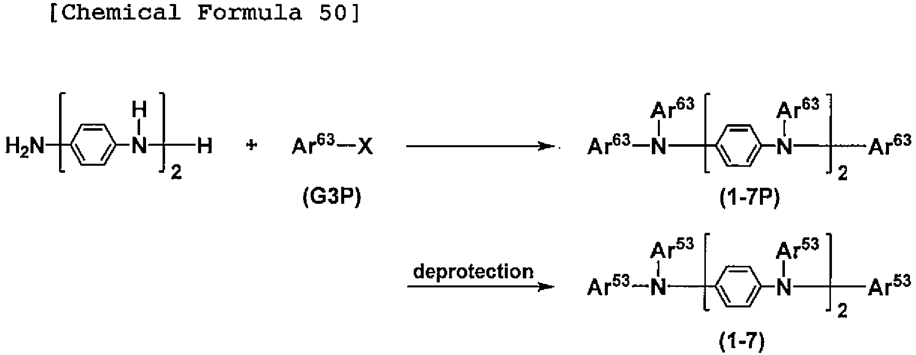

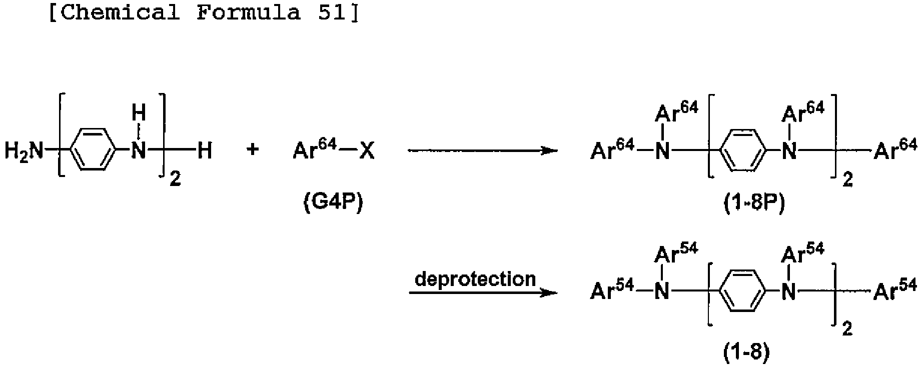

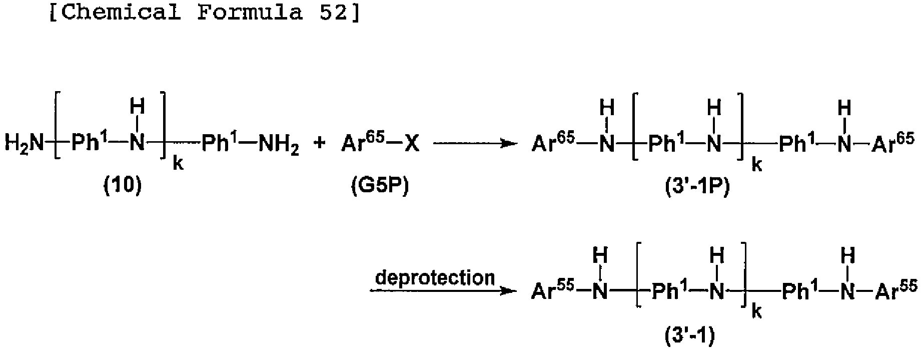

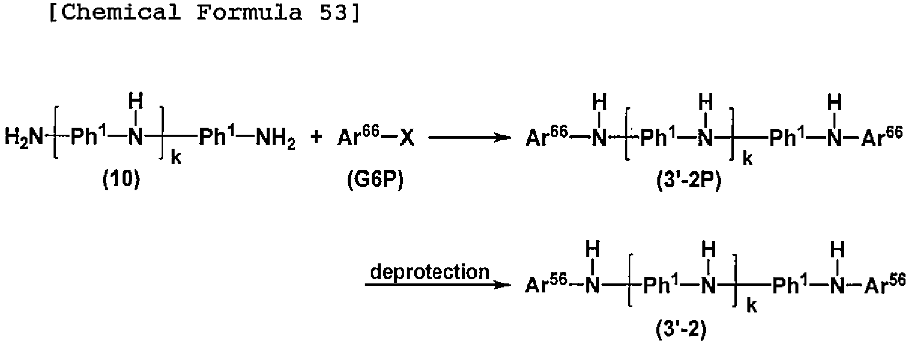

Conditions relating to the starting material charging ratios, catalysts, ligands, solvents, reaction temperatures and the like in preparation methods that use such aryl compounds having protective groups are the same as the conditions described above for aniline derivatives of formula (1) or amine compounds of formula (3'). Also, deprotection may be carried out by a suitable known method, such as treatment under acidic or basic conditions or treatment under oxidizing or reducing conditions, while referring to, for example, "Green's Protective Groups" in Organic Synthesis, 4th Edition and taking into consideration the nature, etc. of the protective groups.

In formula (1), when preparing a tertiary amine site-containing aniline derivative of the invention wherein Ar¹ is a group of formula (B4) in which R⁵² is not a hydrogen atom or a group of formula (B11), or wherein Ar² is a group of formula (A13) or a group of formula (A16) in which R¹⁵⁵ (including R⁵² in formula (1-1)) is not a hydrogen atom, use may be made of a secondary amine site-containing aniline derivative of the invention represented by formula (1) wherein Ar¹ is a group of the formula (B4) in which R⁵² is a hydrogen atom or a group of formula (B10), or wherein Ar² is a group of formula (A12) or a group of formula (A16) in which R¹⁵⁵ (including R⁵² in formula (1-1)) is a hydrogen atom, or of a secondary amine site-containing amine compound of formula (3) wherein Ar¹ is a group of formula (B4) in which R⁵² is a hydrogen atom or is a group of formula (B10).

Specifically, as shown below, the amine site on this secondary amine site-containing aniline derivative or amine compound is reacted with an aryl compound of formula (10) or a hydrocarbon compound of formula (11) or (12).

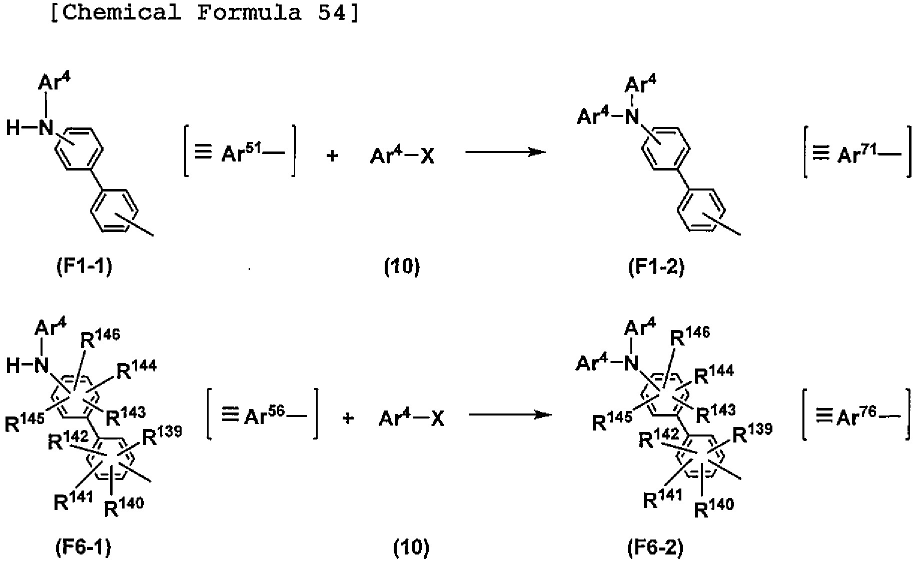

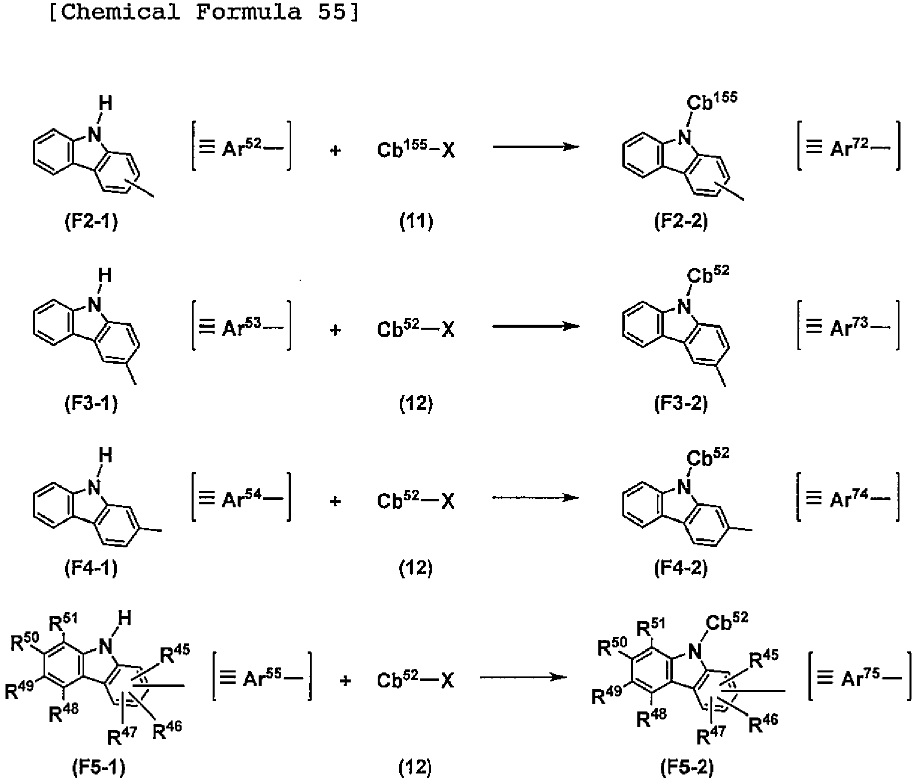

In the formulas, X, R¹³⁹ to R¹⁴⁶, Ar⁴ and R⁴⁵ to R⁵¹ are as defined above. Cb¹⁵⁵ and Cb⁵² are each independently an alkyl group of 1 to 20 carbon atoms, alkenyl group of 2 to 20 carbon atoms or alkynyl group of 2 to 20 carbon atoms which may be substituted with Z⁴, or an aryl group of 6 to 20 carbon atoms or heteroaryl group of 2 to 20 carbon atoms which may be substituted with Z¹, these alkyl, alkenyl, alkynyl, aryl and heteroaryl groups being the same as above. Z¹ and Z⁴ are as defined above.

More specific examples of preparation methods using these secondary amine site-containing aniline derivatives or amine compounds include, but are not limited to, the following.

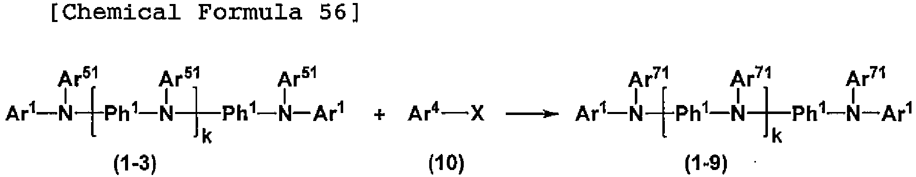

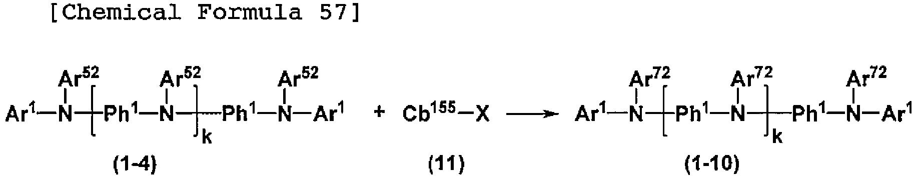

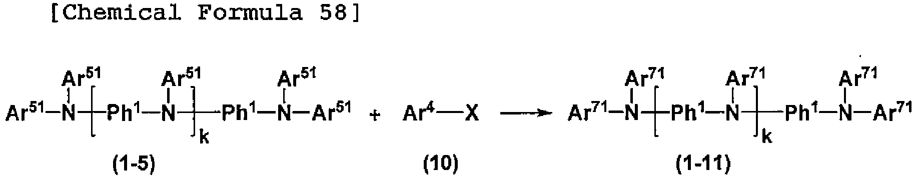

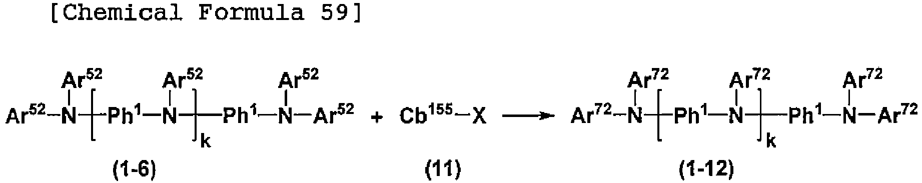

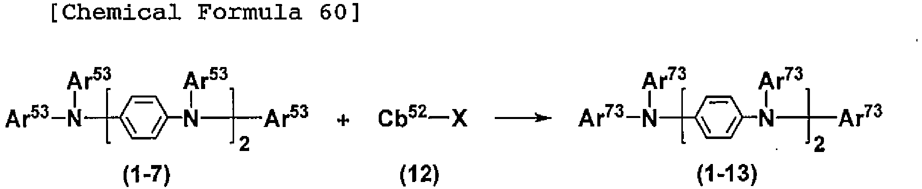

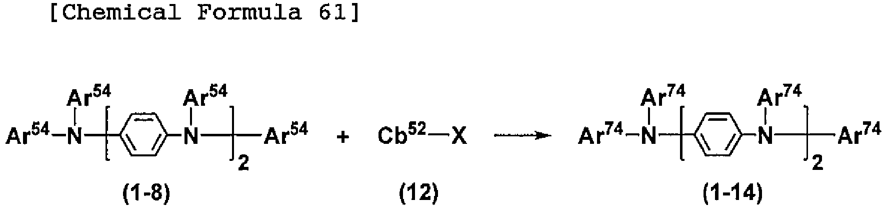

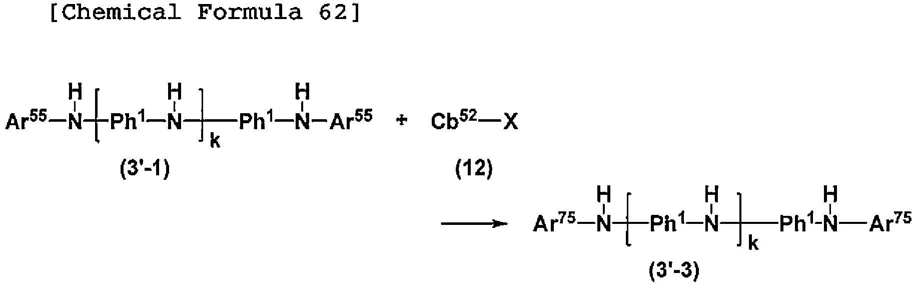

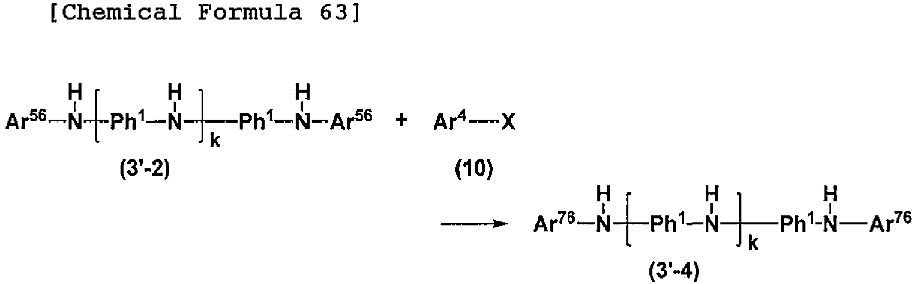

The charging ratio of the aniline derivatives of formula (1-3) to (1-8) to the aryl compound of formula (10) or the hydrocarbon compounds of formulas (11) and (12) may be set such as to make the amount of the aryl compound or hydrocarbon compound at least 1 equivalent, and preferably about 1 to 1.2 equivalents, with respect to the molar amount of all the NH groups on the aniline derivative.

The charging ratio of the amine compounds of formulas (3'-1) and (3'-2) to the aryl compound of formula (10) or the hydrocarbon compound of formula (12), expressed as a molar ratio, is preferably about 2 to 2.4 moles of the aryl compound of formula (10) or the hydrocarbon compound of formula (12) per mole of the amine compounds of formulas (3'-1) and (3'-2).

Conditions other than the charging conditions are as follows.

The conditions relating to catalysts, ligands, solvents, reaction temperatures and the like that are employed when preparing aniline derivatives of formulas (1-9) to (1-14) or amine compounds of formulas (3'-3) to (3'-4) using the copper, palladium or other above-mentioned catalysts may be the conditions described above for the method of preparing aniline derivatives of formula (1).

When an aniline derivative of formulas (1-9) to (1-14) or an amine compound of formulas (3'-3) to (3'-4) is prepared by a substitution reaction using an aryl compound of formula (1), a hydrocarbon compound of formula (11) wherein Cb¹⁵⁵ is an alkyl group of 1 to 20 carbon atoms which may be substituted with Z⁴ or an aryl group of 6 to 20 carbon atoms or heteroaryl group of 2 to 20 carbon atoms which may be substituted with Z¹, or a hydrocarbon compound of formula (12) wherein Cb⁵² is an alkyl group of 1 to 20 carbon atoms which may be substituted with Z⁴ or an aryl group of 6 to 20 carbon atoms or heteroaryl group of 2 to 20 carbon atoms which may be substituted with Z¹, the aniline derivative of formulas (1-3) to (1-8) or the amine compound of formulas (3'-1) to (3'-2) is reacted with a base in a solvent, and the resulting product is reacted with a hydrocarbon compound of formulas (11) to (12) or an aryl compound of formula (10).

Examples of the base include, without particular limitation so long as use in this type of reaction is possible: uncombined alkali metals, alkali metal hydroxides, alkoxy alkali metals, alkali metal carbonates and alkali metal bicarbonates, such as lithium, sodium, potassium, lithium hydride, sodium hydride, potassium hydroxide, t-butoxylithium, t-butoxysodium, t-butoxypotassium, lithium hydroxide, sodium hydroxide, potassium hydroxide, sodium carbonate, potassium carbonate, sodium bicarbonate and potassium bicarbonate; alkaline earth metal carbonates such as calcium carbonate; organolithium compounds such as n-butyllithium, s-butyllithium and t-butyllithium; and amines such as triethylamine, diisopropylethylamine, tetramethylethylenediamine, triethylenediamine and pyridine. Sodium hydride, sodium carbonate and potassium carbonate are especially preferred in terms of ease of handling.

The amount of base used is about 1 to 1.2 equivalents with respect to the molar amount of all the NH groups on the aniline derivative of formulas (1-3) to (1-8), and is about 2 to 2.4 equivalents per mole of amine compound of formulas (3'-1) to (3'-2).

Specific examples of the solvent include the solvents mentioned with respect to the method for preparing aniline derivatives of formula (1). The reaction temperature should be suitably set within the range of the melting point to the boiling point of the solvent used, and is about 20°C to 150°C.

Following reaction completion, work-up such as separatory treatment, column chromatography, re-precipitation and re-crystallization is carried out in the usual manner.

Although impossible to strictly specify owing to effects incurred by, for example, the structure of the starting materials and the type of solvent used, a substitution reaction is preferred when X is a fluorine atom, and a reaction using a catalyst is preferred in cases other than when X is a fluorine atom.

Amine compounds of formula (3) in which the two Ar¹ moieties are both groups of formula (B1) and which may be used as starting materials in the above-described method for preparing aniline derivatives of formula (1) can be synthesized in accordance with the methods described in WO 2008/129947 or WO 2013/08466.

The charge-transporting material of the invention includes a charge-transporting substance consisting of an aniline derivative of formula (1) or (2). From the standpoint of reproducibly obtaining large-surface area thin-films, the charge-transporting material is preferably in the form of a varnish.

Specific examples of aniline derivatives of formula (1) or (2) include, but are not limited to, those shown below. In the formulas below, "Me" stands for a methyl group, "Et" for an ethyl group, "Prⁿ" for an n-propyl group, "Prⁱ" for an i-propyl group, "Buⁿ" for an n-butyl group, "Buⁱ" for an i-butyl group, "Bu^{s}" for an s-butyl group, "Bu^{t}" for a t-butyl group, "DPA" for a diphenylamino group, and "SBF" for a 9,9'-spirobi[9H-fluoren]-2-yl group.

**[Table 1]**

| | | | | | | | |
|---|---|---|---|---|---|---|---|
| 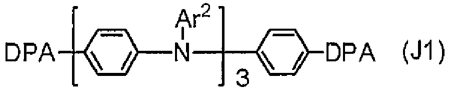 | | | | | | | |

| **Compound** | **Ar²** | **Compound** | **Ar²** | **Compound** | **Ar²** | **Compound** | **Ar²** |
|---|---|---|---|---|---|---|---|
| (J1-1) | (A1-1) | (J1-27) | (A6-11) | (J1-53) | (A12-7) | (J1-79) | (A13-22) |
| (J1-2) | (A1-2) | (J1-28) | (A6-12) | (J1-54) | (A12-8) | (J1-80) | (A13-23) |
| (J1-3) | (A2-1) | (J1-29) | (A6-13) | (J1-55) | (A12-9) | (J1-81) | (A13-24) |
| (J1-4) | (A2-2) | (J1-30) | (A6-14) | (J1-56) | (A12-10) | (J1-82) | (A14-1) |
| (J1-5) | (A2-3) | (J1-31) | (A6-15) | (J1-57) | (A12-11) | (J1-83) | (A14-2) |
| (J1-6) | (A2-4) | (J1-32) | (A7-1) | (J1-58) | (A13-1) | (J1-84) | (A14-3) |
| (J1-7) | (A2-5) | (J1-33) | (A7-2) | (J1-59) | (A13-2) | (J1-85) | (A14-4) |
| (J1-8) | (A3-1) | (J1-34) | (A7-3) | (J1-60) | (A13-3) | (J1-86) | (A15-1) |
| (J1-9) | (A3-2) | (J1-35) | (A8-1) | (J1-61) | (A13-4) | (J1-87) | (A15-2) |
| (J1-10) | (A3-3) | (J1-36) | (A8-2) | (J1-62) | (A13-5) | (J1-88) | (A15-3) |
| (J1-11) | (A4-1) | (J1-37) | (A8-3) | (J1-63) | (A13-6) | (J1-89) | (A15-4) |
| (J1-12) | (A4-2) | (J1-38) | (A9-1) | (J1-64) | (A13-7) | (J1-90) | (A17-1) |
| (J1-13) | (A4-3) | (J1-39) | (A9-2) | (J1-65) | (A13-8) | (J1-91) | (A17-2) |
| (J1-14) | (A5-1) | (J1-40) | (A9-3) | (J1-66) | (A13-9) | (J1-92) | (A17-3) |
| (J1-15) | (A5-2) | (J1-41) | (A10-1) | (J1-67) | (A13-10) | (J1-93) | (A17-4) |
| (J1-16) | (A5-3) | (J1-42) | (A10-2) | (J1-68) | (A13-11) | (J1-94) | (A17-5) |
| (J1-17) | (A6-1) | (J1-43) | (A10-3) | (J1-69) | (A13-12) | (J1-95) | (A17-6) |
| (J1-18) | (A6-2) | (J1-44) | (A11-1) | (J1-70) | (A13-13) | (J1-96) | (A17-7) |
| (J1-19) | (A6-3) | (J1-45) | (A11-2) | (J1-71) | (A13-14) | (J1-97) | (A17-8) |
| (J1-20) | (A6-4) | (J1-46) | (A11-3) | (J1-72) | (A13-15) | (J1-98) | (A17-9) |
| (J1-21) | (A6-5) | (J1-47) | (A12-1) | (J1-73) | (A13-16) | (J1-99) | (A17-10) |
| (J1-22) | (A6-6) | (J1-48) | (A12-2) | (J1-74) | (A13-17) | (J1-100) | (A17-11) |
| (J1-23) | (A6-7) | (J1-49) | (A12-3) | (J1-75) | (A13-18) | (J1-101) | (A17-12) |
| (J1-24) | (A6-8) | (J1-50) | (A12-4) | (J1-76) | (A13-19) | (J1-102) | (A18-1) |
| (J1-25) | (A6-9) | (J1-51) | (A12-5) | (J1-77) | (A13-20) | (J1-103) | (A18-2) |
| (J1-26) | (A6-10) | (J1-52) | (A12-6) | (J1-78) | (A13-21) | | |

**[Table 2]**

| | | | | | | | |
|---|---|---|---|---|---|---|---|
| 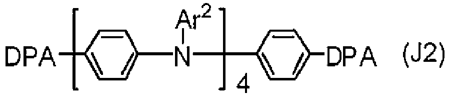 | | | | | | | |

| **Compound** | **Ar²** | **Compound** | **Ar²** | **Compound** | **Ar²** | **Compound** | **Ar²** |
|---|---|---|---|---|---|---|---|
| (J2-1) | (A1-1) | (J2-27) | (A6-11) | (J2-53) | (A12-7) | (J2-79) | (A13-22) |
| (J2-2) | (A1-2) | (J2-28) | (A6-12) | (J2-54) | (A12-8) | (J2-80) | (A13-23) |
| (J2-3) | (A2-1) | (J2-29) | (A6-13) | (J2-55) | (A12-9) | (J2-81) | (A13-24) |
| (J2-4) | (A2-2) | (J2-30) | (A6-14) | (J2-56) | (A12-10) | (J2-82) | (A14-1) |
| (J2-5) | (A2-3) | (J2-31) | (A6-15) | (J2-57) | (A12-11) | (J2-83) | (A14-2) |
| (J2-6) | (A2-4) | (J2-32) | (A7-1) | (J2-58) | (A13-1) | (J2-84) | (A14-3) |
| (J2-7) | (A2-5) | (J2-33) | (A7-2) | (J2-59) | (A13-2) | (J2-85) | (A14-4) |
| (J2-8) | (A3-1) | (J2-34) | (A7-3) | (J2-60) | (A13-3) | (J2-86) | (A15-1) |
| (J2-9) | (A3-2) | (J2-35) | (A8-1) | (J2-61) | (A13-4) | (J2-87) | (A15-2) |
| (J2-10) | (A3-3) | (J2-36) | (A8-2) | (J2-62) | (A13-5) | (J2-88) | (A15-3) |
| (J2-11) | (A4-1) | (J2-37) | (A8-3) | (J2-63) | (A13-6) | (J2-89) | (A15-4) |
| (J2-12) | (A4-2) | (J2-38) | (A9-1) | (J2-64) | (A13-7) | (J2-90) | (A17-1) |
| (J2-13) | (A4-3) | (J2-39) | (A9-2) | (J2-65) | (A13-8) | (J2-91) | (A17-2) |
| (J2-14) | (A5-1) | (J2-40) | (A9-3) | (J2-66) | (A13-9) | (J2-92) | (A17-3) |
| (J2-15) | (A5-2) | (J2-41) | (A10-1) | (J2-67) | (A13-10) | (J2-93) | (A17-4) |
| (J2-16) | (A5-3) | (J2-42) | (A10-2) | (J2-68) | (A13-11) | (J2-94) | (A17-5) |
| (J2-17) | (A6-1) | (J2-43) | (A10-3) | (J2-69) | (A13-12) | (J2-95) | (A17-6) |
| (J2-18) | (A6-2) | (J2-44) | (A11-1) | (J2-70) | (A13-13) | (J2-96) | (A17-7) |
| (J2-19) | (A6-3) | (J2-45) | (A11-2) | (J2-71) | (A13-14) | (J2-97) | (A17-8) |
| (J2-20) | (A6-4) | (J2-46) | (A11-3) | (J2-72) | (A13-15) | (J2-98) | (A17-9) |
| (J2-21) | (A6-5) | (J2-47) | (A12-1) | (J2-73) | (A13-16) | (J2-99) | (A17-10) |
| (J2-22) | (A6-6) | (J2-48) | (A12-2) | (J2-74) | (A13-17) | (J2-100) | (A17-11) |
| (J2-23) | (A6-7) | (J2-49) | (A12-3) | (J2-75) | (A13-18) | (J2-101) | (A17-12) |
| (J2-24) | (A6-8) | (J2-50) | (A12-4) | (J2-76) | (A13-19) | (J2-102) | (A18-1) |
| (J2-25) | (A6-9) | (J2-51) | (A12-5) | (J2-77) | (A13-20) | (J2-103) | (A18-2) |
| (J2-26) | (A6-10) | (J2-52) | (A12-6) | (J2-78) | (A13-21) | | |

**[Table 3]**

| | | | | | | | |
|---|---|---|---|---|---|---|---|
| 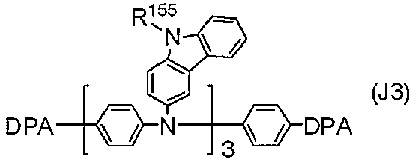 | | | | | | | |

| **Compound** | **R¹⁵⁵** | **Compound** | **R¹⁵⁵** | **Compound** | **R¹⁵⁵** | **Compound** | **R¹⁵⁵** |
|---|---|---|---|---|---|---|---|
| (J3-1) | (N1) | (J3-27) | (N27) | (J3-53) | (N53) | (J3-79) | -H |
| (J3-2) | (N2) | (J3-28) | (N28) | (J3-54) | (N54) | (J3-80) | -Me |
| (J3-3) | (N3) | (J3-29) | (N29) | (J3-55) | (N55) | (J3-81) | -Et |
| (J3-4) | (N4) | (J3-30) | (N30) | (J3-56) | (N56) | (J3-82) | -Prⁿ |
| (J3-5) | (N5) | (J3-31) | (N31) | (J3-57) | (N57) | (J3-83) | -Prⁱ |
| (J3-6) | (N6) | (J3-32) | (N32) | (J3-58) | (N58) | (J3-84) | -Buⁿ |
| (J3-7) | (N7) | (J3-33) | (N33) | (J3-59) | (N59) | (J3-85) | -Buⁱ |
| (J3-8) | (N8) | (J3-34) | (N34) | (J3-60) | (N60) | (J3-86) | -Bu^{s} |
| (J3-9) | (N9) | (J3-35) | (N35) | (J3-61) | (N61) | (J3-87) | -Bu^{t} |
| (J3-10) | (N10) | (J3-36) | (N36) | (J3-62) | (N62) | | |
| (J3-11) | (N11) | (J3-37) | (N37) | (J3-63) | (N63) | | |
| (J3-12) | (N12) | (J3-38) | (N38) | (J3-64) | (N64) | | |
| (J3-13) | (N13) | (J3-39) | (N39) | (J3-65) | (N65) | | |
| (J3-14) | (N14) | (J3-40) | (N40) | (J3-66) | (N66) | | |
| (J3-15) | (N15) | (J3-41) | (N41) | (J3-67) | (N67) | | |
| (J3-16) | (N16) | (J3-42) | (N42) | (J3-68) | (N68) | | |
| (J3-17) | (N17) | (J3-43) | (N43) | (J3-69) | (N69) | | |
| (J3-18) | (N18) | (J3-44) | (N44) | (J3-70) | (N70) | | |
| (J3-19) | (N19) | (J3-45) | (N45) | (J3-71) | (N71) | | |
| (J3-20) | (N20) | (J3-46) | (N46) | (J3-72) | (N72) | | |
| (J3-21) | (N21) | (J3-47) | (N47) | (J3-73) | (N73) | | |
| (J3-22) | (N22) | (J3-48) | (N48) | (J3-74) | (N74) | | |
| (J3-23) | (N23) | (J3-49) | (N49) | (J3-75) | (N75) | | |
| (J3-24) | (N24) | (J3-50) | (N50) | (J3-76) | (N76) | | |
| (J3-25) | (N25) | (J3-51) | (N51) | (J3-77) | (N77) | | |
| (J3-26) | (N26) | (J3-52) | (N52) | (J3-78) | (N78) | | |

**[Table 4]**

| | | | | | | | |
|---|---|---|---|---|---|---|---|
| 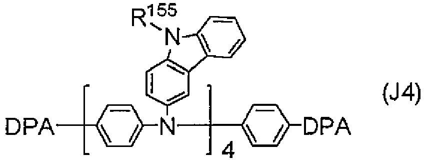 | | | | | | | |

| **Compound** | **R¹⁵⁵** | **Compound** | **R¹⁵⁵** | **Compound** | **R¹⁵⁵** | **Compound** | **R¹⁵⁵** |
|---|---|---|---|---|---|---|---|
| (J4-1) | (N1) | (J4-27) | (N27) | (J4-53) | (N53) | (J4-79) | -H |
| (J4-2) | (N2) | (J4-28) | (N28) | (J4-54) | (N54) | (J4-80) | -Me |
| (J4-3) | (N3) | (J4-29) | (N29) | (J4-55) | (N55) | (J4-81) | -Et |
| (J4-4) | (N4) | (J4-30) | (N30) | (J4-56) | (N56) | (J4-82) | -Prⁿ |
| (J4-5) | (N5) | (J4-31) | (N31) | (J4-57) | (N57) | (J4-83) | -Prⁱ |
| (J4-6) | (N6) | (J4-32) | (N32) | (J4-58) | (N58) | (J4-84) | -Buⁿ |
| (J4-7) | (N7) | (J4-33) | (N33) | (J4-59) | (N59) | (J4-85) | -Buⁱ |
| (J4-8) | (N8) | (J4-34) | (N34) | (J4-60) | (N60) | (J4-86) | -Bu^{s} |
| (J4-9) | (N9) | (J4-35) | (N35) | (J4-61) | (N61) | (J4-87) | -Bu^{t} |
| (J4-10) | (N10) | (J4-36) | (N36) | (J4-62) | (N62) | | |
| (J4-11) | (N11) | (J4-37) | (N37) | (J4-63) | (N63) | | |
| (J4-12) | (N12) | (J4-38) | (N38) | (J4-64) | (N64) | | |
| (J4-13) | (N13) | (J4-39) | (N39) | (J4-65) | (N65) | | |
| (J4-14) | (N14) | (J4-40) | (N40) | (J4-66) | (N66) | | |
| (J4-15) | (N15) | (J4-41) | (N41) | (J4-67) | (N67) | | |
| (J4-16) | (N16) | (J4-42) | (N42) | (J4-68) | (N68) | | |
| (J4-17) | (N17) | (J4-43) | (N43) | (J4-69) | (N69) | | |
| (J4-18) | (N18) | (J4-44) | (N44) | (J4-70) | (N70) | | |
| (J4-19) | (N19) | (J4-45) | (N45) | (J4-71) | (N71) | | |
| (J4-20) | (N20) | (J4-46) | (N46) | (J4-72) | (N72) | | |
| (J4-21) | (N21) | (J4-47) | (N47) | (J4-73) | (N73) | | |
| (J4-22) | (N22) | (J4-48) | (N48) | (J4-74) | (N74) | | |
| (J4-23) | (N23) | (J4-49) | (N49) | (J4-75) | (N75) | | |
| (J4-24) | (N24) | (J4-50) | (N50) | (J4-76) | (N76) | | |
| (J4-25) | (N25) | (J4-51) | (N51) | (J4-77) | (N77) | | |
| (J4-26) | (N26) | (J4-52) | (N52) | (J4-78) | (N78) | | |

**[Table 5]**

| | | | | | | | |
|---|---|---|---|---|---|---|---|
| 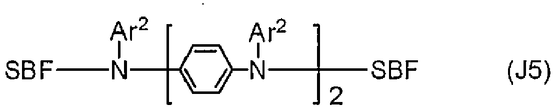 | | | | | | | |

| **Compound** | **Ar²** | **Compound** | **Ar²** | **Compound** | **Ar²** | **Compound** | **Ar²** |
|---|---|---|---|---|---|---|---|
| (J5-1) | (A1-1) | (J5-27) | (A6-11) | (J5-53) | (A12-7) | (J5-79) | (A 13-22) |
| (J5-2) | (A1-2) | (J5-28) | (A6-12) | (J5-54) | (A12-8) | (J5-80) | (A13-23) |
| (J5-3) | (A2-1) | (J5-29) | (A6-13) | (J5-5 5) | (A12-9) | (J5-81) | (A13-24) |
| (J5-4) | (A2-2) | (J5-30) | (A6-14) | (J5-56) | (A12-10) | (J5-82) | (A14-1) |
| (J5-5) | (A2-3) | (J5-31) | (A6-15) | (J5-57) | (A12-11) | (J5-83) | (A 14-2) |
| (J5-6) | (A2-4) | (J5-32) | (A7-1) | (J5-58) | (A13-1) | (J5-84) | (A 14-3) |
| (J5-7) | (A2-5) | (J5-33) | (A7-2) | (J5-59) | (A13-2) | (J5-85) | (A 14-4) |
| (J5-8) | (A3-1) | (J5-34) | (A7-3) | (J 5-60) | (A13-3) | (J5-86) | (A15-1) |
| (J5-9) | (A3-2) | (J5-35) | (A8-1) | (J5-61) | (A13-4) | (J5-87) | (A 15-2) |
| (J5-10) | (A3-3) | (J5-36) | (A8-2) | (J5-6 2) | (A13-5) | (J5-88) | (A 15-3) |
| (J5-11) | (A4-1) | (J5-37) | (A8-3) | (J5-63) | (A13-6) | (J5-89) | (A1 5-4) |
| (J5-12) | (A4-2) | (J5-38) | (A9-1) | (J5-64) | (A13-7) | (J5-90) | (A17-1) |
| (J5-13) | (A4-3) | (J5-39) | (A9-2) | (J5-65) | (A13-8) | (J5-91) | (A17-2) |
| (J5-14) | (A5-1) | (J5-40) | (A9-3) | (J5-66) | (A13-9) | (J5-92) | (A17-3) |
| (J5-15) | (A5-2) | (J5-41) | (A10-1) | (J5-67) | (A13-10) | (J5-93) | (A17-4) |
| (J5-16) | (A5-3) | (J5-42) | (A10-2) | (J5-68) | (A13-11) | (J5-94) | (A17-5) |
| (J5-17) | (A6-1) | (J5-43) | (A10-3) | (J5-69) | (A13-12) | (J5-95) | (A17-6) |
| (J5-18) | (A6-2) | (J5-44) | (A11-1) | (J5-70) | (A13-13) | (J5-96) | (A17-7) |
| (J5-19) | (A6-3) | (J5-45) | (A11-2) | (J5-71) | (A13-14) | (J5-97) | (A17-8) |
| (J5-20) | (A6-4) | (J5-46) | (A11-3) | (J 5-72) | (A13-15) | (J5-98) | (A17-9) |
| (J5-21) | (A6-5) | (J5-47) | (A12-1) | (J5-73) | (A13-16) | (J5-99) | (A17-10) |
| (J5-22) | (A6-6) | (J5-48) | (A12-2) | (J5-74) | (A13-17) | (J5-100) | (A17-11) |
| (J5-23) | (A6-7) | (J5-49) | (A12-3) | (J5-75) | (A13-18) | (J5-101) | (A17-12) |
| (J5-24) | (A6-8) | (J5-50) | (A12-4) | (J5-76) | (A13-19) | (J5-102) | (A18-1) |
| (J5-25) | (A6-9) | (J5-51) | (A12-5) | (J5-77) | (A13-20) | (J5-103) | (A18-2) |
| (J5-26) | (A6-10) | (J5-52) | (A12-6) | (J5-78) | (A13-21) | | |

**[Table 6]**

| | | | | | | | |
|---|---|---|---|---|---|---|---|
| 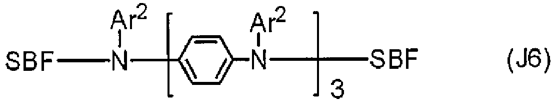 | | | | | | | |

| **Compound** | **Ar²** | **Compound** | **Ar²** | **Compound** | **Ar²** | **Compound** | **Ar²** |
|---|---|---|---|---|---|---|---|
| (J6-1) | (A1-1) | (J6-27) | (A6-11) | (J6-53) | (A12-7) | (J6-79) | (A13-22) |
| (J6-2) | (A1-2) | (J6-28) | (A6-12) | (J6-54) | (A12-8) | (J6-80) | (A13-23) |
| (J6-3) | (A2-1) | (J6-29) | (A6-13) | (J6-55) | (A12-9) | (J6-81) | (A13-24) |
| (J6-4) | (A2-2) | (J6-30) | (A6-14) | (J6-56) | (A12-10) | (J6-82) | (A14-1) |
| (J6-5) | (A2-3) | (J6-31) | (A6-15) | (J6-57) | (A12-11) | (J6-83) | (A14-2) |
| (J6-6) | (A2-4) | (J6-32) | (A7-1) | (J6-58) | (A13-1) | (J6-84) | (A14-3) |
| (J6-7) | (A2-5) | (J6-33) | (A7-2) | (J6-59) | (A13-2) | (J6-85) | (A14-4) |
| (J6-8) | (A3-1) | (J6-34) | (A7-3) | (J6-60) | (A13-3) | (J6-86) | (A15-1) |
| (J6-9) | (A3-2) | (J6-35) | (A8-1) | (J6-61) | (A13-4) | (J6-87) | (A15-2) |
| (J6-10) | (A3-3) | (J6-36) | (A8-2) | (J6-62) | (A13-5) | (J6-88) | (A 15-3) |
| (J6-11) | (A4-1) | (J6-37) | (A8-3) | (J6-63) | (A13-6) | (J6-89) | (A15-4) |
| (J 6-12) | (A4-2) | (J6-38) | (A9-1) | (J6-64) | (A13-7) | (J6-90) | (A17-1) |
| (J6-13) | (A4-3) | (J6-39) | (A9-2) | (J6-65) | (A13-8) | (J6-91) | (A17-2) |
| (J6-14) | (A5-1) | (J6-40) | (A9-3) | (J6-66) | (A13-9) | (J6-92) | (A 17-3) |
| (J6-15) | (A5-2) | (J6-41) | (A10-1) | (J6-67) | (A13-10) | (J6-93) | (A17-4) |
| (J6-16) | (A5-3) | (J6-42) | (A10-2) | (J6-68) | (A13-11) | (J6-94) | (A17-5) |
| (J6-17) | (A6-1) | (J6-43) | (A10-3) | (J6-69) | (A13-12) | (J6-95) | (A17-6) |
| (J6-18) | (A6-2) | (J6-44) | (A11-1) | (J6-70) | (A13-13) | (J6-96) | (A17-7) |
| (J6-19) | (A6-3) | (J6-45) | (A11-2) | (J6-71) | (A13-14) | (J6-97) | (A17-8) |
| (J6-20) | (A6-4) | (J6-46) | (A11-3) | (J6-72) | (A13-15) | (J6-98) | (A17-9) |
| (J6-21) | (A6-5) | (J6-47) | (A12-1) | (J6-73) | (A13-16) | (J6-99) | (A17-10) |
| (J6-22) | (A6-6) | (J6-48) | (A12-2) | (J6-74) | (A13-17) | (J6-100) | (A17-11) |
| (J6-23) | (A6-7) | (J6-49) | (A12-3) | (J6-75) | (A13-18) | (J6-101) | (A17-12) |
| (J6-24) | (A6-8) | (J6-50) | (A12-4) | (J6-76) | (A13-19) | (J6-102) | (A18-1) |
| (J6-25) | (A6-9) | (J6-51) | (A12-5) | (J6-77) | (A13-20) | (J6-103) | (A18-2) |
| (J6-26) | (A6-10) | (J6-52) | (A12-6) | (J6-78) | (A13-21) | | |

**[Table 7]**

| | | | | | | | |
|---|---|---|---|---|---|---|---|
| 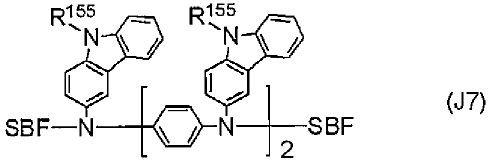 | | | | | | | |

| **Compound** | **R¹⁵⁵** | **Compound** | **R¹⁵⁵** | **Compound** | **R¹⁵⁵** | **Compound** | **R¹⁵⁵** |
|---|---|---|---|---|---|---|---|
| (J7-1) | (N1) | (J7-27) | (N27) | (J7-53) | (N53) | (J7-79) | -H |
| (J7-2) | (N2) | (J7-28) | (N28) | (J7-54) | (N54) | (J7-80) | -Me |
| (J7-3) | (N3) | (J7-29) | (N29) | (J7-55) | (N55) | (J7-81) | -Et |
| (J7-4) | (N4) | (J7-30) | (N30) | (J7-56) | (N56) | (J7-82) | -Prⁿ |
| (J7-5) | (N5) | (J7-31) | (N31) | (J7-57) | (N57) | (J7-83) | -Prⁱ |
| (J7-6) | (N6) | (J7-32) | (N32) | (J7-58) | (N58) | (J7-84) | -Buⁿ |
| (J7-7) | (N7) | (J7-33) | (N33) | (J7-59) | (N59) | (J7-85) | -Buⁱ |
| (J7-8) | (N8) | (J7-34) | (N34) | (J7-60) | (N60) | (J7-86) | -Bu^{s} |
| (J7-9) | (N9) | (J7-35) | (N35) | (J7-61) | (N61) | (J7-87) | -Bu^{t} |
| (J7-10) | (N10) | (J7-36) | (N36) | (J7-62) | (N62) | | |
| (J7-11) | (N11) | (J7-37) | (N37) | (J7-63) | (N63) | | |
| (J7-12) | (N12) | (J7-38) | (N38) | (J7-64) | (N64) | | |
| (J7-13) | (N13) | (J7-39) | (N39) | (J7-65) | (N65) | | |
| (J7-14) | (N14) | (J7-40) | (N40) | (J7-66) | (N66) | | |
| (J7-15) | (N15) | (J7-41) | (N41) | (J7-67) | (N67) | | |
| (J7-16) | (N16) | (J7-42) | (N42) | (J7-68) | (N68) | | |
| (J7-17) | (N17) | (J7-43) | (N43) | (J7-69) | (N69) | | |
| (J7-18) | (N18) | (J7-44) | (N44) | (J7-70) | (N70) | | |
| (J7-19) | (N19) | (J7-45) | (N45) | (J7-71) | (N71) | | |
| (J7-20) | (N20) | (J7-46) | (N46) | (J7-72) | (N72) | | |
| (J7-21) | (N21) | (J7-47) | (N47) | (J7-73) | (N73) | | |
| (J7-22) | (N22) | (J7-48) | (N48) | (J7-74) | (N74) | | |
| (J7-23) | (N23) | (J7-49) | (N49) | (J7-75) | (N75) | | |
| (J7-24) | (N24) | (J7-50) | (N50) | (J7-76) | (N76) | | |
| (J7-25) | (N25) | (J7-51) | (N51) | (J7-77) | (N77) | | |
| (J7-26) | (N26) | (J7-52) | (N52) | (J7-78) | (N78) | | |

**[Table 8]**

| | | | | | | | |
|---|---|---|---|---|---|---|---|
| 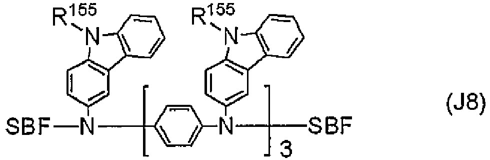 | | | | | | | |

| **Compound** | **R¹⁵⁵** | **Compound** | **R¹⁵⁵** | **Compound** | **R¹⁵⁵** | **Compound** | **R¹⁵⁵** |
|---|---|---|---|---|---|---|---|
| (J8-1) | (N1) | (J8-27) | (N27) | (J8-53) | (N53) | (J8-79) | -H |
| (J8-2) | (N2) | (J8-28) | (N28) | (J8-54) | (N54) | (J8-80) | -Me |
| (J8-3) | (N3) | (J8-29) | (N29) | (J8-55) | (N55) | (J8-81) | -Et |
| (J8-4) | (N4) | CJ8-30) | (N30) | (J8-56) | (N56) | (J8-82) | -Prⁿ |
| (J8-5) | (N5) | (J8-31) | (N31) | (J8-57) | (N57) | (J8-83) | -Prⁱ |
| (J8-6) | (N6) | (J8-32) | (N32) | (J8-58) | (N58) | (J8-84) | -Buⁿ |
| (J8-7) | (N7) | (J8-33) | (N33) | (J8-59) | (N59) | (d8-85) | -Buⁱ |
| (J8-8) | (N8) | (J8-34) | (N34) | (J8-60) | (N60) | (J8-86) | -Bu^{s} |
| (J8-9) | (N9) | (J8-35) | (N35) | (J8-61) | (N61) | (J8-87) | -Bu^{t} |
| (J8-10) | (N10) | (J8-36) | (N36) | (J8-62) | (N62) | | |
| (J8-11) | (N11) | (J8-37) | (N37) | (J8-63) | (N63) | | |
| (J8-12) | (N12) | (J8-38) | (N38) | (J8-64) | (N64) | | |
| (J8-13) | (N13) | (J8-39) | (N39) | (J8-65) | (N65) | | |
| (J8-14) | (N14) | (J8-40) | (N40) | (J8-66) | (N66) | | |
| (J8-15) | (N15) | (J8-41) | (N41) | (J8-67) | (N67) | | |
| (J8-16) | (N16) | (J8-42) | (N42) | (JB-68) | (N68) | | |
| (J8-17) | (N17) | (J8-43) | (N43) | (J8-69) | (N69) | | |
| (J8-18) | (N18) | (J8-44) | (N44) | (J8-70) | (N70) | | |
| (J8-19) | (N19) | (J8-45) | (N45) | (J8-71) | (N71) | | |
| (J8-20) | (N20) | (J8-46) | (N46) | (J8-72) | (N72) | | |
| (J8-21) | (N21) | (J8-47) | (N47) | (J8-73) | (N73) | | |
| (J8-22) | (N22) | (J8-48) | (N48) | (J8-74) | (N74) | | |
| (J8-23) | (N23) | (J8-49) | (N49) | (J8-75) | (N75) | | |
| (J8-24) | (N24) | (J8-50) | (N50) | (J8-76) | (N76) | | |
| (J8-25) | (N25) | (J8-51) | (N51) | (J8-77) | (N77) | | |
| (J8-26) | (N26) | (J8-52) | (N52) | (J8-78) | (N78) | | |

**[Table 9]**

| | | | | | | | |
|---|---|---|---|---|---|---|---|
| 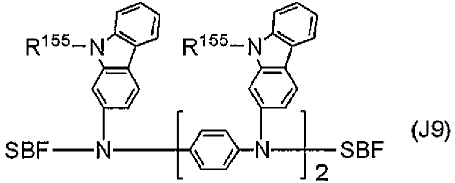 | | | | | | | |

| **Compound** | **R¹⁵⁵** | **Compound** | **R¹⁵⁵** | **Compound** | **R¹⁵⁵** | **Compound** | **R¹⁵⁵** |
|---|---|---|---|---|---|---|---|
| (J9-1) | (N1) | (J9-27) | (N27) | (J9-53) | (N53) | (J9-79) | -H |
| (J9-2) | (N2) | (J9-28) | (N28) | (J9-54) | (N54) | (J9-80) | -Me |
| (J9-3) | (N3) | (J9-29) | (N29) | (J9-55) | (N55) | (J9-81) | -Et |
| (J9-4) | (N4) | (J9-30) | (N30) | (J9-56) | (N56) | (J9-82) | -Prⁿ |
| (J9-5) | (N5) | (J9-31) | (N31) | (J9-57) | (N57) | (J9-83) | -Prⁱ |
| (J9-6) | (N6) | (J9-32) | (N32) | (J9-58) | (N58) | (J 9-84) | -Buⁿ |
| (J9-7) | (N7) | (J9-33) | (N33) | (J9-59) | (N59) | (J9-85) | -Buⁱ |
| (J9-8) | (N8) | (J9-34) | (N34) | (J9-60) | (N60) | (J9-86) | -Bu^{s} |
| (J9-9) | (N9) | (J9-35) | (N35) | (J9-61) | (N61) | (J9-87) | -Bu^{t} |
| (J9-10) | (N10) | (J9-36) | (N36) | (J9-62) | (N62) | | |
| (J9-11) | (N11) | (J9-37) | (N37) | (J9-63) | (N63) | | |
| (J9-12) | (N12) | (J9-38) | (N38) | (J9-64) | (N64) | | |
| (J9-13) | (N13) | (J9-39) | (N39) | (J9-65) | (N65) | | |
| (J9-14) | (N14) | (J9-40) | (N40) | (J9-66) | (N66) | | |
| (J9-15) | (N15) | (J9-41) | (N41) | (J9-67) | (N67) | | |
| (J9-16) | (N16) | (J9-42) | (N42) | (J9-68) | (N68) | | |
| (J9-17) | (N17) | (J9-43) | (N43) | (J9-69) | (N69) | | |
| (J9-18) | (N18) | (J9-44) | (N44) | (J9-70) | (N70) | | |
| (J9-19) | (N19) | (J9-45) | (N45) | (J9-71) | (N71) | | |
| (J9-20) | (N20) | (J9-46) | (N46) | (J9-72) | (N72) | | |
| (J9-21) | (N21) | (J9-47) | (N47) | (J9-73) | (N73) | | |
| (J9-22) | (N22) | (J9-48) | (N48) | (J9-74) | (N74) | | |
| (J9-23) | (N23) | (J9-49) | (N49) | (J9-75) | (N75) | | |
| (J9-24) | (N24) | (J9-50) | (N50) | (J9-76) | (N76) | | |
| (J9-25) | (N25) | (J9-51) | (N51) | (J9-77) | (N77) | | |
| (J9-26) | (N26) | (J9-52) | (N52) | (J9-78) | (N78) | | |

**[Table 10]**

| | | | | | | | |
|---|---|---|---|---|---|---|---|
| 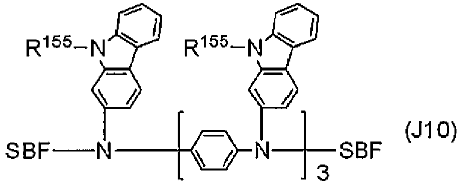 | | | | | | | |

| **Compound** | **R¹⁵⁵** | **Compound** | **R¹⁵⁵** | **Compound** | **R¹⁵⁵** | **Compound** | **R¹⁵⁵** |
|---|---|---|---|---|---|---|---|
| (J10-1) | (N1) | (J10-27) | (N27) | (J10-53) | (N53) | (J10-79) | -H |
| (J10-2) | (N2) | (J10-28) | (N28) | (J10-54) | (N54) | (J10-80) | -Me |
| (J10-3) | (N3) | (J10-29) | (N29) | (J10-55) | (N55) | (J10-81) | -Et |
| (J10-4) | (N4) | (J10-30) | (N30) | (J10-56) | (N56) | (J10-82) | -Prⁿ |
| (J10-5) | (N5) | (J10-31) | (N31) | (J10-57) | (N57) | (J10-83) | -Prⁱ |
| (J10-6) | (N6) | (J10-32) | (N32) | (J10-58) | (N58) | (J10-84) | -Buⁿ |
| (J10-7) | (N7) | (J10-33) | (N33) | (J10-59) | (N59) | (J10-85) | -Buⁱ |
| (J10-8) | (N8) | (J10-34) | (N34) | (J10-60) | (N60) | (J10-86) | -Bu^{s} |
| (J10-9) | (N9) | (J10-35) | (N35) | (J10-61) | (N61) | (J10-87) | -Bu^{t} |
| (J10-10) | (N10) | (J10-36) | (N36) | (J10-62) | (N62) | | |
| (J10-11) | (N11) | (J10-37) | (N37) | (J10-63) | (N63) | | |
| (J10-12) | (N12) | (J10-38) | (N38) | (J10-64) | (N64) | | |
| (J10-13) | (N13) | (J10-39) | (N39) | (J10-65) | (N65) | | |
| (J10-14) | (N14) | (J10-40) | (N40) | (J10-66) | (N66) | | |
| (J10-15) | (N15) | (J10-41) | (N41) | (J10-67) | (N67) | | |
| (J10-16) | (N16) | (J10-42) | (N42) | (J10-68) | (N68) | | |
| (J10-17) | (N17) | (J10-43) | (N43) | (J10-69) | (N69) | | |
| (J10-18) | (N18) | (J10-44) | (N44) | (J10-70) | (N70) | | |
| (J10-19) | (N19) | (J10-45) | (N45) | (J10-71) | (N71) | | |
| (J10-20) | (N20) | (J10-46) | (N46) | (J10-72) | (N72) | | |
| (J10-21) | (N21) | (J10-47) | (N47) | (J10-73) | (N73) | | |
| (J10-22) | (N22) | (J10-48) | (N48) | (J10-74) | (N74) | | |
| (J10-23) | (N23) | (J10-49) | (N49) | (J10-75) | (N75) | | |
| (J10-24) | (N24) | (J10-50) | (N50) | (J10-76) | (N76) | | |
| (J10-25) | (N25) | (J10-51) | (N51) | (J10-77) | (N77) | | |
| (J10-26) | (N26) | (J10-52) | (N52) | (J10-78) | (N78) | | |

**[Table 11]**

| | | | | | | | |
|---|---|---|---|---|---|---|---|
| 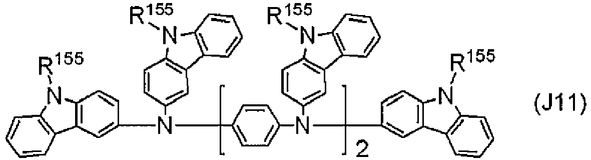 | | | | | | | |

| Compound | R¹⁵⁵ | Compound | R¹⁵⁵ | Compound | R¹⁵⁵ | Compound | R¹⁵⁵ |
|---|---|---|---|---|---|---|---|
| (J11-1) | (N1) | (J11-27) | (N27) | (J11-53) | (N53) | (J11-79) | -H |
| (J11-2) | (N2) | (J11-28) | (N28) | (J11-54) | (N54) | (J11-80) | -Me |
| (J11-3) | (N3) | (J11-29) | (N29) | (J11-55) | (N55) | (J11-81) | -Et |
| (J11-4) | (N4) | (J11-30) | (N30) | (J11-56) | (N56) | (J11-82) | -Prⁿ |
| (J11-5) | (N5) | (J11-31) | (N31) | (J11-57) | (N57) | (J11-83) | -Prⁱ |
| (J11-6) | (N6) | (J11-32) | (N32) | (J11-58) | (N58) | (J11-84) | -Buⁿ |
| (d11-7) | (N7) | (J11-33) | (N33) | (J11-59) | (N59) | (J11-85) | -Buⁱ |
| (J11-8) | (N8) | (J11-34) | (N34) | (J11-60) | (N60) | (J11-86) | -Bu^{s} |
| (J11-9) | (N9) | (J11-35) | (N35) | (J11-61) | (N61) | (J11-87) | -Bu^{t} |
| (J11-10) | (N10) | (J11-36) | (N36) | (J11-62) | (N62) | | |
| (J11-11) | (N11) | (J11-37) | (N37) | (J11-63) | (N63) | | |
| (J11-12) | (N12) | (J11-38) | (N38) | (J11-64) | (N64) | | |
| (J11-13) | (N13) | (J11-39) | (N39) | (J11-65) | (N65) | | |
| (J11-14) | (N14) | (J11-40) | (N40) | (J11-66) | (N66) | | |
| (J11-15) | (N15) | (J11-41) | (N41) | (J11-67) | (N67) | | |
| (J11-16) | (N16) | (J11-42) | (N42) | (J11-68) | (N68) | | |
| (J11-17) | (N17) | (J11-43) | (N43) | (J11-69) | (N69) | | |
| (J11-18) | (N18) | (J11-44) | (N44) | (J11-70) | (N70) | | |
| (J11-19) | (N19) | (J11-45) | (N45) | (J11-71) | (N71) | | |
| (J11-20) | (N20) | (J11-46) | (N46) | (J11-72) | (N72) | | |
| (J11-20 | (N21) | (J11-47) | (N47) | (J11-73) | (N73) | | |
| (J11-22) | (N22) | (J11-48) | (N48) | (J11-74) | (N74) | | |
| (J11-23) | (N23) | (J11-49) | (N49) | (J11-75) | (N75) | | |
| (J11-24) | (N24) | (J11-50) | (N50) | (J11-76) | (N76) | | |
| (J11-25) | (N25) | (J11-51) | (N51) | (J11-77) | (N77) | | |
| (J11-26) | (N26) | (J11-52) | (N52) | (J11-78) | (N78) | | |

**[Table 12]**

| | | | | | | | |
|---|---|---|---|---|---|---|---|
| 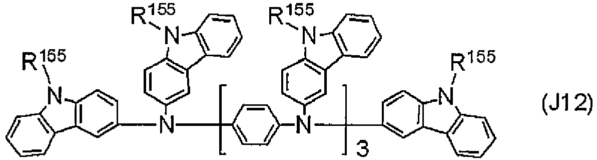 | | | | | | | |

| Compound | R¹⁵⁵ | Compound | R¹⁵⁵ | Compound | R¹⁵⁵ | Compound | R¹⁵⁵ |
|---|---|---|---|---|---|---|---|
| (J12-1) | (N1) | (J12-27) | (N27) | (J12-53) | (N53) | (J12-79) | -H |
| (J12-2) | (N2) | (J12-28) | (N28) | (J12-54) | (N54) | (J12-80) | -Me |
| (J12-3) | (N3) | (J12-29) | (N29) | (J12-55) | (N55) | (J12-81) | -Et |
| (J12-4) | (N4) | (J12-30) | (N30) | (J12-56) | (N56) | (J12-82) | -Prⁿ |
| (J12-5) | (N5) | (J12-31) | (N31) | (J12-57) | (N57) | (J12-83) | -Prⁱ |
| (J12-6) | (N6) | (J12-32) | (N32) | (J12-58) | (N58) | (J12-84) | -Buⁿ |
| (J12-7) | (N7) | (J12-33) | (N33) | (J12-59) | (N59) | (J12-85) | -Buⁱ |
| (J12-8) | (N8) | (J12-34) | (N34) | (J12-60) | (N60) | (J12-86) | -Bu^{s} |
| (J12-9) | (N9) | (J12-35) | (N35) | (J12-61) | (N61) | (J12-87) | -Bu^{t} |
| (J12-10) | (N10) | (J12-36) | (N36) | (J12-62) | (N62) | | |
| (J12-11) | (N11) | (J12-37) | (N37) | (J12-63) | (N63) | | |
| (J12-12) | (N12) | (J12-38) | (N38) | (J12-64) | (N64) | | |
| (J12-13) | (N13) | (J12-39) | (N39) | (J12-65) | (N65) | | |
| (J12-14) | (N14) | (J12-40) | (N40) | (J12-66) | (N66) | | |
| (J12-15) | (N15) | (J12-41) | (N41) | (J12-67) | (N67) | | |
| (J12-16) | (N16) | (J12-42) | (N42) | (J12-68) | (N68) | | |
| (J112-17) | (N17) | (J12-43) | (N43) | (J12-69) | (N69) | | |
| (J12-18) | (N18) | (J12-44) | (N44) | (J12-70) | (N70) | | |
| (J12-19) | (N19) | (J12-45) | (N45) | (J12-71) | (N71) | | |
| (J12-20) | (N20) | (J12-46) | (N46) | (J12-72) | (N72) | | |
| (J12-21) | (N21) | (J12-47) | (N47) | (J12-73) | (N73) | | |
| (J12-22) | (N22) | (J12-48) | (N48) | (J12-74) | (N74) | | |
| (J12-23) | (N23) | (J 12-49) | (N49) | (J12-75) | (N75) | | |
| (J12-24) | (N24) | (J12-50) | (N50) | (J12-76) | (N76) | | |
| (J12-25) | (N25) | (J12-51) | (N51) | (J12-77) | (N77) | | |
| (J12-26) | (N26) | (J12-52) | (N52) | (J12-78) | (N78) | | |

**[Table 13]**

| | | | | | | | |
|---|---|---|---|---|---|---|---|
| 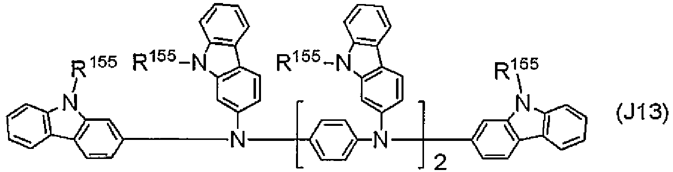 | | | | | | | |

| Compound | R¹⁵⁵ | Compound | R¹⁵⁵ | Compound | R¹⁵⁵ | Compound | R¹⁵⁵ |
|---|---|---|---|---|---|---|---|
| (J13-1) | (N1) | (J13-27) | (N27) | (J13-53) | (N53) | (J13-79) | -H |
| (J13-2) | (N2) | (J13-28) | (N28) | (J13-54) | (N54) | (J13-80) | -Me |
| (J13-3) | (N3) | (J13-29) | (N29) | (J13-55) | (N55) | (J13-81) | -Et |
| (J13-4) | (N4) | (J13-30) | (N30) | (J13-56) | (N56) | (J13-82) | -Prⁿ |
| (J13-5) | (N5) | (J13-31) | (N31) | (J13-57) | (N57) | (J13-83) | -Prⁱ |
| (J13-6) | (N6) | (J13-32) | (N32) | (J13-58) | (N58) | (J13-84) | -Buⁿ |
| (J13-7) | (N7) | (J13-33) | (N33) | (J13-59) | (N59) | (J13-85) | -Buⁱ |
| (J13-8) | (N8) | (J13-34) | (N34) | (J13-60) | (N60) | (J13-86) | -Bu^{s} |
| (J13-9) | (N9) | (J13-35) | (N35) | (J13-61) | (N61) | (J13-87) | -Bu^{t} |
| (J13-10) | (N10) | (J13-36) | (N36) | (J13-62) | (N62) | | |
| (J13-11) | (N11) | (J13-37) | (N37) | (J13-63) | (N63) | | |
| (J13-12) | (N12) | (J13-38) | (N38) | (J13-64) | (N64) | | |
| (J13-13) | (N13) | (J13-39) | (N39) | (J13-65) | (N65) | | |
| (J13-14) | (N14) | (J13-40) | (N40) | (J13-66) | (N66) | | |
| (J13-15) | (N15) | (J13-41) | (N41) | (J13-67) | (N67) | | |
| (J13-16) | (N16) | (J13-42) | (N42) | (J13-68) | (N68) | | |
| (J13-17) | (N17) | (J13-43) | (N43) | (J13-69) | (N69) | | |
| (J13-18) | (N18) | (J13-44) | (N44) | (J13-70) | (N70) | | |
| (J13-19) | (N19) | (J13-45) | (N45) | (J13-71) | (N71) | | |
| (J13-20) | (N20) | (J13-46) | (N46) | (J13-72) | (N72) | | |
| (J13-21) | (N21) | (J13-47) | (N47) | (J13-73) | (N73) | | |
| (J13-22) | (N22) | (J13-48) | (N48) | (J13-74) | (N74) | | |
| (J13-23) | (N23) | (J13-49) | (N49) | (J13-75) | (N75) | | |
| (J13-24) | (N24) | (J 13-50) | (N50) | (J13-76) | (N76) | | |
| (J13-25) | (N25) | (J13-51) | (N51) | (J13-77) | (N77) | | |
| (J13-26) | (N26) | (J13-52) | (N52) | (J13-78) | (N78) | | |

**[Table 14]**

| | | | | | | | |
|---|---|---|---|---|---|---|---|
| 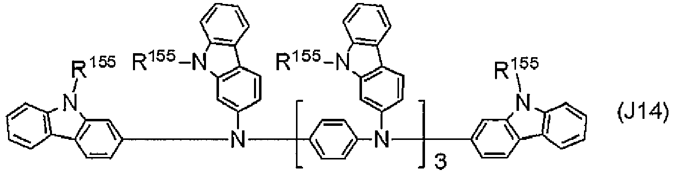 | | | | | | | |

| Compound | R¹⁵⁵ | Compound | R¹⁵⁵ | Compound | R¹⁵⁵ | Compound | R¹⁵⁵ |
|---|---|---|---|---|---|---|---|
| (J14-1) | (N1) | (J14-27) | (N27) | (J14-53) | (N53) | (J14-79) | -H |
| (J14-2) | (N2) | (J14-28) | (N28) | (J14-54) | (N54) | (J14-80) | -Me |
| (J14-3) | (N3) | (J14-29) | (N29) | (J14-55) | (N55) | (J14-81) | -Et |
| (J14-4) | (N4) | (J14-30) | (N30) | (J14-56) | (N56) | (J14-82) | -Prⁿ |
| (J14-5) | (N5) | (J14-31) | (N31) | (J14-57) | (N57) | (J14-83) | -Prⁱ |
| (J14-6) | (N6) | (J14-32) | (N32) | (J14-58) | (N58) | (J14-84) | -Buⁿ |
| (J14-7) | (N7) | (J14-33) | (N33) | (J14-59) | (N59) | (J14-85) | -Buⁱ |
| (J14-8) | (N8) | (J14-34) | (N34) | (J14-60) | (N60) | (J14-86) | -Bu^{s} |
| (J14-9) | (N9) | (J14-35) | (N35) | (J14-61) | (N61) | (J14-87) | -Bu^{t} |
| (J14-10) | (N10) | (J14-36) | (N36) | (J14-62) | (N62) | | |
| (J14-11) | (N11) | (J14-37) | (N37) | (J14-63) | (N63) | | |
| (J14-12) | (N12) | (J14-38) | (N38) | (J14-64) | (N64) | | |
| (J14-13) | (N13) | (J14-39) | (N39) | (J14-65) | (N65) | | |
| (J14-14) | (N14) | (J14-40) | (N40) | (J14-66) | (N66) | | |
| (J14-15) | (N15) | (J14-41) | (N41) | (J14-67) | (N67) | | |
| (J14-16) | (N16) | (J14-42) | (N42) | (J14-68) | (N68) | | |
| (J14-17) | (N17) | (J14-43) | (N43) | (J14-69) | (N69) | | |
| (J14-18) | (N18) | (J14-44) | (N44) | (J14-70) | (N70) | | |
| (J14-19) | (N19) | (J14-45) | (N45) | (J14-71) | (N71) | | |
| (J14-20) | (N20) | (J14-46) | (N46) | (J14-72) | (N72) | | |
| (J14-21) | (N21) | (J14-47) | (N47) | (J14-73) | (N73) | | |
| (J14-22) | (N22) | (J14-48) | (N48) | (J14-74) | (N74) | | |
| (J14-23) | (N23) | (J14-49) | (N49) | (J14-75) | (N75) | | |
| (J14-24) | (N24) | (J14-50) | (N50) | (J14-76) | (N76) | | |
| (J14-25) | (N25) | (J14-51) | (N51) | (J14-77) | (N77) | | |
| (J14-26) | (N26) | (J14-52) | (N52) | (J14-78) | (N78) | | |

**[Table 15]**

| | | | | | | | |
|---|---|---|---|---|---|---|---|
| 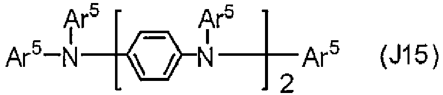 | | | | | | | |

| Compound | Ar⁵ | Compound | Ar⁵ | Compound | Ar⁵ | Compound | Ar⁵ |
|---|---|---|---|---|---|---|---|
| (J15-1) | (A1-1) | (J15-27) | (A6-11) | (J15-53) | (A12-7) | (J15-79) | (A13-22) |
| (J15-2) | (A1-2) | (J15-28) | (A6-12) | (J15-54) | (A12-8) | (J15-80) | (A13-23) |
| (J15-3) | (A2-1) | (J15-29) | (A6-13) | (J15-55) | (A12-9) | (J15-81) | (A13-24) |
| (J15-4) | (A2-2) | (J15-30) | (A6-14) | (J15-56) | (A12-10) | (J15-82) | (A14-1) |
| (J15-5) | (A2-3) | (J15-31) | (A6-15) | (J15-57) | (A12-11) | (J15-83) | (A14-2) |
| (J15-6) | (A2-4) | (J15-32) | (A7-1) | (J15-58) | (A13-1) | (J15-84) | (A14-3) |
| (J15-7) | (A2-5) | (J15-33) | (A7-2) | (J15-59) | (A13-2) | (115-85) | (A14-4) |
| (J15-8) | (A3-1) | (J15-34) | (A7-3) | (J15-60) | (A13-3) | (J15-86) | (A15-1) |
| (J15-9) | (A3-2) | (J15-35) | (A8-1) | (J15-61) | (A13-4) | (J15-87) | (A15-2) |
| (J15-10) | (A3-3) | (J15-36) | (A8-2) | (J15-62) | (A13-5) | (J15-88) | (A15-3) |
| (J15-11) | (A4-1) | (J15-37) | (A8-3) | (J15-63) | (A13-6) | (J15-89) | (A15-4) |
| (J15-12) | (A4-2) | (J15-38) | (A9-1) | (J15-64) | (A13-7) | (J15-90) | (A17-1) |
| (J15-13) | (A4-3) | (J15-39) | (A9-2) | (J15-65) | (A13-8) | (J15-91) | (A17-2) |
| (J15-14) | (A5-1) | (J15-40) | (A9-3) | (J15-66) | (A13-9) | (J15-92) | (A17-3) |
| (J15-15) | (A5-2) | (J15-41) | (A10-1) | (J15-67) | (A13-10) | (J15-93) | (A17-4) |
| (J15-16) | (A5-3) | (J15-42) | (A10-2) | (J15-68) | (A13-11) | (J15-94) | (A17-5) |
| (J15-17) | (A6-1) | (J15-43) | (A10-3) | (J15-69) | (A13-12) | (J15-95) | (A17-6) |
| (J15-18) | (A6-2) | (J15-44) | (A11-1) | (J15-70) | (A13-13) | (J15-96) | (A17-7) |
| (J15-19) | (A6-3) | (J15-45) | (A11-2) | (J15-71) | (A13-14) | (J15-97) | (A17-8) |
| (J15-20) | (A6-4) | (J15-46) | (A11-3) | (J15-72) | (A13-15) | (J15-98) | (A17-9) |
| (J15-21) | (A6-5) | (J15-47) | (A12-1) | (J15-73) | (A13-16) | (J15-99) | (A17-10) |
| (J15-22) | (A6-6) | (J15-48) | (A12-2) | (J15-74) | (A13-17) | (J15-100) | (A17-11) |
| (J15-23) | (A6-7) | (J15-49) | CA12-3) | (J15-75) | (A13-18) | (J15-101) | (A17-12) |
| (J15-24) | (A6-8) | (J15-50) | (A12-4) | (J15-76) | (A13-19) | (J15-102) | (A18-1) |
| (J15-25) | (A6-9) | (J15-51) | (A12-5) | (J15-77) | (A13-20) | (J15-103) | (A18-2) |
| (J15-26) | (A6-10) | (J15-52) | (A12-6) | (J15-78) | (A13-21) | | |

**[Table 16]**

| | | | | | | | |
|---|---|---|---|---|---|---|---|
| 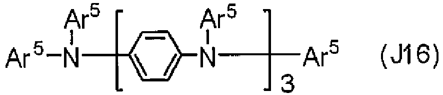 | | | | | | | |

| Compound | Ar⁵ | Compound | Ar⁵ | Compound | Ar⁵ | Compound | Ar⁵ |
|---|---|---|---|---|---|---|---|
| (J16-1) | (A1-1) | (J16-27) | (A6-11) | (J16-53) | (A12-7) | (J16-79) | (A13-22) |
| (J16-2) | (A1-2) | (J16-28) | (A6-12) | (J16-54) | (A12-8) | (J16-80) | (A13-23) |
| (J16-3) | (A2-1) | (J16-29) | (A6-13) | (J16-55) | (A12-9) | (J16-81) | (A13-24) |
| (J16-4) | (A2-2) | (J16-30) | (A6-14) | (J16-56) | (A12-10) | (J16-82) | (A14-1) |
| (J16-5) | (A2-3) | (J16-31) | (A6-15) | (J16-57) | (A12-11) | (J16-83) | (A14-2) |
| (J16-6) | (A2-4) | (J16-32) | (A7-1) | (J16-58) | (A13-1) | (J16-84) | (A14-3) |
| (J16-7) | (A2-5) | (J16-33) | (A7-2) | (J16-59) | (A13-2) | (J16-85) | (A14-4) |
| (J16-8) | (A3-1) | (J16-34) | (A7-3) | (J16-60) | (A13-3) | (J16-86) | (A15-1) |
| (J16-9) | (A3-2) | (J16-35) | (A8-1) | (J16-61) | (A13-4) | (J16-87) | (A15-2) |
| (J16-10) | (A3-3) | (J16-36) | (A8-2) | (J16-62) | (A13-5) | (J16-88) | (A15-3) |
| (J16-11) | (A4-1) | (J16-37) | (A8-3) | (J16-63) | (A13-6) | (J16-89) | (A15-4) |
| (J16-12) | (A4-2) | (J16-38) | (A9-1) | (J16-64) | (A13-7) | (J16-90) | (A17-1) |
| (J16-13) | (A4-3) | (J16-39) | (A9-2) | (J16-65) | (A13-8) | (J16-91) | (A17-2) |
| (J16-14) | (A5-1) | (J16-40) | (A9-3) | (J16-66) | (A13-9) | (J16-92) | (A17-3) |
| (J16-15) | (A5-2) | (J16-41) | (A10-1) | (J16-67) | (A13-10) | (J16-93) | (A17-4) |
| (J16-16) | (A5-3) | (J16-42) | (A10-2) | (J16-68) | (A13-11) | (J16-94) | (A17-5) |
| (J16-17) | (A6-1) | (J16-43) | (A10-3) | (J16-69) | (A13-12) | (J16-95) | (A17-6) |
| (J16-18) | (A6-2) | (J16-44) | (A11-1) | (J16-70) | (A13-13) | (J16-96) | (A17-7) |
| (J16-19) | (A6-3) | (J16-45) | (A11-2) | (J16-71) | (A13-14) | (J16-97) | (A17-8) |
| (J16-20) | (A6-4) | (J16-46) | (A11-3) | (J16-72) | (A13-15) | (J16-98) | (A17-9) |
| (J16-21) | (A6-5) | (J16-47) | (A12-1) | (J16-73) | (A13-16) | (J16-99) | (A17-10) |
| (J16-22) | (A6-6) | (J16-48) | (A12-2) | (J16-74) | (A13-17) | (J16-100) | (A17-11) |
| (J16-23) | (A6-7) | (J16-49) | (A12-3) | (J16-75) | (A13-18) | (J16-101) | (A17-12) |
| (J16-24) | (A6-8) | (J16-50) | (A12-4) | (J16-76) | (A13-19) | (J16-102) | (A18-1) |
| (J16-25) | (A6-9) | (J16-51) | (A12-5) | (J16-77) | (A13-20) | (J16-103) | (A18-2) |
| (J16-26) | (A6-10) | (J16-52) | (A12-6) | (J16-78) | (A13-21) | | |

**[Table 17]**

| | | | | | | | |
|---|---|---|---|---|---|---|---|
| 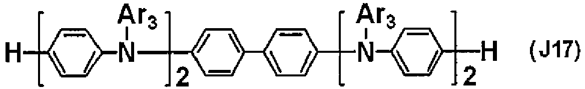 | | | | | | | |

| Compound | Ar³ | Compound | Ar³ | Compound | Ar³ | Compound | Ar³ |
|---|---|---|---|---|---|---|---|
| (J17-1) | (C1') | (J17-3) | (C3') | (J17-5) | (C5') | (J17-7) | (C7') |
| (J17-2) | (C2') | (J17-4) | (C4') | (J 17-6) | (C6') | (J17-8) | (C8') |

**[Table 18]**

| | | | | | | | |
|---|---|---|---|---|---|---|---|
| 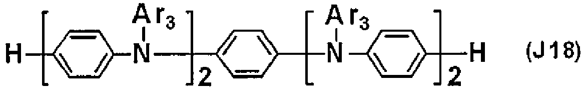 | | | | | | | |

| Compound | Ar³ | Compound | Ar³ | Compound | Ar³ | Compound | Ar³ |
|---|---|---|---|---|---|---|---|
| (J18-1) | (C1') | (J18-3) | (C3') | (J18-5) | (C5') | (J18-7) | (C7') |
| (J18-2) | (C2') | (J18-4) | (C4') | (J18-6) | (C6') | (J18-8) | (C8') |

Illustrative examples of aniline derivatives include those of formula (13) below.

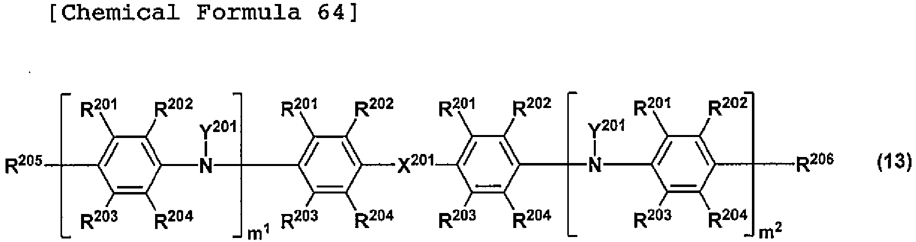

In formula (13), X²⁰¹ is -NY²⁰¹-, -O-, -S-, -(CR²⁰⁷R²⁰⁸)_{L}-or a single bond. However, when m¹ or m² is 0, X²⁰¹ is -NY²⁰¹-.

Each Y²⁰¹ is independently a hydrogen atom, an alkyl group of 1 to 20 carbon atoms, alkenyl group of 2 to 20 carbon atoms or alkynyl group of 2 to 20 carbon atoms which may be substituted with Z²⁰¹, or an aryl group of 6 to 20 carbon atoms or heteroaryl group of 2 to 20 carbon atoms which may be substituted with Z²⁰².

The alkyl groups of 1 to 20 carbon atoms, alkenyl groups of 2 to 20 carbon atoms, alkynyl groups of 2 to 20 carbon atoms and aryl groups of 6 to 20 carbon atoms are exemplified in the same way as above.

Illustrative examples of heteroaryl groups of 2 to 20 carbon atoms include 2-thienyl, 3-thienyl, 2-furanyl, 3-furanyl, 2-oxazolyl, 4-oxazolyl, 5-oxazolyl, 3-isooxazolyl, 4-isooxazolyl, 5-isooxazolyl, 2-thiazolyl, 4-thiazolyl, 5-thiazolyl, 3-isothiazolyl, 4-isothiazolyl, 5-isothiazolyl, 2-imidazolyl, 4-imidazolyl, 2-pyridyl, 3-pyridyl and 4-pyridyl.

R²⁰⁷ and R²⁰⁸ are each independently a hydrogen atom, a halogen atom, a nitro group, a cyano group, an amino group, an aldehyde group, a hydroxyl group, a thiol group, a sulfonic acid group, a carboxylic acid group, an alkyl group of 1 to 20 carbon atoms, alkenyl group of 2 to 20 carbon atoms or alkynyl group of 2 to 20 carbon atoms which may be substituted with Z¹, an aryl group of 6 to 20 carbon atoms or heteroaryl group of 2 to 20 carbon atoms which may be substituted with Z², or a -NHY²⁰², -NY²⁰³Y²⁰⁴, -C(O)Y²⁰⁵, -OY²⁰⁶, -SY²⁰⁷, -SO₃Y²⁰⁸, -C(O)OY²⁰⁹, -OC(O)Y²¹⁰, -C(O)NHY²¹¹ or -C(O)NY²¹²Y²¹³ group.

Y²⁰² to Y²¹³ are each independently an alkyl group of 1 to 20 carbon atoms, alkenyl group of 2 to 20 carbon atoms or alkynyl group of 2 to 20 carbon atoms which may be substituted with Z²⁰¹, or an aryl group of 6 to 20 carbon atoms or heteroaryl group of 2 to 20 carbon atoms which may be substituted with Z²⁰².

Z²⁰¹ is a halogen atom, a nitro group, a cyano group, an amino group, an aldehyde group, a hydroxyl group, a thiol group, a sulfonic acid group, a carboxylic acid group, or an aryl group of 6 to 20 carbon atoms or heteroaryl group of 2 to 20 carbon atoms which may be substituted with Z²⁰³.

Z²⁰² is a halogen atom, a nitro group, a cyano group, an amino group, an aldehyde group, a hydroxyl group, a thiol group, a sulfonic acid group, a carboxylic acid group, or an alkyl group of 1 to 20 carbon atoms, alkenyl group of 2 to 20 carbon atoms or alkynyl group of 2 to 20 carbon atoms which may be substituted with Z²⁰³.

Z²⁰³ is a halogen atom, a nitro group, a cyano group, an amino group, an aldehyde group, a hydroxyl group, a thiol group, a sulfonic acid group or a carboxylic acid group.

The halogen atom is exemplified by fluorine, chlorine, bromine and iodine atoms.

The alkyl groups, alkenyl groups, alkynyl groups, aryl groups and heteroaryl groups of R²⁰⁷ to R²⁰⁸ and Y²⁰² to Y²¹³ are exemplified in the same way as above.

Of these, R²⁰⁷ and R²⁰⁸ are preferably hydrogen atoms or alkyl groups of 1 to 20 carbon atoms which may be substituted with Z²⁰¹, more preferably hydrogen atoms or methyl groups which may be substituted with Z²⁰¹, and most preferably both hydrogen atoms.

L, which represents the number of divalent recurring units represented as - (CR²⁰⁷R²⁰⁸) -, is an integer from 1 to 20, preferably from 1 to 10, more preferably from 1 to 5, even more preferably 1 or 2, and most preferably 1. When L is 2 or more, the plurality of R²⁰⁷ groups may be mutually the same or different, and the plurality of R²⁰⁸ groups may be mutually the same or different.

In particular, X²⁰¹ is preferably -NY²⁰¹- or a single bond. Y²⁰¹ is preferably a hydrogen atom or an alkyl group of 1 to 20 carbon atoms which may be substituted with Z²⁰¹, more preferably a hydrogen atom or a methyl group which may be substituted with Z²⁰¹, and most preferably a hydrogen atom.

R²⁰¹ to R²⁰⁶ are each independently a hydrogen atom, a halogen atom, a nitro group, a cyano group, an amino group, an aldehyde group, a hydroxyl group, a thiol group, a sulfonic acid group, a carboxylic acid group, an alkyl group of 1 to 20 carbon atoms, alkenyl group of 2 to 20 carbon atoms or alkynyl group of 2 to 20 carbon atoms which may be substituted with Z²⁰¹, an aryl group of 6 to 20 carbon atoms or heteroaryl group of 2 to 20 carbon atoms which may be substituted with Z²⁰², or a -NHY²⁰², -NY²⁰³Y²⁰⁴, -C(O)Y²⁰⁵, -OY²⁰⁶, -SY²⁰⁷, -SO₃Y²⁰⁸, -C(O)OY²⁰⁹, -OC(O)Y²¹⁰, -C(O)NHY²¹¹ or -C(O)NY²¹²Y²¹³ group (wherein Y²⁰² to Y²¹³ are as defined above). These halogen atoms, alkyl groups, alkenyl groups, alkynyl groups, aryl groups and heteroaryl groups are as defined above.

In particular, in formula (13), R²⁰¹ to R²⁰⁴ are preferably hydrogen atoms, halogen atoms, alkyl groups of 1 to 10 carbon atoms which may be substituted with Z²⁰¹, or aryl groups of 6 to 14 carbon atoms which may be substituted with Z²⁰²; more preferably hydrogen atoms, fluorine atoms, or alkyl groups of 1 to 10 carbon atoms which may be substituted with fluorine atoms; and most preferably all hydrogen atoms.

R²⁰⁵ and R²⁰⁶ are preferably hydrogen atoms, halogen atoms, alkyl groups of 1 to 10 carbon atoms which may be substituted with Z²⁰¹, aryl groups of 6 to 14 carbon atoms which may be substituted with Z²⁰², or diphenylamino groups which may be substituted with Z²⁰² (-NY²⁰³Y²⁰⁴ groups wherein Y²⁰³ and Y²⁰⁴ are phenyl groups which may be substituted with Z²⁰²); more preferably hydrogen atoms, fluorine atoms, or diphenylamino groups which may be substituted with fluorine atoms; and even more preferably both hydrogen atoms or both diphenylamino groups.

Of these, combinations in which R²⁰¹ to R²⁰⁴ are hydrogen atoms, fluorine atoms or alkyl groups of 1 to 10 carbon atoms which may be substituted with fluorine atoms, R²⁰⁵ and R²⁰⁶ are hydrogen atoms, fluorine atoms or diphenylamino groups which may be substituted with fluorine atoms, X²⁰¹ is -NY²⁰¹- or a single bond, and Y²⁰¹ is a hydrogen atom or a methyl group are preferred. Combinations in which R²⁰¹ to R²⁰⁴ are hydrogen atoms, R²⁰⁵ and R²⁰⁶ are both hydrogen atoms or diphenylamino groups, and X²⁰¹ is -NH- or a single bond are more preferred.

In formula (13), m¹ and m² independently represent an integer of 0 or more and satisfy the condition 1 ≤ m¹+m² ≤ 20. Taking into account the balance between the charge transportability of the resulting thin-film and the solubility of the aniline derivative, m¹ and m² preferably satisfy the condition 2 ≤ m¹+m² ≤ 8, more preferably satisfy the condition 2 ≤ m¹+m² ≤ 6, and still more preferably satisfy the condition 2 ≤ m¹+m² ≤ 4.

In particular, in Y²⁰¹ to Y²¹³ and R²⁰¹ to R²⁰⁸, Z²⁰¹ is preferably a halogen atom or an aryl group of 6 to 20 carbon atoms which may be substituted with Z²⁰³, more preferably a halogen atom or a phenyl group which may be substituted with Z²⁰³, and most preferably does not exist (i.e., is non-substituting).

Z²⁰² is preferably a halogen atom or an alkyl group of 1 to 20 carbon atoms which may be substituted with Z²⁰³, more preferably a halogen atom or an alkyl group of 1 to 4 carbon atoms which may be substituted with Z²⁰³, and most preferably does not exist (i.e., is non-substituting).

Also, Z²⁰³ is preferably a halogen atom, more preferably fluorine, and most preferably does not exist (i.e., is non-substituting).

In Y²⁰¹ to Y¹²¹³ and R²⁰¹ to R²⁰⁸, the number of carbon atoms on the alkyl groups, alkenyl groups and alkynyl groups is preferably 10 or less, more preferably 6 or less, and even more preferably 4 or less. The number of carbons on the aryl groups and heteroaryl groups is preferably 14 or less, more preferably 10 or less, and even more preferably 6 or less.

The aniline derivative has a molecular weight which is generally from 300 to 5,000. However, from the standpoint of increasing its solubility, the molecular weight is preferably not more than 4,000, more preferably not more than 3,000, and even more preferably not more than 2,000.

Examples of methods for synthesizing the aniline derivative include, but are not particularly limited to, the methods described in Bulletin of Chemical Society of Japan, 67, pp. 1749-1752 (1994); Synthetic Metals, 84, pp. 119-120 (1997); Thin Solid Films, 520 (24), pp. 7157-7163 (2012), WO 2008/032617, WO 2008/032616 and WO 2008/129947.

Examples of aniline derivatives of formula (13) include, but are not limited to, those shown below. In these formula, DPA is as defined above, Ph stands for a phenyl group, and TPA stands for a p-(diphenylamino)phenyl group.

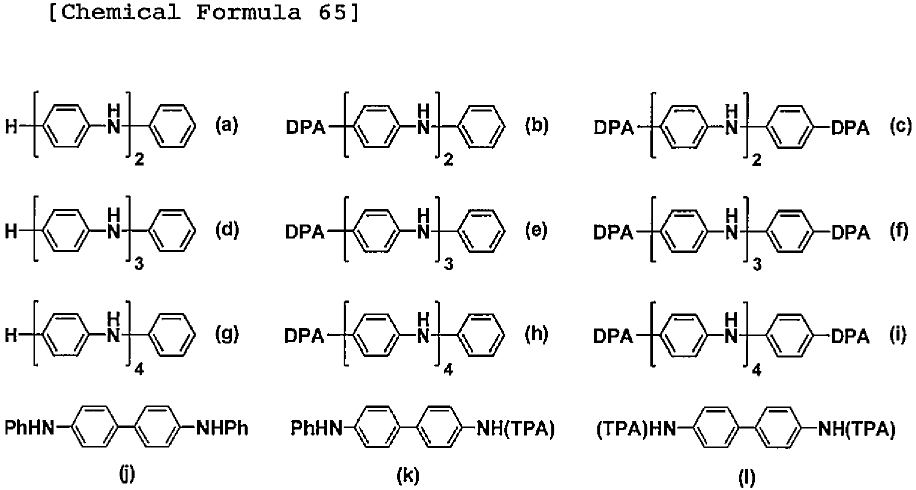

Thiophene derivatives that are suitable as the charge-transporting substance include, but are not limited to, those of formula (14) below.

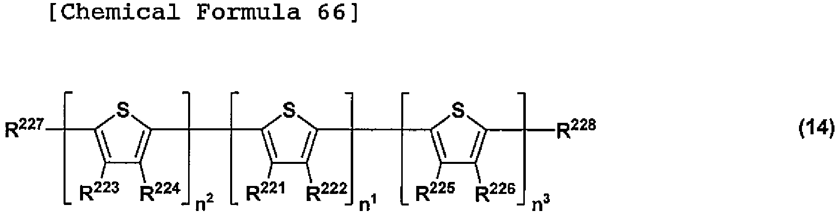

In the formula, R²²¹ to R²²⁶ are each independently a hydrogen atom, an alkyl group of 1 to 20 carbon atoms, alkenyl group of 2 to 20 carbon atoms or alkynyl group of 2 to 20 carbon atoms which may be substituted with Z²⁰⁴, an aryl group of 6 to 20 carbon atoms or heteroaryl group of 2 to 20 carbon atoms which may be substituted with Z²⁰⁵, or -OY²²¹, -SY²²² , -NHY²²³ , -NY²²⁴Y²²⁵ or -NHC(O)Y²²⁶. In cases where R²²¹ to R²²⁶ are not hydrogen atoms, R²²¹ and R²²², R²²³ and R²²⁴ and/or R²²⁵ and R²²⁶ may mutually bond to form divalent groups.

R²²⁷ and R²²⁸ are each independently a hydrogen atom, an alkyl group of 1 to 20 carbon atoms, alkenyl group of 2 to 20 carbon atoms or alkynyl group of 2 to 20 carbon atoms which may be substituted with Z²⁰⁴, an aryl group of 6 to 20 carbon atoms or heteroaryl group of 2 to 20 carbon atoms which may be substituted with Z²⁰⁶, or -OY²²¹, -SY²²², -NHY²²³, -NY²²⁴Y²²⁵ or -NHC(O)Y²²⁶.

Y²²¹ to Y²²⁶ are each independently an alkyl group of 1 to 20 carbon atoms, alkenyl group of 2 to 20 carbon atoms or alkynyl group of 2 to 20 carbon atoms which may be substituted with Z²⁰⁴, or an aryl group of 6 to 20 carbon atoms or heteroaryl group of 2 to 20 carbon atoms which may be substituted with Z²⁰⁵.

Z²⁰⁴ is an aryl group of 6 to 20 carbon atoms or a heteroaryl group of 2 to 20 carbon atoms. Z²⁰⁵ is an alkyl group of 1 to 20 carbon atoms, an alkenyl group of 2 to 20 carbon atoms, or an alkynyl group of 2 to 20 carbon atoms. Z²⁰⁶ is an alkyl group of 1 to 20 carbon atoms, an alkenyl group of 2 to 20 carbon atoms, an alkynyl group of 2 to 20 carbon atoms, a dialkylamino group wherein each alkyl is an alkyl group of 1 to 20 carbon atoms, or a diarylamino group wherein each aryl is an aryl group of 6 to 20 carbon atoms.

Here, the alkyl, alkenyl, alkynyl, aryl and heteroaryl groups are exemplified in the same way as described above.

In formula (14), R²²¹ and R²²² are each preferably a hydrogen atom, an alkyl group of 1 to 20 carbon atoms or alkoxy group of 1 to 20 carbon atoms which may be substituted with Z²⁰⁴(i.e., an -OY²²¹ group wherein R²²¹ is an alkyl group of 1 to 20 carbon atoms that may be substituted with Z²⁰⁴); more preferably a hydrogen atom, or an alkyl group of 1 to 10 carbon atoms or alkoxy group of 1 to 10 carbon atoms which may be substituted with Z²⁰⁴; even more preferably a hydrogen atom, or an alkyl group of 1 to 8 carbon atoms or alkoxy group of 1 to 8 carbon atoms which may be substituted with Z²⁰⁴; and most preferably a hydrogen atom.

Accordingly, suitable thiophene derivatives are exemplified by compounds of formula (15) below 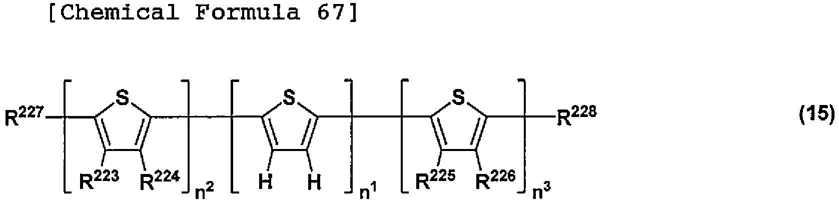 (wherein R²²³ to R²²⁸ are as defined above).

R²²³ to R²²⁶ are each preferably a hydrogen atom, an alkyl group of 1 to 20 carbon atoms or alkoxy group of 1 to 20 carbons which may be substituted with Z²⁰⁴ (i.e., an -OY²²¹ group wherein R²²¹ is an alkyl group of 1 to 20 carbon atoms that may be substituted with Z²⁰⁴); more preferably a hydrogen atom, or an alkyl group of 1 to 10 carbon atoms or alkoxy group of 1 to 10 carbon atoms which may be substituted with Z²⁰⁴; and even more preferably a hydrogen atom, or an alkyl group of 1 to 8 carbon atoms or alkoxy group of 1 to 8 carbon atoms which may be substituted with Z²⁰⁴. It is even more preferable for at least one of R²²³ and R²²⁴ to be an alkyl group of 1 to 18 carbon atoms or alkoxy group of 1 to 8 carbon atoms which may be substituted with Z²⁰⁴.

R²²⁷ and R²²⁸ are each preferably a hydrogen atom, -NY²²⁴Y²²⁵, or an aryl group of 6 to 20 carbon atoms which may be substituted with a dialkylamino group wherein each alkyl group is an alkyl group of 1 to 20 carbon atoms or a diarylamino group wherein each aryl group is an aryl group of 6 to 20 carbon atoms. Here, Y²²⁴ and Y²²⁵ are each preferably an alkyl group of 1 to 20 carbon atoms which may be substituted with Z²⁰⁴or an aryl group of 6 to 20 carbon atoms which may be substituted with Z²⁰⁵; and more preferably an alkyl group of 1 to 10 carbon atoms which may be substituted with Z²⁰⁴or an aryl group of 6 to 10 carbon atoms which may be substituted with Z²⁰⁵.

Of these, R²²⁷ and R²²⁸ are, in particular, each preferably a hydrogen atom, a diarylamino group in which each aryl group is an aryl group of 6 to 10 carbon atoms which may be substituted with Z²⁰⁶, or a phenyl group substituted with a diarylamino group in which each aryl group is an aryl group of 6 to 20 carbon atoms; and most preferably a hydrogen atom or a 4-diphenylaminophenyl group.

In R²²¹ to R²²⁸ and Y²²¹ to Y²²⁶, Z²⁰⁴is preferably an aryl group of 6 to 20 carbon atoms, more preferably a phenyl group, and most preferably does not exist (i.e., is non-substituting).

Z²⁰⁵ is preferably an alkyl group of 1 to 20 carbon atoms, more preferably an alkyl group of 1 to 10 carbon atoms, even more preferably an alkyl group of 1 to 8 carbon atoms, still more preferably an alkyl group of 1 to 6 carbon atoms, and most preferably does not exist (i.e., is non-substituting).

Z²⁰⁶ is preferably an alkyl group of 1 to 20 carbon atoms, a dialkylamino group in which each alkyl group is an alkyl group of 1 to 20 carbon atoms, or a diarylamino group in which each aryl group is an aryl group of 6 to 20 carbon atoms; more preferably an alkyl group of 1 to 10 carbon atoms, a dialkylamino group in which each alkyl group is an alkyl group of 1 to 10 carbon atoms, or a diarylamino group in which each aryl group is an aryl group of 6 to 10 carbon atoms; even more preferably an alkyl group of 1 to 8 carbon atoms, a dialkylamino group in which each alkyl group is an alkyl group of 1 to 8 carbon atoms, or a diphenylamino group; and most preferably does not exist (i.e., is non-substituting) or is a diphenylamino group.

In formulas (14) and (15), the subscripts n¹ to n³ independently represent a positive integer and satisfy the condition 4 ≤ n¹+n²+n³ ≤ 20. Here, n¹ is preferably from 1 to 15, more preferably from 1 to 10, even more preferably from 2 to 5, and still more preferably 2 or 3. Also, n² and n³ are preferably from 1 to 15, more preferably from 1 to 10, even more preferably from 1 to 5, and still more preferably from 1 to 3. From the standpoint of increasing the solubility of the oligothiophene derivative in the organic solvent, n¹ to n³ preferably satisfy the condition n¹+n²+n³ ≤ 8, more preferably satisfy the condition n¹+n²+n³ ≤ 7, even more preferably satisfy the condition n¹+n²+n³ ≤ 6, and still more preferably satisfy the condition n¹+n²+n³ ≤ 5.

Illustrative examples of the thiophene derivative of formula (14) include, but are not limited to, the following. 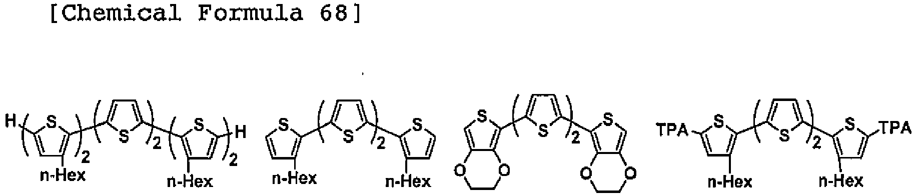 Here, n-Hex stands for an n-hexyl group, and TPA is as defined above.

Such thiophene derivatives may be synthesized by a known method (e.g., the methods described in JP-A H02-250881 and Chem. Eur. J., 2005, 11, pp. 3742-3752), or a commercial product may be used.

More specifically, these thiophene derivatives may be synthesized by the reaction shown in Scheme 1 or 2 below. Alternatively, oligothiophene derivatives having, in particular, alkyl groups, alkenyl groups, alkynyl groups, aryl groups or heteroaryl groups at both ends (formula (14')) may be synthesized by the reaction shown in Scheme 3 below. 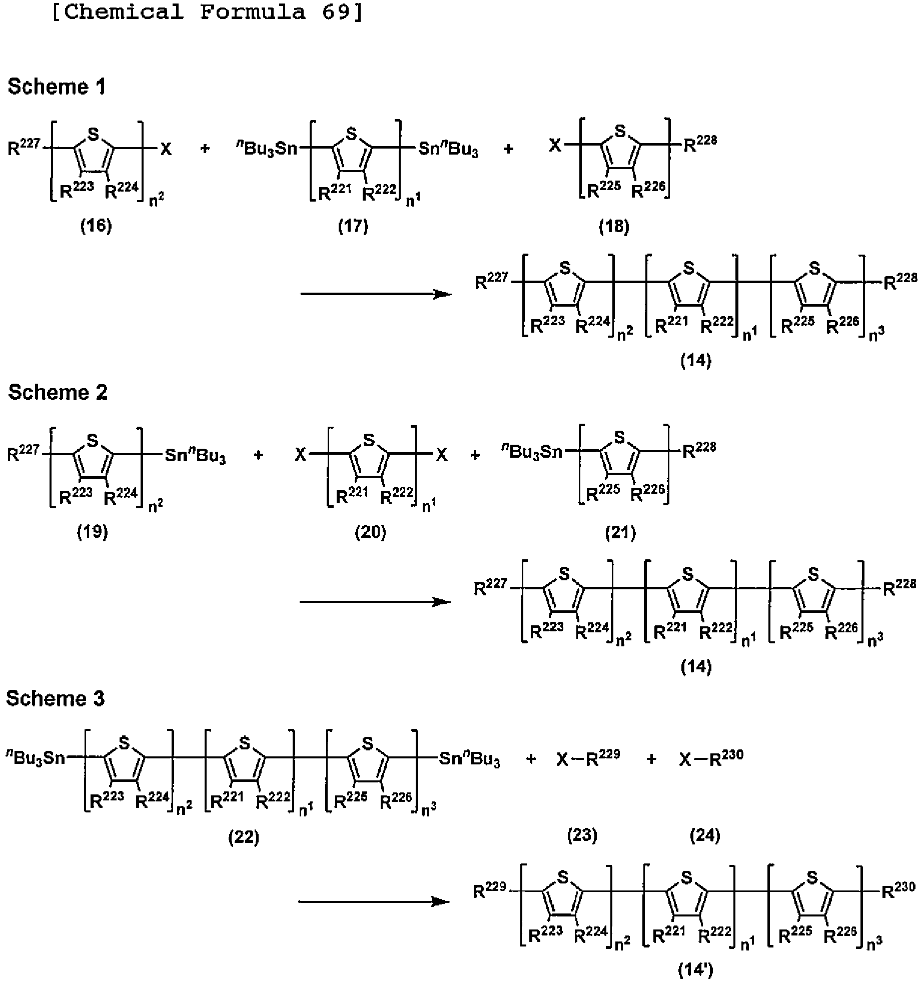 In these formulas, X, R²²¹ to R²²⁸ and n¹ to n³ are as defined above, and ⁿBu stands for an n-butyl group.

R²²⁹ and R²³⁰ are each independently an alkyl group of 1 to 20 carbon atoms, alkenyl group of 2 to 20 carbon atoms or alkynyl group of 2 to 20 carbon atoms which may be substituted with Z²⁰⁴, or an aryl group of 6 to 20 carbon atoms or heteroaryl group of 2 to 20 carbon atoms which may be substituted with Z²⁰⁶. These are exemplified in the same way as above. Also, Z²⁰⁴ and Z²⁰⁶ are the same as above.

In Scheme 1, the charging ratios of the thiophene derivatives of formulas (16) to (18) are generally such that the amount of thiophene derivative of formula (16) and the amount of thiophene derivative of formula (18) are each about 0.5 to 1.5 equivalents, and preferably about 0.9 to 1.3 equivalents, with respect to the thiophene derivative of formula (17).

In Scheme 2, the charging ratios of the thiophene derivatives of formulas (19) to (21) are generally such that the amount of thiophene derivative of formula (19) and the amount of thiophene derivative of formula (21) are each about 0.5 to 1.5 equivalents, and preferably about 0.9 to 1.3 equivalents, with respect to the thiophene derivative of formula (20).

In Scheme 3, the charging ratios of the thiophene derivative of formula (22) and the compounds of formulas (23) and (24) are generally such that the amount of compound of formula (23) and the amount of compound of formula (24) are each about 0.5 to 1.5 equivalents, and preferably about 0.9 to 1.3 equivalents, with respect to the thiophene derivative of formula (22).

The catalysts used in these reactions are exemplified in the same way as those described in connection with the method for preparing aniline derivatives of formula (1). These catalysts may be used singly or two or more may be used in combination. These catalysts may be used together with suitable known ligands. Such ligands are exemplified in the same way as those described in connection with the method for preparing aniline derivatives of formula (1).

The amount of catalyst used may be set to generally about 0.01 to 0.2 mole per mole of the compound of formula (17), (20) or (22), with about 0.05 mole being preferred. When ligands are used, the amount thereof may be set to from 0.1 to 5 equivalents, and preferably from 1 to 4 equivalents, with respect to the metal catalyst used.

The above reactions may be carried out in a solvent. When a solvent is used, the type thereof is not particularly limited, provided it does not have an adverse effect on the reaction. Specific examples include the same as those mentioned in connection with the method of preparing aniline derivatives of formula (1). The solvent may be used singly, or two or more may be used in admixture.

The reaction temperature may be suitably set in the range of the melting point to the boiling point of the solvent used, with a temperature of about 0°C to 200°C being preferred, and a temperature of 20°C to 150°C being more preferred.

Following reaction completion, the oligothiophene derivative of formula (14) or (14') can be obtained by work-up in the usual manner.

The compounds of formulas (17), (19), (21) and (22) used in the above reactions can each be obtained by using, in accordance with a common technique, a suitable base such as n-butyllithium and a suitable tin compound such as tributyl(chloro)stannane to introduce tributyltin groups onto both ends of thiophene compounds having structures corresponding to the respective compounds. In addition, compounds of formula (22) can be obtained by introducing tributyltin groups onto both ends of an oligothiophene derivative obtained in accordance with Scheme 1 or 2.

As for the compounds of formulas (16), (18), (20), (23) and (24), use may be made of commercial products, or such compounds may be obtained by, in accordance with a common technique, halogenating or pseudo-halogenating thiophenes, alkanes, alkenes, alkynes, arenes or heteroarenes (exclusive of thiophenes) having structures corresponding to the respective compounds.

The content of charge-transporting substance in the varnish of the invention is suitably set while taking into account such factors as the viscosity and surface tension of the varnish, and the thickness of the thin-film to be formed. Generally, the content is about 0.1 to 20 wt% of the overall varnish. To improve the ease of applying the varnish, the content is preferably about 0.1 to 10.0 wt%, more preferably about 0.5 to 5.0 wt%, and even more preferably about 1.0 to 3.0 wt%.

### [Dopant]

The charge-transporting varnish of the invention may include a dopant. The dopant is not particularly limited. Preferred examples include heteropolyacids and arylsulfonic acids.

Examples of heteropolyacids include phosphomolybdic acid, silicomolybdic acid, phosphotungstic acid and silicotungstic acid, with phosphotungstic acid or phosphomolybdic acid being preferred. The heteropolyacid may be used singly, or two or more may be used in combination.

Arylsulfonic acid compounds that may be suitably used as dopants in this invention include those of formula (25) or (26) below.

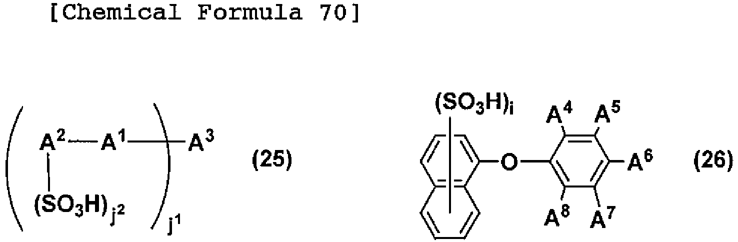

In formula (25), A¹ represents -O- or -S-, and is preferably -O-. A² represents a naphthalene ring or an anthracene ring, and is preferably a naphthalene ring. A³ represents a divalent to tetravalent perfluorobiphenyl group and the subscript j¹ represents the number of bonds between A¹ and A³, which is an integer that satisfies the condition 2 ≤ j¹ ≤ 4, with A³ preferably being a divalent perfluorobiphenyl group and j¹ preferably being 2. The subscript j² represents the number of sulfonic acid groups that are bonded to A², this being an integer that satisfies the condition 1 ≤ j² ≤ 4, and preferably 2.

In formula (26), A⁴ to A⁸ are each independently a hydrogen atom, a halogen atom, a cyano group, an alkyl group of 1 to 20 carbon atoms, a halogenated alkyl group of 1 to 20 carbon atoms, or a halogenated alkenyl group of 2 to 20 carbon atoms; of A⁴ to A⁸, at least three are halogen atoms. The subscript i represents the number of sulfonic acid groups bonded to the naphthalene ring, this being an integer that satisfies the condition 1 ≤ i ≤ 4, preferably from 2 to 4, and more preferably 2.

Illustrative examples of the halogenated alkyl group of 1 to 20 carbon atoms include trifluoromethyl, 2,2,2-trifluoroethyl, 1,1,2,2,2-pentafluoroethyl, 3,3,3-trifluoropropyl, 2,2,3,3,3-pentafluoropropyl, 1,1,2,2,3,3,3-heptafluoropropyl, 4,4,4-trifluorobutyl, 3,3,4,4,4-pentafluorobutyl, 2,2,3,3,4,4,4-heptafluorobutyl and 1,1,2,2,3,3,4,4,4-nonafluorobutyl groups.
Illustrative examples of halogenated alkenyl groups of 2 to 20 carbon atoms include perfluorovinyl, 1-perfluoropropenyl, perfluoroallyl and perfluorobutenyl groups.

The halogen atoms and alkyl groups of 1 to 20 carbon atoms are exemplified in the same way as above, although the halogen atom is preferably a fluorine atom.

Of these, A⁴ to A⁸ are each preferably a hydrogen atom, a halogen atom, a cyano group, an alkyl group of 1 to 10 carbon atoms, a halogenated alkyl group of 1 to 10 carbon atoms, or a halogenated alkenyl group of 2 to 10 carbon atoms, with at least three of A⁴ to A⁸ being fluorine atoms; more preferably a hydrogen atom, a fluorine atom, a cyano group, an alkyl group of 1 to 5 carbon atoms, a fluorinated alkyl group of 1 to 5 carbon atoms, or a fluorinated alkenyl group of 2 to 5 carbon atoms, with at least three of A⁴ to A⁸ being fluorine atoms; and even more preferably a hydrogen atom, a fluorine atom, a cyano group, a perfluoroalkyl group of 1 to 5 carbon atoms or a perfluoroalkenyl group of 1 to 5 carbon atoms, with A⁴, A⁵ and A⁸ being fluorine atoms.

As used herein, "perfluoroalkyl group" refers to an alkyl group on which all the hydrogen atoms are substituted with fluorine atoms, and "perfluoroalkenyl group" refers to an alkenyl group on which all the hydrogen atoms are substituted with fluorine atoms.

Illustrative examples of the above-described arylsulfonic acid compounds include, but are not limited to, the following.

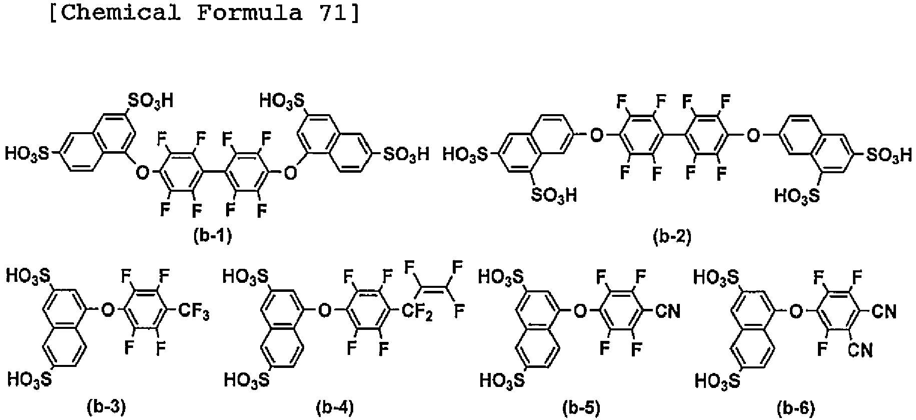

The amount of dopant included in the varnish of the invention is suitably selected while taking into account, for example, the type and amount of charge-transporting substance. Expressed as a weight ratio relative to unity (1) for the charge-transporting substance, the amount of dopant included is generally about 0.5 to about 10.

### [Charge-Transporting Thin-Film]

A charge-transporting thin-film can be formed on a substrate by applying the charge-transporting varnish of the invention onto the substrate and baking.

Examples of methods for applying the varnish include, but are not particularly limited to, dipping, spin coating, transfer printing, roll coating, brush coating, ink-jet printing, spraying and slit coating. It is preferable to adjust the viscosity and surface tension of the varnish in accordance with the method of application.

When using the varnish of the invention, the bake atmosphere is not particularly limited. A thin-film having a uniform film-forming surface can be obtained not only in an open-air atmosphere, but even in an inert gas such as nitrogen or in a vacuum. However, in most charge-transporting substances, an open-air atmosphere is preferred because a thin-film having high charge transportability can be reproducibly obtained.

The bake temperature is suitably set within the range of generally 100 to 260°C, based on such considerations as the intended use of the thin-film to be obtained, and the degree of charge-transportability to be conferred to the resulting thin-film. However, when the resulting thin-film is used as a hole injection layer in an organic EL device, the bake temperature is preferably from about 140°C to about 250°C, and more preferably from about 145°C to about 240°C. During the bake, in order to manifest an even more uniform film formability or to promote the reaction on the substrate, a temperature change of two or more steps may be imparted. Heating should be carried out using a suitable apparatus such as a hot plate or an oven.

The thickness of the charge-transporting thin-film is not particularly limited. However, when the thin-film is to be used as a hole injection layer in an organic EL device, a film thickness of 5 to 200 nm is preferred. Methods for varying the film thickness include, for example, changing the solids concentration in the varnish and changing the amount of solution on the substrate during application.

### [Organic EL Device]

The organic EL device of the invention has a pair of electrodes and, between these electrodes, the above-described charge-transporting thin-film of the invention.

Typical organic EL device configurations include, but are not limited to, those of (a) to (f) below. In these configurations, where necessary, an electron-blocking layer or the like may be provided between the emissive layer and the anode, and a hole-blocking layer or the like may be provided between the emissive layer and the cathode. Alternatively, the hole injection layer, hole-transporting layer or hole injecting and transporting layer may also have the function of, for example, an electron-blocking layer; and the electron injection layer, electron-transporting layer or electron injecting and transporting layer may also have the function of, for example, a hole-blocking layer.
(a) anode/hole injection layer/hole-transporting layer/emissive layer/electron-transporting layer/electron injection layer/cathode
(b) anode/hole injection layer/hole-transporting layer/emissive layer/electron injecting and transporting layer/cathode
(c) anode/hole injecting and transporting layer/emissive layer/electron-transporting layer/electron injection layer/cathode
(d) anode/hole injecting and transporting layer/emissive layer/electron injecting and transporting layer/cathode
(e) anode/hole injection layer/hole-transporting layer/emissive layer/cathode
(f) anode/hole injecting and transporting layer/emissive layer/cathode

As used herein, "hole injection layer," "hole-transporting layer" and "hole injecting and transporting layer" refer to layers which are formed between the emissive layer and the anode, and which have the function of transporting holes from the anode to the emissive layer. When only one layer of hole-transporting material is provided between the emissive layer and the anode, this is a "hole injecting and transporting layer"; when two or more layers of hole-transporting material are provided between the emissive layer and the anode, the layer that is closer to the anode is a "hole injection layer" and the other layer is a "hole-transporting layer." In particular, thin-films having not only an ability to receive holes from the anode but also an excellent ability to inject holes into, respectively, the hole-transporting layer and the emissive layer may be used as the hole injection layer and the hole injecting and transporting layer.

In addition, "electron injection layer," "electron-transporting layer" and "electron injecting and transporting layer" refer to layers which are formed between the emissive layer and the cathode, and which have the function of transporting electrons from the cathode to the emissive layer. When only one layer of electron-transporting material is provided between the emissive layer and the cathode, this is an "electron injecting and transporting layer"; when two or more layers of electron-transporting material are provided between the emissive layer and the cathode, the layer that is closer to the cathode is an "electron injection layer" and the other layer is an "electron-transporting layer."

The "emissive layer" is an organic layer having a light-emitting function. When a doping system is used, this layer includes a host material and a dopant material. The function of the host material is primarily to promote the recombination of electrons and holes, and to confine the resulting excitons within the emissive layer. The function of the dopant material is to cause the excitons obtained by recombination to efficiently luminesce. In the case of a phosphorescent device, the host material functions primarily to confine within the emissive layer the excitons generated by the dopant.

The charge-transporting thin-film of the invention can preferably be used as a hole injection layer, a hole-transporting layer or a hole transporting and injecting layer, and can more preferably can be used as a hole injection layer, in an organic EL device.

The materials and method employed to fabricate an organic EL device using the charge-transporting varnish of the invention are exemplified by, but not limited to, those described below.

The electrode substrate to be used is preferably cleaned beforehand by liquid washing with, for example, a cleaning agent, alcohol or pure water. When the substrate is an anode substrate, it is preferably subjected to surface treatment such as UV/ozone treatment or oxygen-plasma treatment just prior to use. However, surface treatment need not be carried out if the anode material is composed primarily of organic substances.

An example of a method of fabricating an inventive organic EL device in which a thin-film obtained from the charge-transporting varnish of the invention serves as a hole injection layer is described below.

In the method described above, a hole injection layer is formed on an electrode by applying the charge-transporting varnish of the invention onto an anode substrate and baking. A hole-transporting layer, emissive layer, electron-transporting layer, electron injection layer and cathode are then provided in this order on the hole injection layer. The hole-transporting layer, emissive layer, electron-transporting layer and electron injection layer may be formed by a vapor deposition process or a coating process (wet process), depending on the properties of the material to be used.

Illustrative examples of anode materials include transparent electrodes such as indium-tin oxide (ITO) and indium-zinc oxide (IZO), and metal anodes made of a metal such as aluminum or an alloy of such a metal. An anode material on which planarizing treatment has been carried out is preferred. Use can also be made of polythiophene derivatives and polyaniline derivatives having high charge transportability.

Examples of other metals making up the metal anode include, but are not limited to, scandium, titanium, vanadium, chromium, manganese, iron, cobalt, nickel, copper, zinc, gallium, yttrium, zirconium, niobium, molybdenum, ruthenium, rhodium, palladium, cadmium, indium, scandium, lanthanum, cerium, praseodymium, neodymium, promethium, samarium, europium, gadolinium, terbium, dysprosium, holmium, erbium, thulium, ytterbium, hafnium, thallium, tungsten, rhenium, osmium, iridium, platinum, gold, titanium, lead, bismuth, and alloys thereof.

Specific examples of hole-transporting layer-forming materials include the following hole-transporting low-molecular-weight materials: triarylamines such as (triphenylamine) dimer derivatives, [(triphenylamine) dimer] spirodimer,
N,N'-bis(naphthalen-1-yl)-N,N'-bis(phenyl)benzidine (α-NPD),
N,N'-bis(naphthalen-2-yl)-N,N'-bis(phenyl)benzidine,
N,N'-bis(3-methylphenyl)-N,N'-bis(phenyl)benzidine,
N,N'-bis(3-methylphenyl)-N,N'-bis(phenyl)-9,9-spirobifluorene,
N,N'-bis(naphthalen-1-yl)-N,N'-bis(phenyl)-9,9-spirobifluorene,
N,N'-bis(3-methylphenyl)-N,N'-bis(phenyl)-9,9-dimethylfluorene,
N,N'-bis(naphthalen-1-yl)-N,N'-bis(phenyl)-9,9-dimethylfluorene,
N,N'-bis(3-methylphenyl)-N,N'-bis(phenyl)-9,9-diphenylfluorene,
N,N'-bis(naphthalen-1-yl)-N,N'-bis(phenyl)-9,9-diphenylfluorene,
N,N'-bis(naphthalen-1-yl)-N,N'-bis(phenyl)-2,2'-dimethylbenzidine,
2,2',7,7'-tetrakis(N,N-diphenylamino)-9,9-spirobifluorene,
9,9-bis[4-(N,N-bisbiphenyl-4-ylamino)phenyl]-9H-fluorene,
9,9-bis[4-(N,N-bisnaphthalen-2-ylamino)phenyl]-9H-fluorene,
9,9-bis[4-(N-naphthalen-1-yl-N-phenylamino)phenyl]-9H-fluorene,
2,2',7,7'-tetrakis[N-naphthalenyl(phenyl)amino]-9,9-spirobifluorene,
N,N'-bis(phenanthren-9-yl)-N,N'-bis(phenyl)benzidine,
2,2'-bis[N,N-bis(biphenyl-4-yl)amino]-9,9-spirobifluorene,
2,2'-bis(N,N-diphenylamino)-9,9-spirobifluorene,
di[4-(N,N-di(p-tolyl)amino)phenyl]cyclohexane,
2,2',7,7'-tetra(N,N-di(p-tolyl))amino-9,9-spirobifluorene,
N,N,N',N'-tetranaphthalen-2-ylbenzidine,
N,N,N',N'-tetra(3-methylphenyl)-3,3'-dimethylbenzidine,
N,N'-di(naphthalenyl)-N,N'-di(naphthalen-2-yl)benzidine,
N,N,N',N'-tetra(naphthalenyl)benzidine,
N,N'-di(naphthalen-2-yl)-N,N'-diphenylbenzidine-1-4-diamine,
N¹,N⁴-diphenyl-N¹,N⁴-di(m-tolyl)benzene-1,4-diamine,
N²,N²,N⁶,N⁶-tetraphenylnaphthalene-2,6-diamine,
tris(4-(quinolin-8-yl)phenyl)amine,
2,2'-bis(3-(N,N-di(p-tolyl)amino)phenyl)biphenyl,
4,4',4"-tris[3-methylphenyl(phenyl)amino]triphenylamine (m-MTDATA) and
4,4',4"-tris[1-naphthyl(phenyl)amino]triphenylamine (1-TNATA);
and oligothiophenes such as 5,5"-bis-{4-[bis(4-methylphenyl)-amino]phenyl}-2,2':5',2"-terthiophene (BMA-3T).

Specific examples of emissive layer-forming materials include tris(8-quinolinolate) aluminum(III) (Alq₃),
bis(8-quinolinolate) zinc(II) (Znq₂),
bis(2-methyl-8-quinolinolate)-4-(p-phenylphenolate) aluminum(III) (BAlq),
4,4'-bis(2,2-diphenylvinyl)biphenyl,
9,10-di(naphthalen-2-yl)anthracene,
2-t-butyl-9,10-di(naphthalen-2-yl)anthracene,
2,7-bis[9,9-di(4-methylphenyl)fluoren-2-yl]-9,9-di(4-methylphenyl)fluorene,
2-methyl-9,10-bis(naphthalen-2-yl)anthracene,
2-(9,9-spirobifluoren-2-yl)-9,9-spirobifluorene,
2,7-bis(9,9-spirobifluoren-2-yl)-9,9-spirobifluorene,
2-[9,9-di(4-methylphenyl)fluoren-2-yl]-9,9-di(4-methylphenyl)fluorene,
2,2'-dipyrenyl-9,9-spirobifluorene,
1,3,5-tris(pyren-1-yl)benzene,
9,9-bis[4-(pyrenyl)phenyl]-9H-fluorene,
2,2'-bi(9,10-diphenylanthracene),
2,7-dipyrenyl-9,9-spirobifluorene, 1,4-di(pyren-1-yl)benzene,
1,3-di(pyren-1-yl)benzene, 6,13-di(biphenyl-4-yl)pentacene,
3,9-di(naphthalen-2-yl)perylene,
3,10-di(naphthalen-2-yl)perylene,
tris[4-(pyrenyl)phenyl]amine,
10,10'-di(biphenyl-4-yl)-9,9'-bianthracene,
N,N'-di(naphthalen-1-yl)-N,N'-diphenyl[1,1':4',1":4",1"'-quaterphenyl]-4,4"'-diamine,
4,4'-di[10-(naphthalen-1-yl)anthracen-9-yl]biphenyl,
dibenzo{[f,f']-4,4',7,7'-tetraphenyl}diindeno[1,2,3-cd:1',2',3'-lm]perylene,
1-(7-(9,9'-bianthracen-10-yl)-9,9-dimethyl-9H-fluoren-2-yl)pyrene,
1-(7-(9,9'-bianthracen-10-yl)-9,9-dihexyl-9H-fluoren-2-yl)pyrene,
1,3-bis(carbazol-9-yl)benzene,
1,3,5-tris(carbazol-9-yl)benzene,
4,4',4"-tris(carbazol-9-yl)triphenylamine,
4,4'-bis(carbazol-9-yl)biphenyl (CBP),
4,4'-bis(carbazol-9-yl)-2,2'-dimethylbiphenyl,
2,7-bis(carbazol-9-yl)-9,9-dimethylfluorene,
2,2',7,7'-tetrakis(carbazol-9-yl)-9,9-spirobifluorene,
2,7-bis(carbazol-9-yl)-9,9-di(p-tolyl)fluorene,
9,9-bis[4-(carbazol-9-yl)phenyl]fluorene,
2,7-bis(carbazol-9-yl)-9,9-spirobifluorene,
1,4-bis(triphenylsilyl)benzene,
1,3-bis(triphenylsilyl)benzene,
bis(4-N,N-diethylamino-2-methylphenyl)-4-methylphenylmethane,
2,7-bis(carbazol-9-yl)-9,9-dioctylfluorene,
4,4"-di(triphenylsilyl)-p-terphenyl,

4,4'-di(triphenylsilyl)biphenyl,
9-(4-t-butylphenyl)-3,6-bis(triphenylsilyl)-9H-carbazole,
9-(4-t-butylphenyl)-3,6-ditrityl-9H-carbazole,
9-(4-t-butylphenyl)-3,6-bis(9-(4-methoxyphenyl)-9H-fluoren-9-yl)-9H-carbazole,
2,6-bis(3-(9H-carbazol-9-yl)phenyl)pyridine,
triphenyl(4-(9-phenyl-9H-fluoren-9-yl)phenyl)silane,
9,9-dimethyl-N,N-diphenyl-7-(4-(1-phenyl-1H-benzo[d]imidazol-2-yl)phenyl-9H-fluoren-2-amine,
3,5-bis(3-(9H-carbazol-9-yl)phenyl)pyridine,
9,9-spirobifluoren-2-yldiphenylphosphine oxide,
9,9'-(5-triphenylsilyl)-1,3-phenylene)bis(9H-carbazole),
3-(2,7-bis(diphenylphosphoryl)-9-phenyl-9H-fluoren-9-yl)-9-phenyl-9H-carbazole,
4,4,8,8,12,12-hexa(p-tolyl)-4H-8H-12H-12C-azadibenzo[cd,mn]-pyrene,
4,7-di(9H-carbazol-9-yl)-1,10-phenanthroline,
2,2'-bis(4-(carbazol-9-yl)phenyl)biphenyl,
2,8-bis(diphenylphosphoryl)dibenzo[b,d]thiophene,
bis(2-methylphenyl)diphenylsilane,
bis[3,5-di(9H-carbazol-9-yl)phenyl]diphenylsilane,
3,6-bis(carbazol-9-yl)-9-(2-ethylhexyl)-9H-carbazole,
3-(diphenylphosphoryl)-9-(4-(diphenylphosphoryl)phenyl)-9H-carbazole and
3,6-bis[(3,5-diphenyl)phenyl]-9-phenylcarbazole.
An emissive layer may be formed by co-vapor deposition of any of these materials with a light-emitting dopant.

Specific examples of light-emitting dopants include
3-(2-benzothiazolyl)-7-(diethylamino)coumarin,
2,3,6,7-tetrahydro-1,1,7,7-tetramethyl-1H,5H,11H-10-(2-benzothiazolyl)quinolidino[9,9a,1gh]coumarin,
quinacridone, N,N'-dimethylquinacridone,
tris(2-phenylpyridine) iridium(III) (Ir(ppy)₃),
bis(2-phenylpyridine)(acetylacetonate) iridium(III) (Ir(ppy)₂(acac)),
tris[2-(p-tolyl]pyridine) iridium(III) (Ir(mppy)₃),
9,10-bis[N,N-di(p-tolyl)amino]anthracene,
9,10-bis[phenyl(m-tolyl)amino]anthracene,
bis[2-(2-hydroxyphenyl)benzothiazolate] zinc(II),
N¹⁰,N¹⁰,N¹⁰,N¹⁰-tetra(p-tolyl)-9,9'-bianthracene-10,10'-diamine,
N¹⁰,N¹⁰,N¹⁰,N¹⁰-tetraphenyl-9,9'-bianthracene-10,10'-diamine,
N¹⁰,N¹⁰-diphenyl-N¹⁰,N¹⁰-dinaphthalenyl-9,9'-bianthracene-10,10'-diamine,
4,4'-bis(9-ethyl-3-carbazovinylene)-1,1'-biphenyl,
perylene, 2,5,8,11-tetra-t-butylperylene,
1,4-bis[2-(3-N-ethylcarbazolyl)vinyl]benzene,
4,4'-bis[4-(di-p-tolylamino)styryl]biphenyl,
4-(di-p-tolylamino)-4'-[(di-p-tolylamino)styryl]stilbene,
bis[3,5-difluoro-2-(2-pyridyl)phenyl-(2-carboxypyridyl)] iridium(III),
4,4'-bis[4-(diphenylamino)styryl]biphenyl,
bis(2,4-difluorophenylpyridinato)tetrakis(1-pyrazolyl)borate iridium(III),
N,N'-bis(naphthalen-2-yl)-N,N'-bis(phenyl)tris(9,9-dimethylfluorenylene),
2,7-bis(2-[phenyl(m-tolyl)amino]-9,9-dimethylfluoren-7-yl}-9,9-dimethylfluorene,
N-(4-((E)-2-(6((E)-4-(diphenylamino)styryl)naphthalen-2-yl)vinyl)phenyl)-N-phenylbenzenamine,
fac-iridium(III) tris(1-phenyl-3-methylbenzimidazolin-2-ylidene-C,C²),
mer-iridium(III) tris(1-phenyl-3-methylbenzimidazolin-2-ylidene-C,C²),
2,7-bis[4-(diphenylamino)styryl]-9,9-spirobifluorene,
6-methyl-2-(4-(9-(4-(6-methylbenzo[d]thiazol-2-yl)phenyl)anthracen-10-yl)phenyl)benzo[d]thiazole,
1,4-di[4-(N,N-diphenyl)amino]styrylbenzene,
1,4-bis(4-(9H-carbazol-9-yl)styryl)benzene,
(E)-6-(4-(diphenylamino)styryl)-N,N-diphenylnaphthalen-2-amine,
bis(2,4-difluorophenylpyridinato) (5-(pyridin-2-yl)-1H-tetrazolate) iridium(III),
bis(3-trifluoromethyl-5-(2-pyridyl)pyrazole)((2,4-difluoro-benzyl)diphenylphosphinate) iridium(III),
bis(3-trifluoromethyl-5-(2-pyridyl)pyrazolate) (benzyl-diphenylphosphinate) iridium(III),
bis(1-(2,4-difluorobenzyl)-3-methylbenzimidazolium) (3-(trifluoromethyl)-5-(2-pyridyl)-1,2,4-triazolate) iridium(III),
bis(3-trifluoromethyl-5-(2-pyridyl)pyrazolate)(4',6'-difluorophenylpyridinate) iridium(III),
bis(4',6'-difluorophenylpyridinato)(3,5-bis(trifluoromethyl)-2-(2'-pyridyl)pyrrolate)iridium(III),
bis(4',6'-difluorophenylpyridinato)(3-(trifluoromethyl)-5-(2-pyridyl)-1,2,4-triazolate) iridium (III),
(Z)-6-mesityl-N-(6-mesitylquinolin-2(1H)-ylidene)quinoline-2-amine-BF₂,
(E)-2-(2-(4-(dimethylamino)styryl)-6-methyl-4H-pyran-4-ylidene)malononitrile,
4-(dicyanomethylene)-2-methyl-6-julolidyl-9-enyl-4-H-pyran,
4-(dicyanomethylene)-2-methyl-6-(1,1,7,7-tetramethyl-julolidyl-9-enyl)-4H-pyran,
4-(dicyanomethylene)-2-t-butyl-6-(1,1,7,7-tetramethyl-julolidin-4-ylvinyl)-4H-pyran,
tris(dibenzoylmethane)phenanthroline europium(III),
5,6,11,12-tetraphenylnaphthacene,
bis(2-benzo[b]thiophen-2-yl-pyridine)(acetylacetonate) iridium(III),
tris(1-phenylisoquinoline) iridium(III),
bis(1-phenylisoquinoline)(acetylacetonate) iridium(III),
bis[1-(9,9-dimethyl-9H-fluoren-2-yl)isoquinoline](acetylacetonate) iridium(III),
bis[2-(9,9-dimethyl-9H-fluoren-2-yl)quinoline](acetylacetonate) iridium(III),
tris[4,4'-di-t-butyl-(2,2')-bipyridine]
ruthenium(III) · bis(hexafluorophosphate),
tris(2-phenylquinoline) iridium(III),
bis(2-phenylquinoline)(acetylacetonate) iridium(III),
2,8-di-t-butyl-5,11-bis(4-t-butylphenyl)-6,12-diphenyltetracene,
bis(2-phenylbenzothiazolate)(acetylacetonate) iridium(III),
platinum 5,10,15,20-tetraphenyltetrabenzoporphyrin,
osmium(II) bis(3-trifluoromethyl-5-(2-pyridine)pyrazolate)-dimethylphenylphosphine,
osmium(II) bis(3-trifluoromethyl)-5-(4-t-butylpyridyl)-1,2,4-triazolate)diphenylmethylphosphine,
osmium(II) bis(3-(trifluoromethyl)-5-(2-pyridyl)-1,2,4-triazole)dimethylphenylphosphine,
osmium(II) bis(3-(trifluoromethyl)-5-(4-t-butylpyridyl)-1,2,4-triazolate)dimethylphenylphosphine,
bis[2-(4-n-hexylphenyl)quinoline](acetylacetonate) iridium(III),
tris[2-(4-n-hexylphenyl)quinoline] iridium(III),
tris[2-phenyl-4-methylquinoline] iridium(III),
bis(2-phenylquinoline) (2-(3-methylphenyl)pyridinate) iridium(III),
bis(2-(9,9-diethylfluoren-2-yl)-1-phenyl-1H-benzo[d]-imidazolato)(acetylacetonate) iridium(III),
bis(2-phenylpyridine)(3-(pyridin-2-yl)-2H-chromen-9-onate) iridium(III),
bis(2-phenylquinoline)(2,2,6,6-tetramethylheptane-3,5-dionate)iridium(III),
bis(phenylisoquinoline)(2,2,6,6-tetramethylheptane-3,5-dionate) iridium(III),
iridium(III) bis(4-phenylthieno[3,2-c]pyridinato-N,C²)acetylacetonate,
(E)-2-(2-t-butyl-6-(2-(2,6,6-trimethyl-2,4,5,6-tetrahydro-1H-pyrrolo[3,2,1-ij]quinolin-8-yl)vinyl)-4H-pyran-4-ylidene)-malononitrile,
bis(3-trifluoromethyl-5-(1-isoquinolyl)pyrazolate) (methyldiphenylphosphine) ruthenium,
bis[(4-n-hexylphenyl)isoquinoline] (acetylacetonate) iridium(III),
platinum(II) octaethylporphin,
bis(2-methyldibenzo[f,h]quinoxaline)(acetylacetonate) iridium(III) and
tris[(4-n-hexylphenyl)isoquinoline] iridium(III).

Specific examples of electron transport layer-forming materials include lithium 8-hydroxyquinolinate,
2,2',2"-(1,3,5-benzinetriyl)-tris(1-phenyl-1-H-benzimidazole),
2-(4-biphenyl)-5-(4-t-butylphenyl)-1,3,4-oxadiazole,
2,9-dimethyl-4,7-diphenyl-1,l0-phenanthroline,
4,7-diphenyl-1,10-phenanthroline,
bis(2-methyl-8-quinolinolate)-4-(phenylphenolato)aluminum,
1,3-bis[2-(2,2'-bipyridin-6-yl)-1,3,4-oxadiazo-5-yl]benzene,
6,6'-bis[5-(biphenyl-4-yl)-1,3,4-oxadiazo-2-yl]-2,2'-bipyridine,
3-(4-biphenyl)-4-phenyl-5-t-butylphenyl-1,2,4-triazole,
4-(naphthalen-1-yl)-3,5-diphenyl-4H-1,2,4-triazole,
2,9-bis(naphthalen-2-yl)-4,7-diphenyl-1,10-phenanthroline,
2,7-bis[2-(2,2'-bipyridin-6-yl)-1,3,4-oxadiazo-5-yl]-9,9-dimethylfluorene,
1,3-bis[2-(4-t-butylphenyl)-1,3,4-oxadiazo-5-yl]benzene,
tris(2,4,6-trimethyl-3-(pyridin-3-yl)phenyl)borane,
1-methyl-2-(4-(naphthalen-2-yl)phenyl)-1H-imidazo[4,5f]-[1,10]phenanthroline,
2-(naphthalen-2-yl)-4,7-diphenyl-1,10-phenanthroline, phenyldipyrenylphosphine oxide,
3,3',5,5'-tetra[(m-pyridyl)phen-3-yl]biphenyl,
1,3,5-tris[(3-pyridyl)phen-3-yl]benzene,
4,4'-bis(4,6-diphenyl-1,3,5-triazin-2-yl)biphenyl,
1,3-bis[3,5-di(pyridin-3-yl)phenyl]benzene,
bis(10-hydroxybenzo[h]quinolinato)beryllium,
diphenylbis(4-(pyridin-3-yl)phenyl)silane and
3,5-di(pyren-1-yl)pyridine.

Examples of electron injection layer-forming materials include lithium oxide (Li₂O), magnesium oxide (MgO), alumina (Al₂O₃), lithium fluoride (LiF), sodium fluoride (NaF), magnesium fluoride (MgF₂), cesium fluoride (CsF), strontium fluoride (SrF₂), molybdenum trioxide (MoO₃), aluminum, lithium acetylacetonate Li(acac), lithium acetate and lithium benzoate.

Examples of cathode materials include aluminum, magnesium-silver alloys, aluminum-lithium alloys, lithium, sodium, potassium and cesium.

In cases where the thin-film obtained from the charge-transporting varnish of the invention is a hole injection layer, another example of a method of fabricating the organic EL device of the invention is as follows.

An organic EL device having a charge-transporting thin-film formed using the charge-transporting varnish of the invention can be produced by, in the fabrication of an EL device as described above, successively forming a hole-transporting and an emissive layer instead of carrying out vacuum evaporation operations for a hole-transporting layer, an emissive layer, an electron-transporting layer and an electron injection layer. Specifically, the charge-transporting varnish of the invention is applied onto an anode substrate, and a hole injection layer is formed by the above-described method. A hole-transporting layer and an emissive layer are then successively formed thereon, following which a cathode material is vapor-deposited on top, thereby giving an organic EL device.

The cathode and anode materials used here may be similar to those described above, and similar cleaning treatment and surface treatment may be carried out.

The method of forming the hole-transporting layer and the emissive layer is exemplified by a film-forming method that entails adding a solvent to a hole-transporting polymer material or a light-emitting polymer material, or to a material obtained by adding a dopant to these, thereby dissolving or uniformly dispersing the material, and then applying the resulting solution or dispersion onto, respectively, the hole injection layer or the hole-transporting layer and subsequently baking the applied layer.

Examples of hole-transporting polymer materials include poly[(9,9-dihexylfluorenyl-2,7-diyl)-co-(N,N'-bis{p-butylphenyl}-1,4-diaminophenylene)], poly[(9,9-dioctylfluorenyl-2,7-diyl)-co-(N,N'-bis{p-butylphenyl}-1,1'-biphenylene-4,4-diamine)], poly[(9,9-bis{1'-penten-5'-yl)fluorenyl-2,7-diyl)-co-(N,N'-bis{p-butylphenyl)-1,4-diaminophenylene)], poly[N,N'-bis(4-butylphenyl)-N,N'-bis(phenyl)benzidine] end-capped with polysilsesquioxane and poly[(9,9-dioctylfluorenyl-2,7-diyl)-co-(4,4'-(N-(p-butylphenyl))diphenylamine)].

Examples of light-emitting polymer materials include polyfluorene derivatives such as poly(9,9-dialkylfluorene) (PDAF), poly(phenylene vinylene) derivatives such as poly(2-methoxy-5-(2'-ethylhexoxy)-1,4-phenylene vinylene) (MEH-PPV), polythiophene derivatives such as poly(3-alkylthiophene) (PAT), and polyvinylcarbazole (PVCz).

Examples of the solvent include toluene, xylene and chloroform. Examples of the method of dissolution or uniform dispersion include stirring, stirring under applied heat, and ultrasonic dispersion.

Examples of the coating method include, but are not particularly limited to, inkjet printing, spraying, dipping, spin coating, transfer printing, roll coating and brush coating. Coating is preferably carried out in an inert gas atmosphere such as nitrogen or argon.

Examples of the baking method include methods that involve heating in an oven or on a hot plate, either within an inert gas atmosphere or in a vacuum.

An example is described below of a method of fabricating the organic EL device of the invention in a case where the thin-film obtained from the charge-transporting varnish of the invention is a hole-transporting layer.

A hole injection layer is formed on an anode substrate. The charge-transporting varnish of the invention is applied onto this layer and baked by the above-described method, thereby producing a hole-transporting layer. An emissive layer, an electron-transporting layer, an electron injection layer and a cathode are provided in this order on the hole-transporting layer. Methods of forming the emissive layer, electron-transporting layer and electron injection layer, and specific examples of each, are exemplified in the same way as above. The hole injection layer may be formed by any vapor deposition process and coating process (wet process), according to the properties, etc. of the material used.

Illustrative examples of the material that forms the hole injection layer include copper phthalocyanine, titanium oxide phthalocyanine, platinum phthalocyanine, pyrazino[2,3-f][1,10]phenanthroline-2,3-dicarbonitrile, N,N,N',N'-tetrakis(4-methoxyphenyl)benzidine, 2,7-bis[N,N-bis(4-methoxyphenyl)amino]-9,9-spirobifluorene, 2,2'-bis[N,N-bis(4-methoxyphenyl)amino]-9,9-spirobifluorene, N,N'-diphenyl-N,N'-di[4-(N,N-ditolylamino)phenyl]benzidine, N,N'-diphenyl-N,N'-di[4-(N,N-diphenylamino)phenyl]benzidine, N⁴,N^{4'}-(biphenyl-4,4'-diyl)bis(N⁴,N^{4'},N^{4'}-triphenylbiphenyl-4,4'-diamine), N¹,N^{1'}-(biphenyl-4,4'-diyl)bis(N¹-phenyl-N⁴,N^{4'}-di-m-tolylbenzene-1,4-diamine), and
the charge-transporting materials mentioned in WO 2004/043117, WO 2004/105446, WO 2005/000832, WO 2005/043962, WO 2005/042621, WO 2005/107335, WO 2006/006459, WO 2006/025342, WO 2006/137473, WO 2007/049631, WO 2007/099808, WO 2008/010474, WO 2008/032617, WO 2008/032616, WO 2008/129947, WO 2009/096352, WO 2010/041701, WO 2010/058777, WO 2010/058776, WO 2013/042623, WO 2013/129249, WO 2014/115865, WO 2014/132917, WO 2014/141998, and WO 2014/132834.

The anode material, the materials which form the emissive layer, the light-emitting dopant, the electron-transporting layer and the electron-blocking layer, and the cathode material are exemplified in the same way as above.

An example is described below of a method of fabricating the organic EL device of the invention in a case where the thin-film obtained from the charge-transporting varnish of the invention is a hole injecting and transporting layer.

A hole injecting and transporting layer is formed on an anode substrate, and an emissive layer, an electron-transporting layer, an electron injection layer and a cathode are provided in this order on the hole injecting and transporting layer. Methods of forming the emissive layer, electron-transporting layer and electron injection layer, and specific examples of each, are exemplified in the same way as above.

The anode material, the materials which form the emissive layer, the light-emitting dopant, the electron-transporting layer and the electron-blocking layer, and the cathode material are exemplified in the same way as above.

A hole-blocking layer, an electron-blocking layer or the like may be optionally provided between the electrodes and any of the above layers. By way of illustration, an example of a material that forms an electron-blocking layer is tris(phenylpyrazole)iridium.

The materials which make up the layers that form the anode, the cathode and the layers formed therebetween differ according to whether a device provided with a bottom emission structure or a top emission structure is to be fabricated, and so are suitably selected while taking this into account.

Generally, in an element having a bottom emission structure, a transparent anode is used on the substrate side and light is extracted from the substrate side, whereas in an element having a top emission structure, a reflective anode made of metal is used and light is extracted from a transparent electrode (cathode) in the opposite direction from the substrate. Hence, with regard to the anode material, for example, when fabricating a device having a bottom emission structure, a transparent anode of ITO or the like is used, and when manufacturing a device having a top emission structure, a reflective anode of Al/Nd or the like is used.

The organic EL device of the invention, in order to prevent a deterioration in characteristics, may be sealed in the usual manner with, if necessary, a desiccant or the like.

### EXAMPLES

Working Examples are given below to more concretely illustrate the invention, although the invention is not limited by these Examples. The equipment used was as follows.
(1) ¹H-NMR Measurement:
   JNM-ECP300 FT NMR System, from JEOL Ltd.
(2) MALDI-TOF-MS:
   Autoflex III SmartBeam, from Bruker Daltonics
(3) Substrate Cleaning:
   Substrate cleaning machine (reduced-pressure plasma system), from Choshu Industry Co., Ltd.
(4) Varnish Coating:
   MS-A100 Spin Coater, from Mikasa Co., Ltd.
(5) Film Thickness Measurement:
   Surfcorder ET-4000 microfigure measuring instrument, from Kosaka Laboratory, Ltd.
(6) Film Surface Examination:
   1LM21D Real Time Scanning Laser Microscope,
   from Lasertec Corporation
(7) EL Device Fabrication:
   C-E2L1G1-N Multifunction Vapor Deposition System, from Choshu Industry Co., Ltd.
(8) Examination of Light-Emitting Surface of EL Device, and Brightness Measurement:
   I-V-L Measurement System from Tech World, Inc.

### [1] Synthesis of Compounds

### [Production Example 1] Synthesis of Aniline Derivative A

### [1-1]

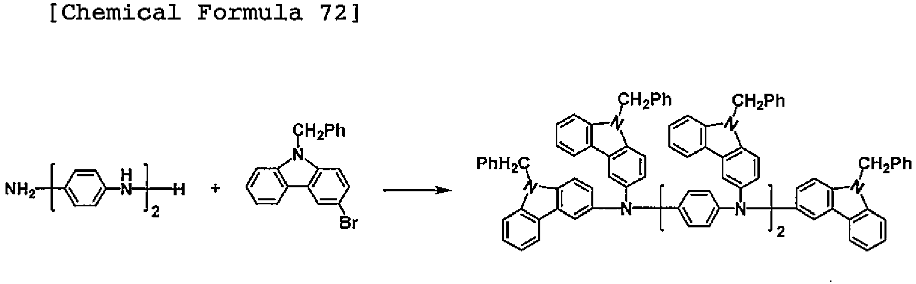

A flask was charged with 5.00 g of N1-(4-aminophenyl)-benzene-1,4-diamine, 8.09 g of 9-benzyl-3-bromo-9H-carbazole, 252 mg of Pd(dba)₂ and 3.03 g of t-butoxysodium, following which the interior of the flask was flushed with nitrogen. Next, 50 mL of toluene and 2.02 mL of a toluene solution of di-t-butyl(phenyl)phosphine (concentration, 96.4 g/L) prepared beforehand were added, and the system was stirred at 90°C for 3 hours.

After the completion of stirring, the reaction mixture was cooled to room temperature, the cooled reaction mixture, 200 mL of toluene and 150 mL of saturated saline were mixed together, and separatory treatment was carried out. Next, 0.5 g of activated carbon was added to the resulting organic phase, which was then stirred at room temperature for 1 hour.

The activated carbon was then removed by filtration, and the filtrate was concentrated. The concentrate was added dropwise to a mixed solvent of methanol and ethyl acetate (200 mL/200 mL), and the resulting slurry was stirred at room temperature for 1 hour, following which the slurry was filtered and the filtered matter was recovered. The resulting filtered matter was dried, thereby giving the target N1,N1,N4-tris(9-benzyl-9H-carbazol-3-yl)-N4-(4-(bis(9-benzyl-9H-carbazol-3-yl)amino)phenyl)benzene-1,4-diamine (amount, 8.46 g; yield, 80%). The ¹H-NMR results were as follows.
¹H-NMR (300 MHz, THF-d8) δ [ppm]:
7.91-8.00 (m, 10H), 7.52-7.58 (m, 10H), 7.34-7.39 (m, 6H), 7.17-7.26 (m, 29H), 7.03-7.11 (m, 5H), 6.83 (d, J = 9.0 Hz, 4H), 6.76 (d, J = 9.0 Hz, 4H), 5.58 (s, 10H).

### [1-2]

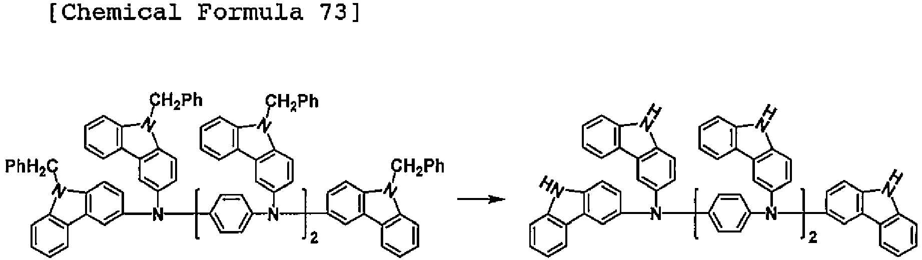

A flask was charged with 5.05 g of t-butoxypotassium, 18 mL of dimethylsulfoxide and 6 mL of tetrahydrofuran, following which the interior of the flask was flushed with oxygen. Next, a solution prepared by mixing together 3.00 g of the N1,N1,N4-tris(9-benzyl-9H-carbazol-3-yl)-N4-(4-(bis(9-benzyl-9H-carbazol-3-yl)amino)phenyl)benzene-1,4-diamine obtained above and 9 mL of tetrahydrofuran was added dropwise thereto at 10°C, the temperature of the resulting mixture was raised to room temperature, and the mixture was stirred for 4 hours.

After the completion of stirring, the reaction mixture was added dropwise to 120 mL of deionized water, and 9 mL of 5 mol/L hydrochloric acid was added dropwise thereto, following which the resulting slurry was stirred at room temperature for 1 hour. The slurry was then filtered, and the filtered matter was recovered. The filtered matter thus obtained was mixed thoroughly with 90 mL of tetrahydrofuran, the mixture was filtered with silica gel, and the resulting filtrate was concentrated. The concentrate was added dropwise to 150 mL of methanol, and the resulting slurry was stirred at room temperature for 1 hour.

Finally, the slurry was filtered, and the filtered matter was recovered. The filtered matter was then dried, giving the target aniline derivative A (amount, 2.20 g; yield, 90%). The MALDI-TOF-MS results were as follows.
MALDI-TOF-MS, m/Z; found: 1024.13
([m]⁺ calculated: 1024.40).

### [Production Example 2] Synthesis of Aniline Derivative B

### [2-1]

A flask was charged with 10.00 g of 3-bromocarbazole, 1.75 g of sodium hydroxide and 100 mL of N,N-dimethylformamide, following which the interior of the flask was flushed with nitrogen. Next, 7.42 g of benzyl bromide was added dropwise thereto and the system was stirred at room temperature for 19 hours, following which the reaction mixture was added dropwise to deionized water under stirring, and the resulting system was additionally stirred at room temperature. The resulting slurry was filtered and the filtered matter was dried, giving the target 9-benzyl-3-bromocarbazole (amount, 13.1 g; yield, 96%). The ¹H-NMR results are shown below.
¹H-NMR (300 MHz, CDCl₃) δ [ppm]:
8.23 (d, J = 2.1 Hz, 1H), 8.07 (d, J = 8.0 Hz, 1H), 7.49 (dd, J = 8.6, 2.1 Hz, 1H), 7.42-7.45 (m, 1H), 7.36 (d, J = 8.0 Hz, 1H), 7.21-7.31 (m, 5H), 7.08-7.11 (m, 2H), 5.49 (s, 2H).

### [2-2]

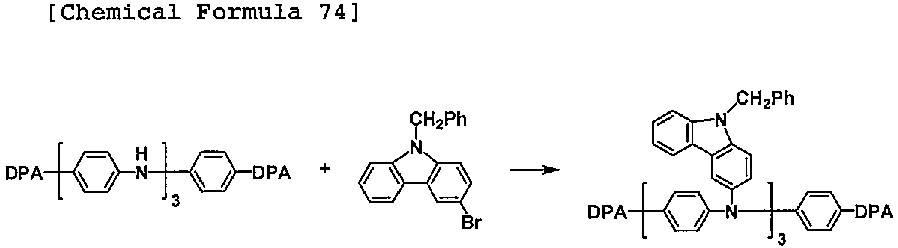

Here and below, DPA stands for a diphenylamine group.

A flask was charged with charged with 2.00 g of N1-(4-((4-((4-(diphenylamino)phenyl)amino)phenyl)amino)-phenyl)-N4,N4-diphenylbenzene-1,4-diamine, 3.24 g of the 9-benzyl-3-bromocarbozole obtained above, 50.5 mg of Pd(dba)₂ and 1.21 g of t-butoxysodium, following which the interior of the flask was flushed with nitrogen. To this was added 20 mL of toluene and 0.56 mL of a toluene solution of tri-t-butylphosphine (concentration, 63.4 g/L) prepared beforehand, and the system was stirred for 24 hours at 50°C.

After the completion of stirring, the reaction mixture was cooled to room temperature, the cooled reaction mixture, toluene and saturated saline were mixed together, and separatory treatment was carried out. Next, activated carbon was added to the resulting organic phase, which was then stirred at room temperature for 30 minutes, following which the activated carbon was removed by filtration and the filtrate was concentrated. The concentrate thus obtained was added dropwise to a mixed solvent of methanol and ethyl acetate, and the resulting slurry was stirred at room temperature.

Finally, the slurry was filtered and the filtered matter was dried, giving the target N1,N4-bis(9-benzyl-9H-carbazol-3-yl)-N1-(4-((9-benzyl-9H-carbazol-3-yl)(4-(diphenylamino)phenyl)amino)phenyl)-N4-(4-(diphenylamino)phenyl)benzene-1,4-diamine (amount, 3.92 g; yield, 93%). The MALDI-TOF-MS results were as follows. MALDI-TOF-MS, m/Z; found: 1452.52 ([m]⁺ calculated: 1450.63).

### [2-3]

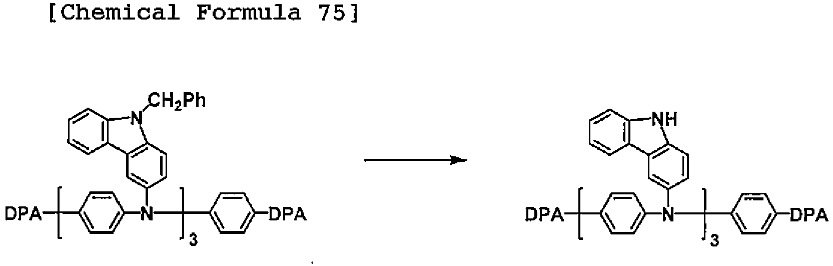

A flask was charged with 2.00 g of the N1,N4-bis(9-benzyl-9H-carbazol-3-yl)-N1-(4-((9-benzyl-9H-carbazol-3-yl)(4-(diphenylamino)phenyl)amino)phenyl)-N4-(4-(diphenylamino)phenyl)benzene-1,4-diamine obtained above and 40 mL of dimethylsulfoxide, following which the interior of the flask was flushed with oxygen. To this was added dropwise 25 mL of a tetrahydrofuran solution of t-butoxypotassium (concentration, 1 mol/L) prepared beforehand, and the system was stirred at room temperature for 23 hours.

Following the completion of stirring, the reaction mixture was added dropwise to a mixed solvent of deionized water and methanol, and the resulting mixture was stirred, after which 5 mL of 5 mol/L hydrochloric acid was added dropwise thereto and the system was additionally stirred.

Finally, the resulting slurry was filtered and the filtered matter was dried, giving the target Aniline Derivative B (amount, 1.62 g; yield, 99%). The MALDI-TOF-MS results were as follows. MALDI-TOF-MS, m/Z; found: 1180.10 ([m]⁺ calculated: 1180.49).

### [Production Example 3] Synthesis of Aniline Derivative (H5)

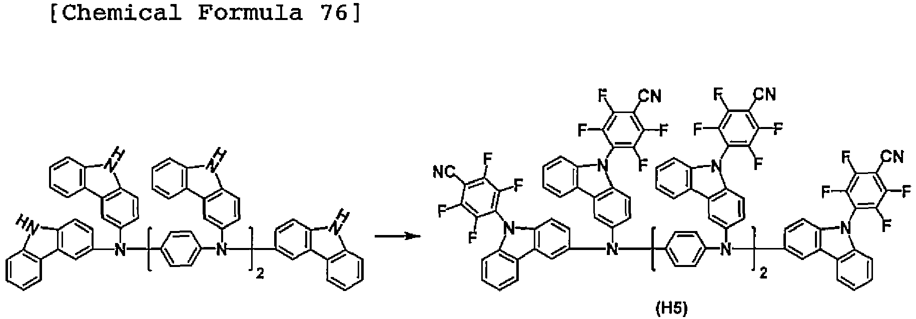

A flask was charged with 0.50 g of Aniline Derivative A, 0.67 g of potassium carbonate and 5 mL of N,N-dimethylformamide, following which the interior of the flask was flushed with nitrogen. Next, 330 µL of pentafluorobenzonitrile was added dropwise thereto, and the system was stirred at room temperature for 15 hours.

Following the completion of stirring, the reaction mixture was added dropwise to deionized water and the resulting slurry was stirred at room temperature for 30 minutes. Next, the slurry was filtered, and the filtered matter was dried. The resulting powder was dissolved in toluene and the resulting solution was subjected to silica gel column chromatography (developing solvent: toluene). Using thin-layer column chromatography (TLC) or the like to check for the presence of the target substance, the fractions containing the target substance were separated off and collected. The solvent was distilled off under reduced pressure from the collected fractions and the resulting solid was dried, giving an aniline derivative of the formula (H5) (amount, 0.37 g; yield, 40%). The MALDI-TOF-MS results were as follows. MALDI-TOF-MS, m/Z; found: 1890.54 ([m]⁺ calculated: 1889.34).

### [Production Example 4] Synthesis of Aniline Derivative (H6)

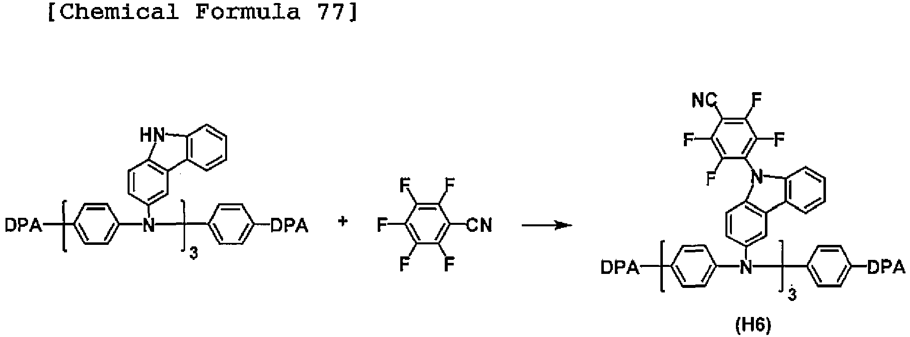

A flask was charged with 2.36 g of Aniline Derivative B, 20 mL of N,N-dimethylformamide and 1.66 g of potassium carbonate, following which the flask interior was flushed with nitrogen. Next, while cooling the flask in an ice bath, 1.29 g of pentafluorobenzonitrile was added dropwise and the temperature was gradually raised to room temperature under stirring, after which the system was stirred at room temperature in this manner for 24 hours.

After the completion of stirring, the reaction mixture was filtered, the solvent was distilled off under reduced pressure from the resulting filtrate, and the residue obtained was dissolved in a mixed solvent of toluene and n-hexane (3:2 (v/v)). The resulting solution was subjected to silica gel column chromatography (developing solvent: toluene/hexane). Using thin-layer column chromatography (TLC) or the like to check for the presence of the target substance, the fractions containing the target substance were separated off and collected.

The solvent was distilled off under reduced pressure from the collected fractions and the resulting solid was dried, giving an aniline derivative of the formula (H6) (amount, 1.34 g; yield, 40%). The ¹H-NMR and MALDI-TOF-MS results were as follows.
¹H-NMR (300 MHz, THF-d8) δ [ppm]:
8.02-8.10 (m, 6H), 6.90-7.46 (m, 51H).
MALDI-TOF-MS, m/Z; found: 1699.75
([m]⁺ calculated: 1700.46).

### [2] Preparation of Charge-Transporting Varnish

### [Working Example 1-1]

A charge-transporting varnish was obtained by dissolving 0.067 g of an aniline derivative represented by formula (H1) below (referred to below as "H1") as the charge-transporting substance and 0.137 g of an arylsulfonic acid compound of formula (Dl) below (referred to below as "D1") as the dopant in 10 g of N,N-dimethylisobutyramide (DMIB), and using a PTFE filter having a pore size of 0.2 µm to filter the resulting solution.

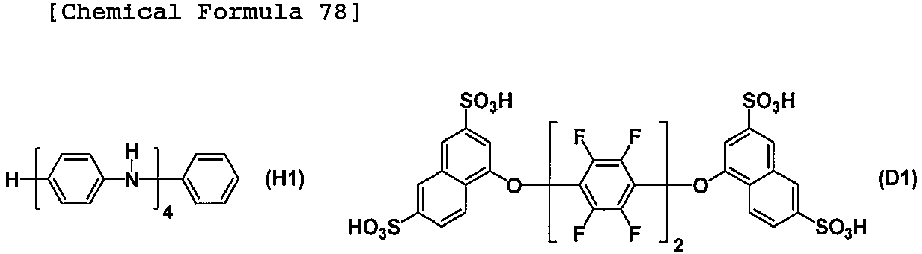

### [Working Examples 1-2 to 1-16, and Comparative Examples 1-1 to 1-10]

Aside from varying the types and amounts of the charge-transporting substance, dopant and solvent used in accordance with Table 19, charge-transporting varnishes were prepared by the same method as in Working Example 1-1.

In the table, H2 represents the aniline derivative of formula (H2) below (wherein "Ph" stands for a phenyl group), H3 represents N,N'-diphenylbenzidine, H4 represents a thiophene derivative of formula (H4) below (wherein "n-Hex" stands for an n-hexyl group), D2 represents phosphotungstic dianhydride, DPM represents dipropylene glycol monomethyl ether, 2,3-BD represents 2,3-butanediol, DMI represents 1,3-dimethyl-2-imidazolidinone, and DMAc represents N,N-dimethylacetamide.

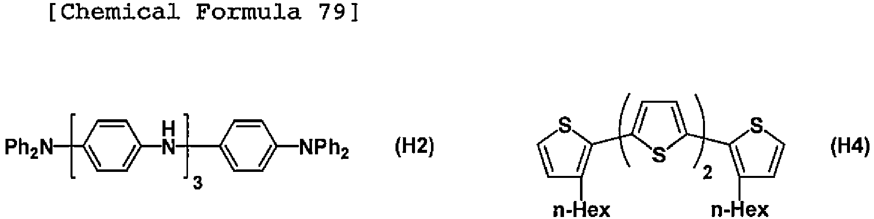

**[Table 19]**

| | Charge-transporting substance | | Dopant | | Solvent | |
|---|---|---|---|---|---|---|
| | Type | Amount (g) | Type | Amount (g) | Type | Amount (g) |
| Working Example 1-1 | H1 | 0.067 | D1 | 0.137 | DMIB | 10 |
| Comparative Example 1-1 | H1 | 0.067 | D1 | 0.137 | DMAc | 10 |
| Comparative Example 1-2 | H1 | 0.067 | D1 | 0.137 | DMI | 10 |
| Working Example 1-2 | H2 | 0.069 | D1 | 0.135 | DMIB | 10 |
| Comparative Example 1-3 | H2 | 0.069 | D1 | 0.135 | DMAc | 10 |
| Comparative Example 1-4 | H2 | 0.069 | D1 | 0.135 | DMI | 10 |
| Working Example 1-3 | H2 | 0.052 | D2 | 0.258 | DMIB | 10 |
| Comparative Example 1-5 | H2 | 0.052 | D2 | 0.258 | DMAc | 10 |
| Comparative Example 1-6 | H2 | 0.052 | D2 | 0.258 | DMI | 10 |
| Working Example 1-4 | H3 | 0.087 | D1 | 0.117 | DMIB | 10 |
| Comparative Example 1-7 | H3 | 0.087 | D1 | 0.117 | DMAc | 10 |
| Comparative Example 1-8 | H3 | 0.087 | D1 | 0.117 | DMI | 10 |
| Working Example 1-5 | H4 | 0.052 | D2 | 0.258 | DMIB | 10 |
| Comparative Example 1-9 | H4 | 0.052 | D2 | 0.258 | DMAC | 10 |
| Comparative Example 1-10 | H4 | 0.052 | D2 | 0.258 | DMI | 10 |
| Working Example 1-6 | H5 | 0.208 | - | - | DMIB | 10 |
| Working Example 1-7 | H6 | 0.208 | - | - | DMIB | 10 |
| Working Example 1-8 | H2 | 0.069 | D1 | 0.135 | DMIB | 8 |
| | | | | | 2,3-BD | 2 |
| Working Example 1-9 | H2 | 0.069 | D1 | 0.135 | DMIB | 6 |
| | | | | | 2,3-BD | 4 |
| Working Example 1-10 | H2 | 0.069 | D1 | 0.135 | DMIB | 4 |
| | | | | | 2,3-BD | 6 |
| Working Example 1-11 | H2 | 0.069 | D1 | 0.135 | DMIB | 8 |
| | | | | | DPM | 2 |
| Working Example 1-12 | H2 | 0.069 | D1 | 0.135 | DMIB | 6 |
| | | | | | DPM | 4 |
| Working Example 1-13 | H2 | 0.069 | D1 | 0.135 | DMIB | 4 |
| | | | | | DPM | 6 |
| Working Example 1-14 | H2 | 0.069 | D1 | 0.135 | DMIB | 8 |
| | | | | | 2,3-BD | 1 |
| | | | | | DPM | 1 |
| Working Example 1-15 | H2 | 0.069 | D1 | 0.135 | DMIB | 6 |
| | | | | | 2,3-BD | 2 |
| | | | | | DPM | 2 |
| Working Example 1-16 | H2 | 0.069 | D1 | 0.135 | DMIB | 4 |
| | | | | | 2,3-BD | 3 |
| | | | | | DPM | 3 |

### [3] Production of Charge-Transporting Thin-Films

### [Working Example 2-1]

The varnish obtained in Working Example 1-1 was coated onto an ITO substrate using a spin coater and was subsequently, in open air, pre-baked for 5 minutes at 50°C and then subjected to a main bake for 15 minutes at 230°C, thereby forming a 30 nm thin-film on an ITO substrate. A glass substrate with dimensions of 25 mm × 25 mm × 0.7 mm (t) and having indium-tin oxide (ITO) patterned on the surface to a film thickness of 150 nm was used as the ITO substrate. Prior to use, impurities on the surface were removed with an O₂ plasma cleaning system (150 W, 30 seconds).

### [Working Examples 2-2 to 2-16, and Comparative Examples 2-1 to 2-10]

Aside from using the varnishes obtained in Working Examples 1-2 to 1-16 and Comparative Examples 1-1 to 1-10 instead of the varnish obtained in Working Example 1-1, thin-films were formed by the same method as in Working Example 2-1.

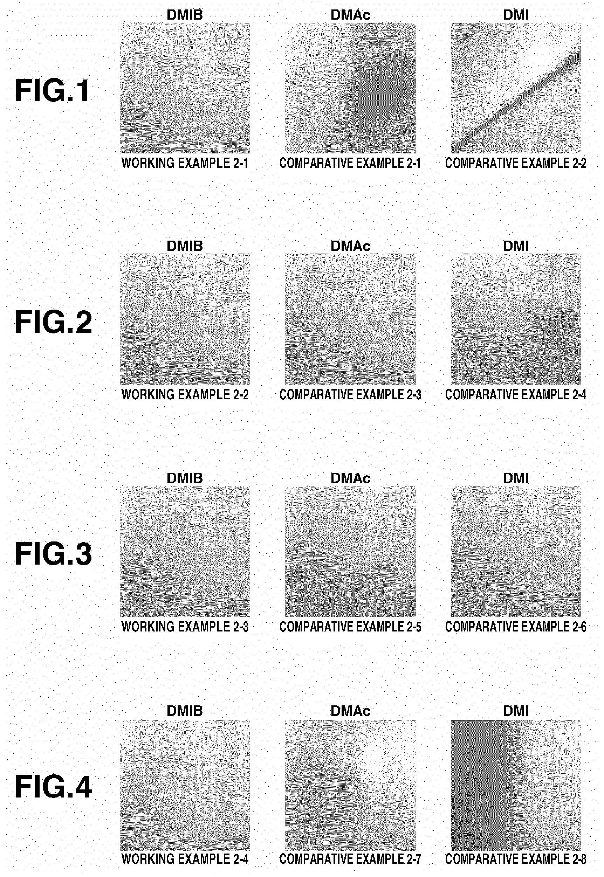

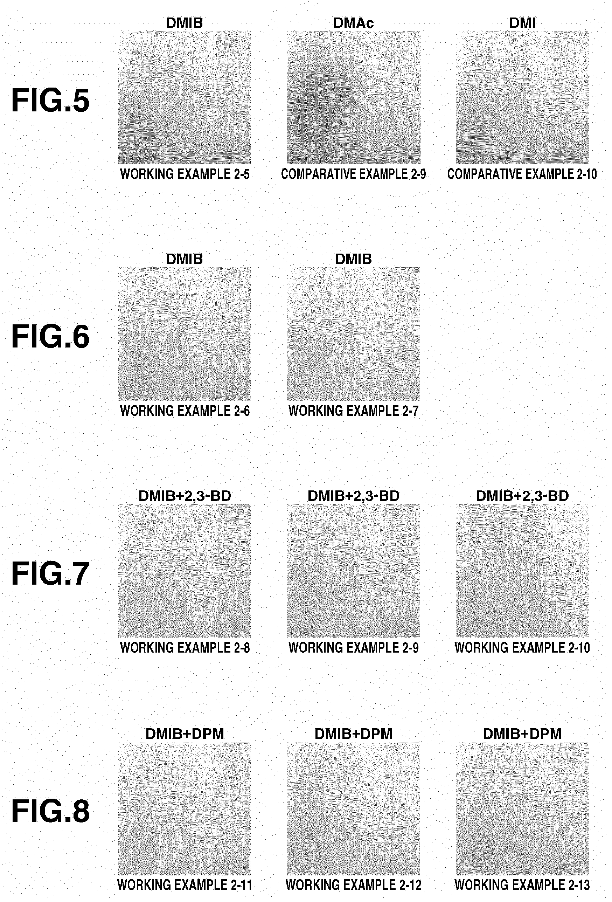

The surfaces of the resulting thin-films were examined using a laser microscope. The results are shown in FIGS. 1 to 9. As is apparent from FIGS. 1 to 9, when the varnishes of the comparative examples were used, the surfaces of the resulting thin-films were observed to be uneven and, in most cases, a high-flatness thin-film could not obtained. By contrast, when the varnishes of the invention were used, surface unevenness was substantially not observed. Also, it was possible to reproducibly produce charge-transporting thin-films of excellent flatness, regardless of the types of dopant and host used.

### [4] Fabrication of Organic EL Devices

### [Working Example 3-1]

A 30 nm thin-film was formed on an ITO substrate by the same method as in Working Example 2-1.

Next, using a vapor deposition system (degree of vacuum, 1.0×10⁻⁵ Pa), thin-films of α-NPD, Alq³, lithium fluoride and aluminum were successively deposited on the ITO substrate on which a thin-film had been formed, thereby giving an organic EL device. At this time, vapor deposition was carried out at a rate of 0.2 nm/s for α-NPD, Alq₃ and aluminum, and at a rate of 0.02 nm/s for lithium fluoride. The film thicknesses were set to, respectively, 30 nm, 40 nm, 0.5 nm and 120 nm.

To prevent the device characteristics from deteriorating due to the influence of oxygen, moisture and the like in air, the organic EL device was sealed with sealing substrates, following which the characteristics were evaluated. Sealing was carried out by the following procedure. The organic EL device was placed between sealing substrates in a nitrogen atmosphere having an oxygen concentration of 2 ppm or less and a dew point of not more than -85°C, and the sealing substrates were laminated together using an adhesive (WB90US(P), from Moresco Corporation). At this time, a desiccant (HD-071010W-40, from Dynic Corporation) was placed, together with the organic EL device, within the sealing substrates. The laminated sealing substrates were irradiated with UV light (wavelength, 365 nm; dosage, 6,000 mJ/cm²), then annealed at 80° C for 1 hour to cure the adhesive.

### [Working Example 3-2 and Comparative Examples 3-1 to 3-4]

Aside from using the varnishes obtained in, respectively, Working Example 1-2 and Comparative Examples 1-1 to 1-4 instead of the varnish obtained in Working Example 1-1, organic EL devices were fabricated in the same way as in Working Example 3-1.

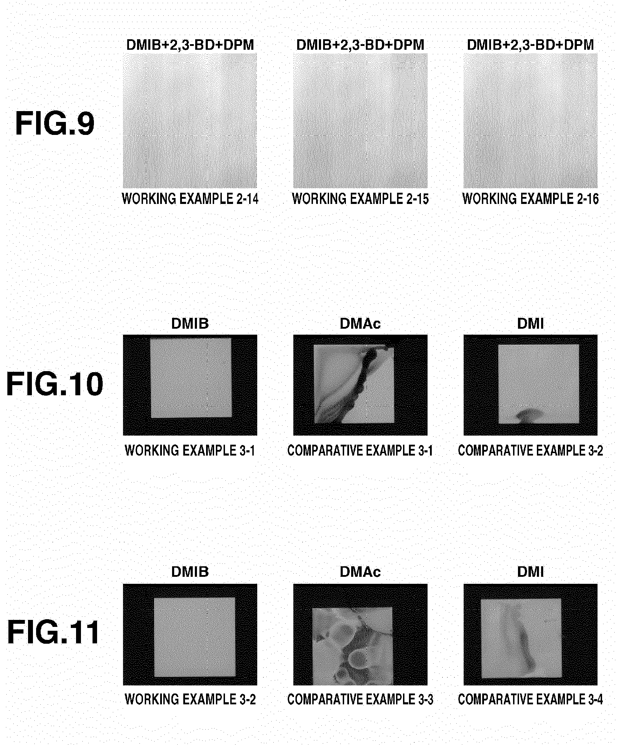

The light-emitting surface when a driving voltage of 5 V was applied to the resulting organic EL device was observed using a CCD camera installed in the I-V-L measurement system. The results are shown in FIGS. 10 and 11.

As is apparent from FIGS. 10 and 11, the thin-films produced using the varnishes of the comparative examples had poor flatnesses, and so uneven light emission was observed in devices provided with these thin-films. By contrast, the thin-films produced using the varnishes of the working examples had excellent flatnesses, and so uneven light emission was not observed in organic EL devices provided with these thin-films.

The current densities and brightnesses at a driving voltage of 5V for the devices fabricated in Working Examples 3-1 and 3-2 were measured. The results are shown in Table 20.

**[Table 20]**

| | Current density (mA/cm²) | Brightness (cd/m²) | Current efficiency (cd/A) |
|---|---|---|---|
| Working Example 3-1 | 91.6 | 2,820 | 3.1 |
| Working Example 3-2 | 89.1 | 2,870 | 3.2 |

### [Working Example 3-3]

The varnish obtained in Working Example 1-6 was coated onto an ITO substrate using a spin coater, then dried at 80°C for 1 minute and subsequently baked in an open-air atmosphere for 10 minutes at 150°C, thereby forming a uniform 30-nm thin-film on the ITO substrate. The ITO substrate used was similar to that used in Working Example 3-1.

Next, using a vapor deposition system (degree of vacuum, 1.0×10⁻⁵ Pa), a 30 nm film of α-NPD was formed at a deposition rate of 0.2 nm/s on the ITO substrate on which a thin-film had been formed. CBP and Ir(PPy)₃ were then co-vapor deposited. Co-vapor deposition was carried out while controlling the vapor deposition rate so that the Ir(PPy)₃ concentration becomes 6%, thereby depositing a 40 nm layer. Next, thin-films of BAlq, lithium fluoride and aluminum were successively deposited, thereby giving an organic EL device. At this time, vapor deposition was carried out at a rate of 0.2 nm/s each for BAlq and aluminum, and at a rate of 0.02 nm/s for lithium fluoride. The film thicknesses were set to respectively 20 nm, 0.5 nm and 100 nm.

The devices were sealed in the same way as in Working Example 3-1, following which the device characteristics were evaluated.

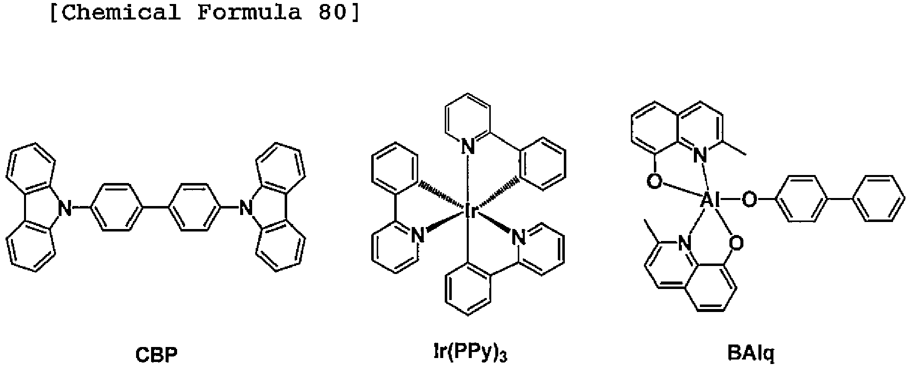

### [Working Example 3-4]

Aside from using the varnish obtained in Working Example 1-7 instead of the varnish obtained in Working Example 1-6, an organic EL device was fabricated by the same method as in Working Example 3-3.

The driving voltage, brightness and luminous efficiency at a driving current of 0.7 mA were measured for the devices fabricated in Working Examples 3-3 and 3-4. The results are shown in Table 21.

**[Table 21]**

| Working Examples | Driving voltage (V) | Brightness (cd/m²) | Luminous efficiency (cd/A) |
|---|---|---|---|
| 3-3 | 11.1 | 18.9 | 26.5 |
| 3-4 | 11.2 | 20.6 | 24.2 |

As shown in Tables 20 and 21, by using charge-transporting thin-films obtained from charge-transporting varnishes of this invention as hole injection layers, organic EL devices of excellent brightness characteristics were obtained.

## Claims

1. A charge-transporting varnish comprising a charge-transporting substance selected from an aniline derivative, thiophene derivative, and pyrrole derivative and having a molecular weight of 200 to 9,000 as measured in the description; a dopant selected from heteropolyacids and arylsulfonic acids; and an organic solvent, which charge-transporting varnish is **characterized in that** the organic solvent includes, as a good solvent, an acid amide derivative of formula (A) below 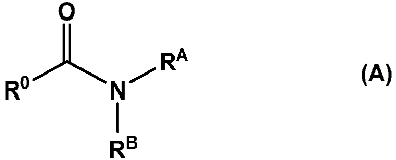 wherein R⁰ is a propyl or isopropyl group, and R^{A} and R^{B} are each independently an alkyl group of 1 to 4 carbon atoms.

2. The charge-transporting varnish of claim 1, wherein the acid amide derivative is N,N-dimethylisobutyramide.

3. The charge-transporting varnish of claim 1 or 2, wherein the charge-transporting substance includes at least one compound selected from among aniline derivatives and thiophene derivatives.

4. The charge-transporting varnish of any one of claims 1 to 3, wherein the charge-transporting substance is an aniline derivative represented by formula (1) or (2), 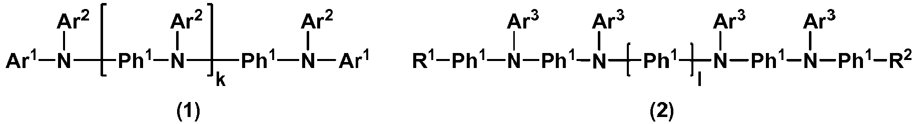 wherein
R¹ and R² are each independently a hydrogen atom, a halogen atom, a nitro group, a cyano group, or an alkyl group of 1 to 20 carbon atoms, alkenyl group of 2 to 20 carbon atoms, alkynyl group of 2 to 20 carbon atoms, aryl group of 6 to 20 carbon atoms or heteroaryl group of 2 to 20 carbon atoms which may be substituted with a halogen atom;
Ph¹ represents a group of formula (P1), 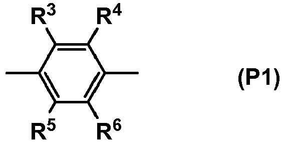 wherein R³ to R⁶ are each independently a hydrogen atom, a halogen atom, a nitro group, a cyano group, or an alkyl group of 1 to 20 carbon atoms, alkenyl group of 2 to 20 carbon atoms, alkynyl group of 2 to 20 carbon atoms, aryl group of 6 to 20 carbon atoms or heteroaryl group of 2 to 20 carbon atoms which may be substituted with a halogen atom;
each Ar¹ is independently a group represented by any of formulas (B1) to (B11), 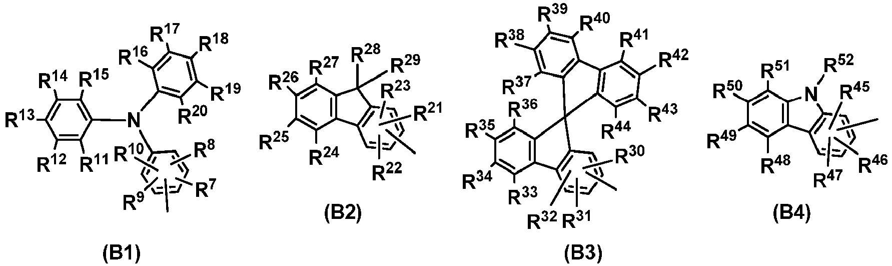 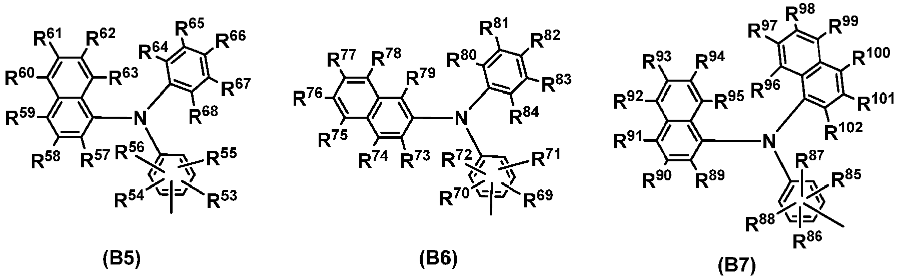 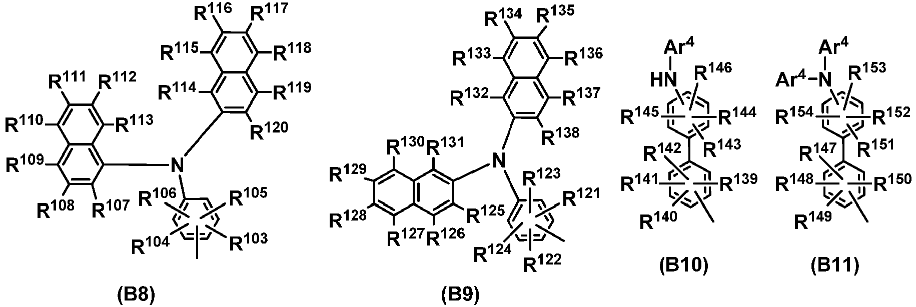 wherein R⁷ to R²⁷, R³⁰ to R⁵¹ and R⁵³ to R¹⁵⁴ are each independently a hydrogen atom, a halogen atom, a nitro group, a cyano group, or a diphenylamino group, alkyl group of 1 to 20 carbon atoms, alkenyl group of 2 to 20 carbon atoms, alkynyl group of 2 to 20 carbon atoms, aryl group of 6 to 20 carbon atoms or heteroaryl group of 2 to 20 carbon atoms which may be substituted with a halogen atom; R²⁸ and R²⁹ are each independently an aryl group of 6 to 20 carbon atoms or a heteroaryl group of 2 to 20 carbon atoms which may be substituted with Z¹_{;} R⁵² is a hydrogen atom, an alkyl group of 1 to 20 carbon atoms, alkenyl group of 2 to 20 carbon atoms or alkynyl group of 2 to 20 carbon atoms which may be substituted with Z⁴, or an aryl group of 6 to 20 carbons or heteroaryl group of 2 to 20 carbon atoms which may be substituted with Z¹_{;} Z¹ is a halogen atom, a nitro group, a cyano group, or an alkyl group of 1 to 20 carbon atoms, alkenyl group of 2 to 20 carbon atoms or alkynyl group of 2 to 20 carbon atoms which may be substituted with Z²_{;} Z² is a halogen atom, a nitro group, a cyano group, or an aryl group of 6 to 20 carbon atoms or heteroaryl group of 2 to 20 carbon atoms which may be substituted with Z³_{;} Z³ is a halogen atom, a nitro group or a cyano group; Z⁴ is a halogen atom, a nitro group, a cyano group, or an aryl group of 6 to 20 carbon atoms or heteroaryl group of 2 to 20 carbon atoms which may be substituted with Z⁵; Z⁵ is a halogen atom, a nitro group, a cyano group, or an alkyl group of 1 to 20 carbon atoms, alkenyl group of 2 to 20 carbon atoms or alkynyl group of 2 to 20 carbon atoms which may be substituted with Z³_{;} and Ar⁴ is each independently an aryl group of 6 to 20 carbon atoms which may be substituted with a diarylamino group wherein each aryl group is an aryl group of 6 to 20 carbon atoms;
Ar² is each independently a group of any one of formulas (Al) to (A18), 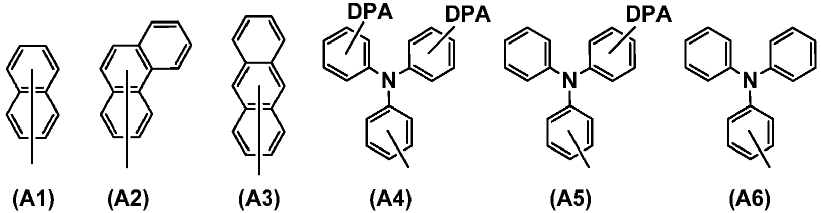 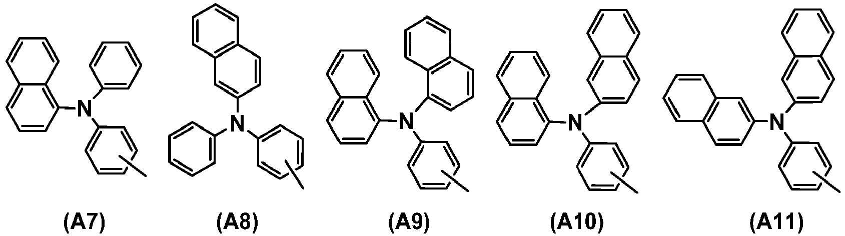 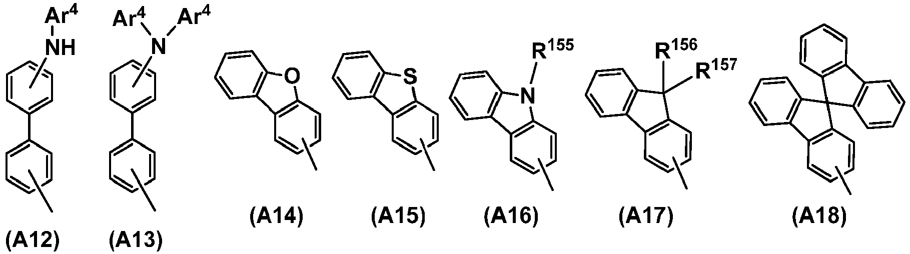 wherein R¹⁵⁵ is a hydrogen atom, an alkyl group of 1 to 20 carbon atoms, alkenyl group of 2 to 20 carbon atoms or alkynyl group of 2 to 20 carbon atoms which may be substituted with Z⁴, or an aryl group of 6 to 20 carbons or heteroaryl group of 2 to 20 carbon atoms which may be substituted with Z¹_{;} R¹⁵⁶ and R¹⁵⁷ are each independently an aryl group of 6 to 20 carbon atoms or heteroaryl group of 2 to 20 carbon atoms which may be substituted with Z¹_{;} DPA stands for a diphenylamino group; and Ar⁴, Z¹ and Z⁴ are as defined above;
Ar³ is a group of any of formulas (C1) to (C8), 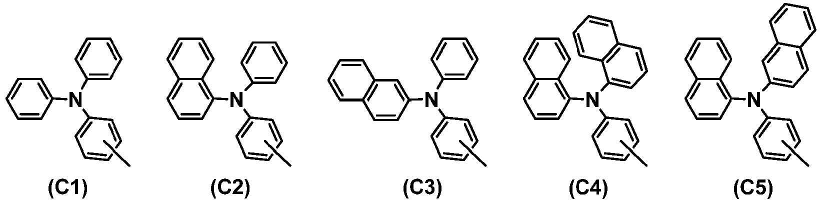 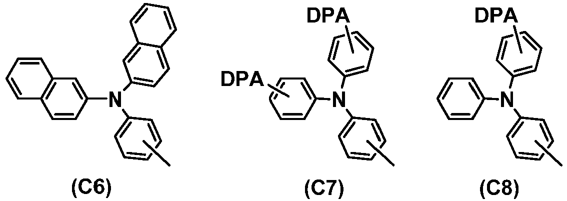
wherein DPA is as defined above;
k is an integer from 1 to 10; and
the letter "1" represents 1 or 2.

5. The charge-transporting varnish of any one of claims 1 to 3, wherein the charge-transporting substance is an aniline derivative represented by formula (13), 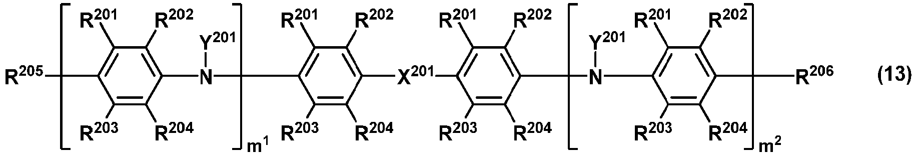 wherein
X²⁰¹ is -N^{y201}-, -O-, -S-, - (CR²⁰⁷R²⁰⁸) L- or a single bond, with the proviso that when m¹ or m² is 0, X²⁰¹ is -NY²⁰¹-_{;} each Y²⁰¹ is independently a hydrogen atom, an alkyl group of 1 to 20 carbon atoms, alkenyl group of 2 to 20 carbon atoms or alkynyl group of 2 to 20 carbon atoms which may be substituted with Z²⁰¹, or an aryl group of 6 to 20 carbon atoms or heteroaryl group of 2 to 20 carbon atoms which may be substituted with Z²⁰² _{;} R²⁰⁷ and R²⁰⁸ are each independently a hydrogen atom, a halogen atom, a nitro group, a cyano group, an amino group, an aldehyde group, a hydroxyl group, a thiol group, a sulfonic acid group, a carboxylic acid group, an alkyl group of 1 to 20 carbon atoms, alkenyl group of 2 to 20 carbon atoms or alkynyl group of 2 to 20 carbon atoms which may be substituted with Z¹, an aryl group of 6 to 20 carbon atoms or heteroaryl group of 2 to 20 carbon atoms which may be substituted with Z², or a -NHY²⁰² , -NY²⁰³Y²⁰⁴ , -C(O)Y²⁰⁵ , -OY²⁰⁶ , ₋-SY²⁰⁷, -SO₃Y²⁰⁸, -C(O)OY²⁰⁹ _{;} -OC(O)Y^{21C}, -C(O)NHY²¹¹ or -C(O)NY²¹²Y²¹³ group;
R²⁰¹ to R²⁰⁶ are each independently a hydrogen atom, a halogen atom, a nitro group, a cyano group, an amino group, an aldehyde group, a hydroxyl group, a thiol group, a sulfonic acid group, a carboxylic acid group, an alkyl group of 1 to 20 carbon atoms, alkenyl group of 2 to 20 carbon atoms or alkynyl group of 2 to 20 carbon atoms which may be substituted with Z²⁰¹, an aryl group of 6 to 20 carbon atoms or heteroaryl group of 2 to 20 carbon atoms which may be substituted with Z²⁰² , or a -NHY²⁰² , -NY²⁰³Y²⁰⁴ , -C(O)Y²⁰⁵ , -OY²⁰⁶ ,-SY²⁰⁷ , -SO₃Y²⁰⁸ , -C(O)OY²⁰⁹ , -OC(O)Y²¹⁰, -C (O) NHY²¹¹ or -C (O) NY²¹²Y²¹³ group;
Y²⁰² to Y²¹³ are each independently an alkyl group of 1 to 20 carbon atoms, alkenyl group of 2 to 20 carbon atoms or alkynyl group of 2 to 20 carbon atoms which may be substituted with Z²⁰¹, or an aryl group of 6 to 20 carbon atoms or heteroaryl group of 2 to 20 carbon atoms which may be substituted with Z²⁰²; Z¹ is a halogen atom, a nitro group, a cyano group, or an alkyl group of 1 to 20 carbon atoms, alkenyl group of 2 to 20 carbon atoms or alkynyl group of 2 to 20 carbon atoms which may be substituted with Z²; Z² is a halogen atom, a nitro group, a cyano group, or an aryl group of 6 to 20 carbon atoms or heteroaryl group of 2 to 20 carbon atoms which may be substituted with Z³; Z³ is a halogen atom, a nitro group or a cyano group; Z²⁰¹ is a halogen atom, a nitro group, a cyano group, an amino group, an aldehyde group, a hydroxyl group, a thiol group, a sulfonic acid group, a carboxylic acid group, or an aryl group of 6 to 20 carbon atoms or heteroaryl group of 2 to 20 carbon atoms which may be substituted with Z²⁰³; Z²⁰² is a halogen atom, a nitro group, a cyano group, an amino group, an aldehyde group, a hydroxyl group, a thiol group, a sulfonic acid group, a carboxylic acid group, or an alkyl group of 1 to 20 carbon atoms, alkenyl group of 2 to 20 carbon atoms or alkynyl group of 2 to 20 carbon atoms which may be substituted with Z²⁰³; Z²⁰³ is a halogen atom, a nitro group, a cyano group, an amino group, an aldehyde group, a hydroxyl group, a thiol group, a sulfonic acid group or a carboxylic acid group; and L is an integer from 1 to 20; and
m¹ and m² independently represent an integer of 0 or more and satisfy the condition 1 ≤ m¹+m² ≤ 20.

6. The charge-transporting varnish of any one of claims 1 to 3, wherein the charge-transporting substance is a thiophene derivative represented by formula (14), 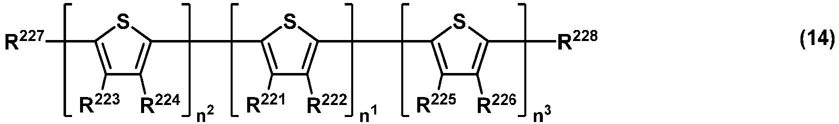 wherein
R221 to R226 are each independently a hydrogen atom, an alkyl group of 1 to 20 carbon atoms, alkenyl group of 2 to 20 carbon atoms or alkynyl group of 2 to 20 carbon atoms which may be substituted with Z²⁰⁴, an aryl group of 6 to 20 carbon atoms or heteroaryl group of 2 to 20 carbon atoms which may be substituted with Z²⁰⁵ or -OY²²¹, -SY²²², -NHY²²³, -NY²²⁴Y²²⁵ or - NHC (O) Y²²⁶ in cases where R²²¹ to R²²⁶ are not hydrogen atoms, R²²¹ and R²²², R²²³ and R²²⁴ and/or R²²⁵ and R²²⁶ may mutually bond to form divalent groups;
R²²⁷ and R²²⁸ are each independently a hydrogen atom, an alkyl group of 1 to 20 carbon atoms, alkenyl group of 2 to 20 carbon atoms or alkynyl group of 2 to 20 carbon atoms which may be substituted with Z²⁰⁴ , an aryl group of 6 to 20 carbon atoms or heteroaryl group of 2 to 20 carbon atoms which may be substituted with Z²⁰⁶ , or -OY²²¹, -SY²²², -NHY²²³, -NY²²⁴Y²²⁵ or-NHC(O) Y²²⁶ ;
Y²²¹ to Y²²⁶ are each independently an alkyl group of 1 to 20 carbon atoms, alkenyl group of 2 to 20 carbon atoms or alkynyl group of 2 to 20 carbon atoms which may be substituted with Z²⁰⁴, or an aryl group of 6 to 20 carbon atoms or heteroaryl group of 2 to 20 carbon atoms which may be substituted with Z²⁰⁵ ;
Z²⁰⁴ is an aryl group of 6 to 20 carbon atoms or a heteroaryl group of 2 to 20 carbon atoms; Z²⁰⁵ is an alkyl group of 1 to 20 carbon atoms, an alkenyl group of 2 to 20 carbon atoms, or an alkynyl group of 2 to 20 carbon atoms; Z²⁰⁶ is an alkyl group of 1 to 20 carbon atoms, an alkenyl group of 2 to 20 carbon atoms, an alkynyl group of 2 to 20 carbon atoms, a dialkylamino group wherein each alkyl is an alkyl group of 1 to 20 carbon atoms, or a diarylamino group wherein each aryl is an aryl group of 6 to 20 carbon atoms; and
the subscripts n¹ to n³ independently represent a positive integer and satisfy the condition 4 ≤ n¹+n²+n³ ≤ 20.

7. The charge-transporting varnish of claim 1, wherein the organic solvent further includes at least one selected from the group consisting of glycols, triols, alkylene glycols, alkylene glycol monoalkyl ethers, alkylene glycol dialkyl ethers, dialkylene glycol monoalkyl ethers and dialkylene glycol dialkyl ethers.

8. A method of producing a charge-transporting thin-film, which method is **characterized by** applying a charge-transporting varnish of any one of claims 1 to 7 onto a substrate and baking.

9. A method of fabricating an organic electroluminescent device, which method is **characterized by** providing a pair of electrodes and producing a charge-transporting thin-film using the method of claim 8 between the electrodes.

10. A method of increasing the flatness of a charge-transporting thin-film the method including applying a charge-transporting varnish according to any one of claims 1 to 7 onto a substrate and baking **characterized in that** the organic solvent is an acid amide derivative of formula (A) below 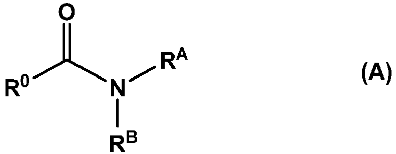 wherein R⁰ is a propyl or isopropyl group, and R^{A} and R^{B} are each independently an alkyl group of 1 to 4 carbon atoms.

## Patentansprüche

1. Ladungstransportierender Lack, der eine ladungstransportierende Substanz, die aus einem Anilinderivat, einem Thiophenderivat und einem Pyrrolderivat ausgewählt ist, und wie in der Beschreibung gemessen ein Molekulargewicht von 200 bis 9.000 aufweist; ein Dotierungsmittel, das aus Heteropolysäuren und Arylsulfonsäuren ausgewählt ist; und ein organisches Lösungsmittel umfasst, wobei der ladungstransportierende Lack **dadurch gekennzeichnet ist, dass** das organische Lösungsmittel ein Säureamidderivat der nachstehenden Formel (A) als gutes Lösungsmittel umfasst 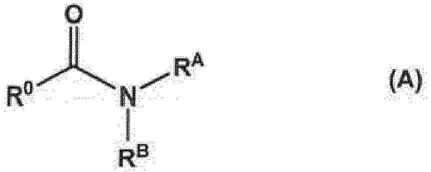 worin R⁰ eine Propyl- oder Isopropylgruppe ist und R^{A} und R^{B} jeweils unabhängig eine Alkylgruppe mit 1 bis 4 Kohlenstoffatomen sind.

2. Ladungstransportierender Lack nach Anspruch 1, wobei das Säureamidderivat N,N-Dimethylisobutyramid ist.

3. Ladungstransportierender Lack nach Anspruch 1 oder 2, wobei die ladungstransportierende Substanz zumindest eine Verbindung umfasst, die aus Anilinderivaten und Thiophenderivaten ausgewählt ist.

4. Ladungstransportierender Lack nach einem der Ansprüche 1 bis 3, wobei die ladungstransportierende Substanz ein Anilinderivat der Formel (1) oder (2) ist 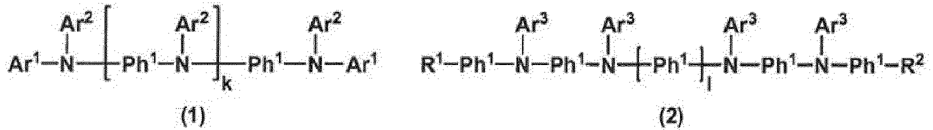 worin
R¹ und R² jeweils unabhängig ein Wasserstoffatom, ein Halogenatom, eine Nitrogruppe, eine Cyanogruppe oder eine Alkylgruppe mit 1 bis 20 Kohlenstoffatomen, eine Alkenylgruppe mit 2 bis 20 Kohlenstoffatomen, eine Alkinylgruppe mit 2 bis 20 Kohlenstoffatomen, eine Arylgruppe mit 6 bis 20 Kohlenstoffatomen oder eine Heteroarylgruppe mit 2 bis 20 Kohlenstoffatomen sind, die gegebenenfalls mit einem Halogenatom substituiert sind;
Ph¹ für eine Gruppe der Formel (P1) steht: 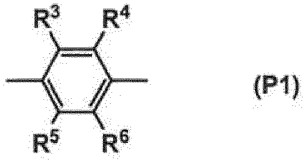 worin R³ bis R⁶ jeweils unabhängig ein Wasserstoffatom, ein Halogenatom, eine Nitrogruppe, eine Cyanogruppe oder eine Alkylgruppe mit 1 bis 20 Kohlenstoffatomen, eine Alkenylgruppe mit 2 bis 20 Kohlenstoffatomen, eine Alkinylgruppe mit 2 bis 20 Kohlenstoffatomen, eine Arylgruppe mit 6 bis 20 Kohlenstoffatomen oder eine Heteroarylgruppe mit 2 bis 20 Kohlenstoffatomen sind, die gegebenenfalls mit einem Halogenatom substituiert sind;
die Ar¹ jeweils unabhängig eine durch eine der Formeln (B1) bis (B11) dargestellte Gruppe sind: 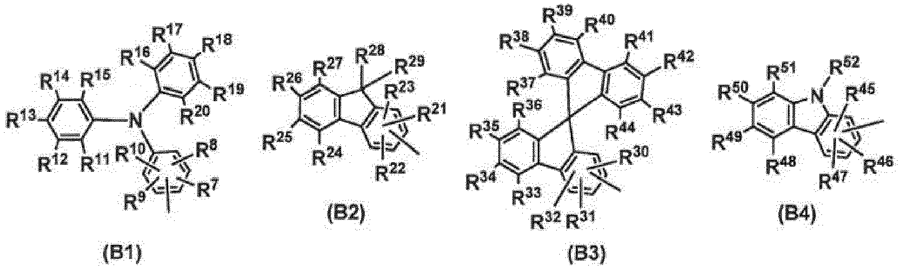 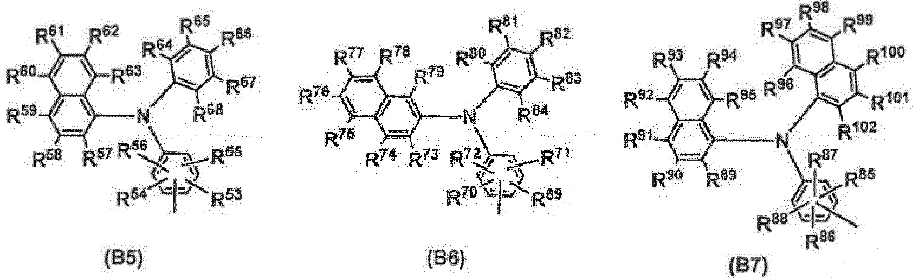 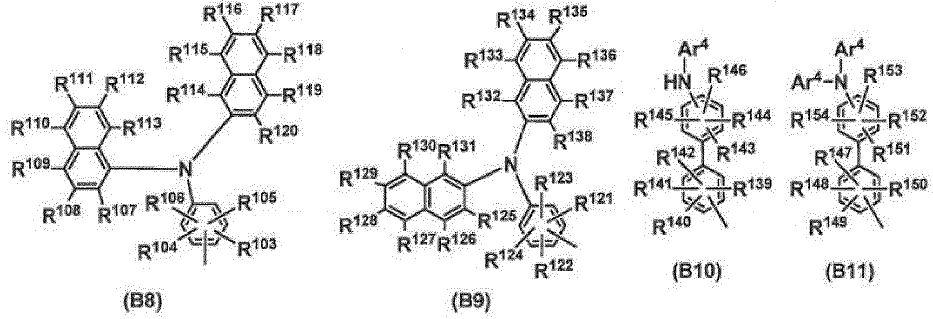 worin R⁷ bis R²⁷, R³⁰ bis R⁵¹ und R⁵³ bis R¹⁵⁴ jeweils unabhängig ein Wasserstoffatom, ein Halogenatom, eine Nitrogruppe, eine Cyanogruppe oder eine Diphenylaminogruppe, eine Alkylgruppe mit 1 bis 20 Kohlenstoffatomen, eine Alkenylgruppe mit 2 bis 20 Kohlenstoffatomen, eine Alkinylgruppe mit 2 bis 20 Kohlenstoffatomen, eine Arylgruppe mit 6 bis 20 Kohlenstoffatomen oder eine Heteroarylgruppe mit 2 bis 20 Kohlenstoffatomen sind, die gegebenenfalls mit einem Halogenatom substituiert sind; R²⁸ und R²⁹ jeweils unabhängig eine Arylgruppe mit 6 bis 20 Kohlenstoffatomen oder eine Heteroarylgruppe mit 2 bis 20 Kohlenstoffatomen sind, die gegebenenfalls mit Z¹ substituiert sind; R⁵² ein Wasserstoffatom, eine Alkylgruppe mit 1 bis 20 Kohlenstoffatomen, eine Alkenylgruppe mit 2 bis 20 Kohlenstoffatomen oder eine Alkinylgruppe mit 2 bis 20 Kohlenstoffatomen, die gegebenenfalls mit Z⁴ substituiert sind, oder eine Arylgruppe mit 6 bis 20 Kohlenstoffatomen oder eine Heteroarylgruppe mit 2 bis 20 Kohlenstoffatomen, die gegebenenfalls mit Z¹ substituiert sind, ist; Z¹ ein Halogenatom, eine Nitrogruppe, eine Cyanogruppe oder eine Alkylgruppe mit 1 bis 20 Kohlenstoffatomen, eine Alkenylgruppe mit 2 bis 20 Kohlenstoffatomen oder eine Alkinylgruppe mit 2 bis 20 Kohlenstoffatomen ist, die gegebenenfalls mit Z² substituiert sind; Z² ein Halogenatom, eine Nitrogruppe, eine Cyanogruppe oder eine Arylgruppe mit 6 bis 20 Kohlenstoffatomen oder eine Heteroarylgruppe mit 2 bis 20 Kohlenstoffatomen, die gegebenenfalls mit Z³ substituiert sind, ist; Z³ ein Halogenatom, eine Nitrogruppe oder eine Cyanogruppe ist; Z⁴ ein Halogenatom, eine Nitrogruppe, eine Cyanogruppe oder eine Arylgruppe mit 6 bis 20 Kohlenstoffatomen oder eine Heteroarylgruppe mit 2 bis 20 Kohlenstoffatomen, die gegebenenfalls mit Z⁵ substituiert sind, ist; Z⁵ ein Halogenatom, eine Nitrogruppe, eine Cyanogruppe oder eine Alkylgruppe mit 1 bis 20 Kohlenstoffatomen, eine Alkenylgruppe mit 2 bis 20 Kohlenstoffatomen oder eine Alkinylgruppe mit 2 bis 20 Kohlenstoffatomen, die gegebenenfalls mit Z³ substituiert sind, ist; und Ar⁴ jeweils unabhängig eine Arylgruppe mit 6 bis 20 Kohlenstoffatomen ist, die gegebenenfalls mit einer Diarylaminogruppe substituiert ist, wobei die Arylgruppe jeweils eine Arylgruppe mit 6 bis 20 Kohlenstoffatomen ist;
Ar² jeweils unabhängig eine Gruppe einer der Formeln (A1) bis (A18) ist: 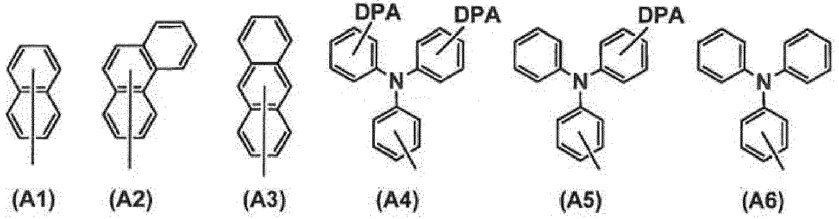 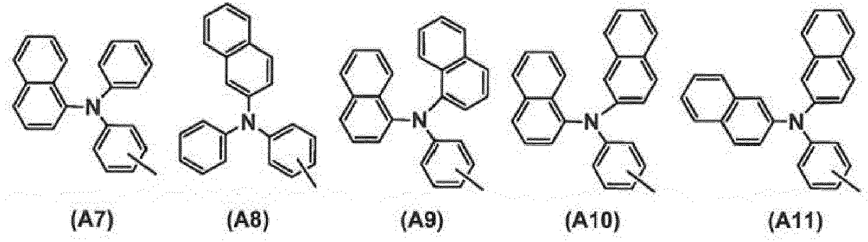 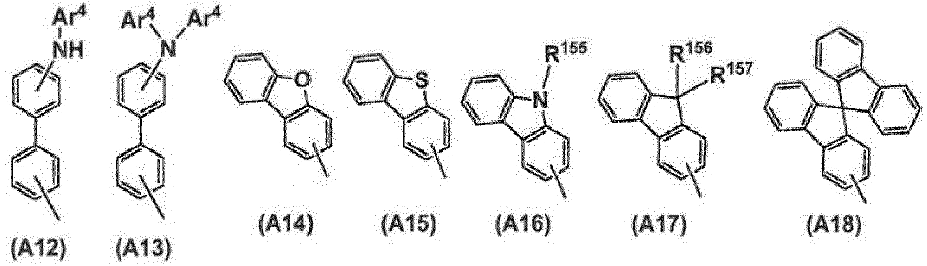 worin R¹⁵⁵ ein Wasserstoffatom, eine Alkylgruppe mit 1 bis 20 Kohlenstoffatomen, eine Alkenylgruppe mit 2 bis 20 Kohlenstoffatomen oder eine Alkinylgruppe mit 2 bis 20 Kohlenstoffatomen, die gegebenenfalls mit Z⁴ substituiert sind, oder eine Arylgruppe mit 6 bis 20 Kohlenstoffatomen oder eine Heteroarylgruppe mit 2 bis 20 Kohlenstoffatomen, die gegebenenfalls mit Z¹ substituiert sind, ist; R¹⁵⁶ und R¹⁵⁷ jeweils unabhängig eine Arylgruppe mit 6 bis 20 Kohlenstoffatomen oder eine Heteroarylgruppe mit 2 bis 20 Kohlenstoffatomen sind, die gegebenenfalls mit Z¹ substituiert sind; DPA für eine Diphenylaminogruppe steht; und Ar⁴, Z¹ und Z⁴ wie vorstehend definiert sind;
Ar³ eine Gruppe einer der Formeln (C1) bis (C8) ist: 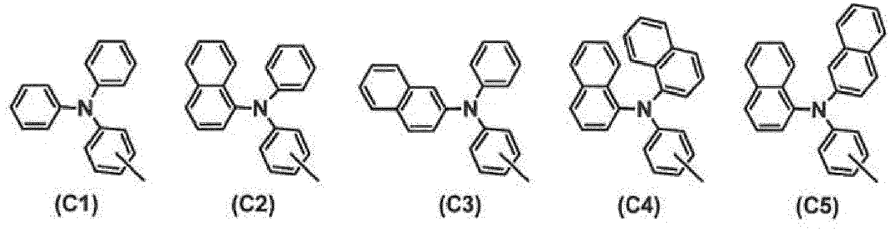 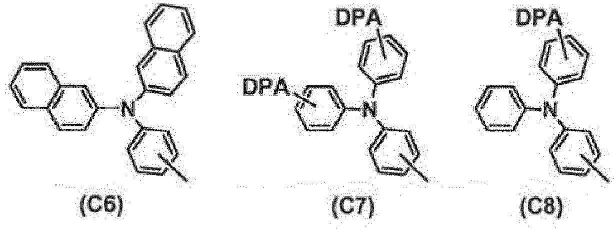
worin DPA wie vorstehend definiert ist;
k eine ganze Zahl von 1 bis 10 ist; und
der Buchstabe "l" für 1 oder 2 steht.

5. Ladungstransportierender Lack nach einem der Ansprüche 1 bis 3, wobei die ladungstransportierende Substanz ein Anilinderivat der Formel (13) ist: 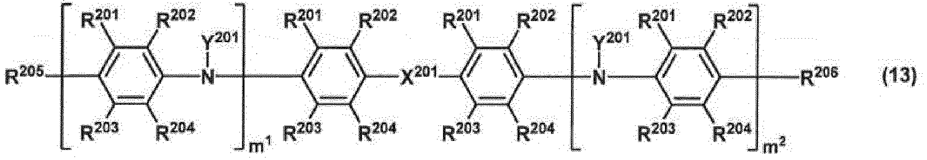 worin
X²⁰¹ für -NY²⁰¹-, -O-, -S-, -(CR²⁰⁷R²⁰⁸)L- oder eine Einfachbindung steht, mit der Maßgabe, dass, wenn m¹ oder m² = 0 ist, X²⁰¹ für -NY²⁰¹- steht; die Y²⁰¹ jeweils unabhängig ein Wasserstoffatom, eine Alkylgruppe mit 1 bis 20 Kohlenstoffatomen, eine Alkenylgruppe mit 2 bis 20 Kohlenstoffatomen oder eine Alkinylgruppe mit 2 bis 20 Kohlenstoffatomen, die gegebenenfalls mit Z²⁰¹ substituiert sind, oder eine Arylgruppe mit 6 bis 20 Kohlenstoffatomen oder eine Heteroarylgruppe mit 2 bis 20 Kohlenstoffatomen sind, die gegebenenfalls mit Z²⁰² substituiert sind; R²⁰⁷ und R²⁰⁸ jeweils unabhängig ein Wasserstoffatom, ein Halogenatom, eine Nitrogruppe, eine Cyanogruppe, eine Aminogruppe, eine Aldehydgruppe, eine Hydroxylgruppe, eine Thiolgruppe, eine Sulfonsäuregruppe, eine Carbonsäuregruppe, eine Alkylgruppe mit 1 bis 20 Kohlenstoffatomen, eine Alkenylgruppe mit 2 bis 20 Kohlenstoffatomen oder eine Alkinylgruppe mit 2 bis 20 Kohlenstoffatomen, die gegebenenfalls mit Z¹ substituiert sind, eine Arylgruppe mit 6 bis 20 Kohlenstoffatomen oder eine Heteroarylgruppe mit 2 bis 20 Kohlenstoffatomen, die gegebenenfalls mit Z² substituiert sind, oder eine Gruppe -NHY²⁰², -NY²⁰³Y²⁰⁴ -C(O)Y²⁰⁵, -OY²⁰⁶, -SY²⁰⁷, -SO₃Y²⁰⁸, -C(O)OY²⁰⁹, -OC(O)Y²¹⁰, -C(O)NHY²¹¹ oder -C(O)NY²¹²Y²¹³ sind;
R²⁰¹ bis R²⁰⁶ jeweils unabhängig ein Wasserstoffatom, ein Halogenatom, eine Nitrogruppe, eine Cyanogruppe, eine Aminogruppe, eine Aldehydgruppe, eine Hydroxylgruppe, eine Thiolgruppe, eine Sulfonsäuregruppe, eine Carbonsäuregruppe, eine Alkylgruppe mit 1 bis 20 Kohlenstoffatomen, eine Alkenylgruppe mit 2 bis 20 Kohlenstoffatomen oder eine Alkinylgruppe mit 2 bis 20 Kohlenstoffatomen, die gegebenenfalls mit Z²⁰¹ substituiert sind, eine Arylgruppe mit 6 bis 20 Kohlenstoffatomen oder eine Heteroarylgruppe mit 2 bis 20 Kohlenstoffatomen, die gegebenenfalls mit Z²⁰² substituiert sind, oder eine Gruppe -NHY²⁰², -NY²⁰³Y²⁰⁴, -C(O)Y²⁰⁵, -OY²⁰⁶, -SY²⁰⁷, -SO₃Y²⁰⁸, -C(O)OY²⁰⁹, -OC(O)Y²¹⁰ -C(O)NHY²¹¹ oder -C(O)NY²¹²Y²¹³ sind;
Y²⁰² bis Y²¹³ jeweils unabhängig eine Alkylgruppe mit 1 bis 20 Kohlenstoffatomen, eine Alkenylgruppe mit 2 bis 20 Kohlenstoffatomen oder eine Alkinylgruppe mit 2 bis 20 Kohlenstoffatomen, die gegebenenfalls mit Z²⁰¹ substituiert sind, oder eine Arylgruppe mit 6 bis 20 Kohlenstoffatomen oder eine Heteroarylgruppe mit 2 bis 20 Kohlenstoffatomen sind, die gegebenenfalls mit Z²⁰² substituiert sind; Z¹ ein Halogenatom, eine Nitrogruppe, eine Cyanogruppe oder eine Alkylgruppe mit 1 bis 20 Kohlenstoffatomen, eine Alkenylgruppe mit 2 bis 20 Kohlenstoffatomen oder eine Alkinylgruppe mit 2 bis 20 Kohlenstoffatomen ist, die gegebenenfalls mit Z² substituiert sind; Z² ein Halogenatom, eine Nitrogruppe, eine Cyanogruppe oder eine Arylgruppe mit 6 bis 20 Kohlenstoffatomen oder eine Heteroarylgruppe mit 2 bis 20 Kohlenstoffatomen, die gegebenenfalls mit Z³ substituiert sind, ist; Z³ ein Halogenatom, eine Nitrogruppe oder eine Cyanogruppe ist; Z²⁰¹ ein Halogenatom, eine Nitrogruppe, eine Cyanogruppe, eine Aminogruppe, eine Aldehydgruppe, eine Hydroxylgruppe, eine Thiolgruppe, eine Sulfonsäuregruppe, eine Carbonsäuregruppe oder eine Arylgruppe mit 6 bis 20 Kohlenstoffatomen oder eine Heteroarylgruppe mit 2 bis 20 Kohlenstoffatomen, die gegebenenfalls mit Z²⁰³ substituiert sind, ist; Z²⁰² ein Halogenatom, eine Nitrogruppe, eine Cyanogruppe, eine Aminogruppe, eine Aldehydgruppe, eine Hydroxylgruppe, eine Thiolgruppe, eine Sulfonsäuregruppe, eine Carbonsäuregruppe oder eine Alkylgruppe mit 1 bis 20 Kohlenstoffatomen, eine Alkenylgruppe mit 2 bis 20 Kohlenstoffatomen oder eine Alkinylgruppe mit 2 bis 20 Kohlenstoffatomen, die gegebenenfalls mit Z²⁰³ substituiert sind, ist; Z²⁰³ ein Halogenatom, eine Nitrogruppe, eine Cyanogruppe, eine Aminogruppe, eine Aldehydgruppe, eine Hydroxylgruppe, eine Thiolgruppe, eine Sulfonsäuregruppe oder eine Carbonsäuregruppe ist; und L eine ganze Zahl von 1 bis 20 ist; und
m¹ und m² jeweils unabhängig für eine ganze Zahl von 0 oder mehr stehen und die Bedingung 1 ≤ m¹+m² ≤ 20 erfüllen.

6. Ladungstransportierender Lack nach einem der Ansprüche 1 bis 3, wobei die ladungstransportierende Substanz ein Thiophenderivat der Formel (14) ist: 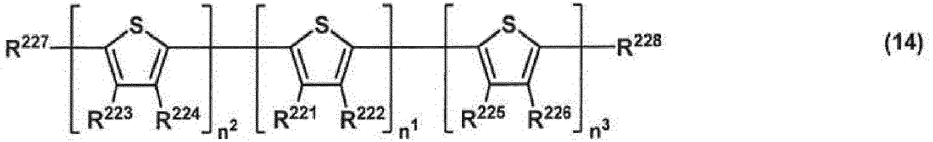 worin
R²²¹ bis R²²⁶ jeweils unabhängig ein Wasserstoffatom, eine Alkylgruppe mit 1 bis 20 Kohlenstoffatomen, eine Alkenylgruppe mit 2 bis 20 Kohlenstoffatomen oder eine Alkinylgruppe mit 2 bis 20 Kohlenstoffatomen, die gegebenenfalls mit Z²⁰⁴ substituiert sind, eine Arylgruppe mit 6 bis 20 Kohlenstoffatomen oder eine Heteroarylgruppe mit 2 bis 20 Kohlenstoffatomen, die gegebenenfalls mit Z²⁰⁵ substituiert sind, oder -OY²²¹, -SY²²², -NHY²²³, -NY²²⁴Y²²⁵ oder -NHC(O)Y²²⁶ sind, wobei, wenn R²²¹ bis R²²⁶ keine Wasserstoffatome sind, R²²¹ und R²²², R²²³ und R²²⁴ und/oder R²²⁵ und R²²⁶ gegebenenfalls miteinander zu zweiwertigen Gruppen verbunden sind;
R²²⁷ und R²²⁸ jeweils unabhängig ein Wasserstoffatom, eine Alkylgruppe mit 1 bis 20 Kohlenstoffatomen, eine Alkenylgruppe mit 2 bis 20 Kohlenstoffatomen oder eine Alkinylgruppe mit 2 bis 20 Kohlenstoffatomen, die gegebenenfalls mit Z²⁰⁴ substituiert sind, eine Arylgruppe mit 6 bis 20 Kohlenstoffatomen oder eine Heteroarylgruppe mit 2 bis 20 Kohlenstoffatomen, die gegebenenfalls mit Z²⁰⁶ substituiert sind, oder -OY²²¹, -SY²²², -NHY²²³, -NY²²⁴Y²²⁵ oder -NHC(O)Y²²⁶ sind;
Y²²¹ bis Y²²⁶ jeweils unabhängig eine Alkylgruppe mit 1 bis 20 Kohlenstoffatomen, eine Alkenylgruppe mit 2 bis 20 Kohlenstoffatomen oder eine Alkinylgruppe mit 2 bis 20 Kohlenstoffatomen, die gegebenenfalls mit Z²⁰⁴ substituiert sind, oder eine Arylgruppe mit 6 bis 20 Kohlenstoffatomen oder eine Heteroarylgruppe mit 2 bis 20 Kohlenstoffatomen sind, die gegebenenfalls mit Z²⁰⁵ substituiert sind;
Z²⁰⁴ eine Arylgruppe mit 6 bis 20 Kohlenstoffatomen oder eine Heteroarylgruppe mit 2 bis 20 Kohlenstoffatomen ist; Z²⁰⁵ eine Alkylgruppe mit 1 bis 20 Kohlenstoffatomen, eine Alkenylgruppe mit 2 bis 20 Kohlenstoffatomen oder eine Alkinylgruppe mit 2 bis 20 Kohlenstoffatomen ist; Z²⁰⁶ eine Alkylgruppe mit 1 bis 20 Kohlenstoffatomen, eine Alkenylgruppe mit 2 bis 20 Kohlenstoffatomen, eine Alkinylgruppe mit 2 bis 20 Kohlenstoffatomen, eine Dialkylaminogruppe, wobei jedes Alkyl eine Alkylgruppe mit 1 bis 20 Kohlenstoffatomen ist, oder eine Diarylaminogruppe ist, wobei jedes Aryl eine Arylgruppe mit 6 bis 20 Kohlenstoffatomen ist; und
die Indizes n¹ bis n³ jeweils unabhängig für eine positive ganze Zahl stehen und die Bedingung 4 ≤ n¹+n²+n³ ≤ 20 erfüllen.

7. Ladungstransportierender Lack nach Anspruch 1, wobei das organische Lösungsmittel außerdem zumindest eines umfasst, das aus der aus Glykolen, Triolen, Alkylenglykolen, Alkylenglykolmonoalkylethern, Alkylenglykoldialkylethern, Dialkylenglykolmonoalkylethern und Dialkylenglykoldialkylethern bestehenden Gruppe ausgewählt ist.

8. Verfahren zur Herstellung eines ladungstransportierenden Dünnfilms, wobei das Verfahren durch Aufbringen eines ladungstransportierenden Lacks nach einem der Ansprüche 1 bis 7 auf ein Substrat und Härten gekennzeichnet ist.

9. Verfahren zur Erzeugung einer organischen Elektrolumineszenzvorrichtung, wobei das Verfahren durch Bereitstellen eines Elektrodenpaars und Herstellen eines ladungstransportierenden Dünnfilms unter Anwendung eines Verfahrens nach Anspruch 8 zwischen den Elektroden gekennzeichnet ist.

10. Verfahren zu Erhöhung der Ebenheit eines ladungstransportierenden Dünnfilms, wobei das Verfahren das Aufbringen eines ladungstransportierenden Lacks nach einem der Ansprüche 1 bis 7 auf ein Substrat und Härten umfasst, **dadurch gekennzeichnet, dass** das organische Lösungsmittel ein Säureamidderivat der nachstehenden Formel (A) ist 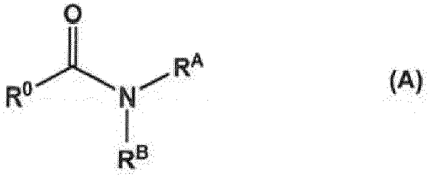 worin R° eine Propyl- oder Isopropylgruppe ist und R^{A} und R^{B} jeweils unabhängig eine Alkylgruppe mit 1 bis 4 Kohlenstoffatomen sind.

## Revendications

1. Vernis de transport de charge comprenant une substance de transport de charge choisie parmi un dérivé de l'aniline, un dérivé du thiophène et un dérivé du pyrrole et ayant un poids moléculaire de 200 à 9 000 comme mesuré dans la description ; un dopant choisi parmi des hétéropolyacides et des acides arylsulfoniques ; et un solvant organique, lequel vernis de transport de charge est **caractérisé en ce que** le solvant organique comprend, en tant que bon solvant, un dérivé d'amide d'acide de formule (A) ci-dessous 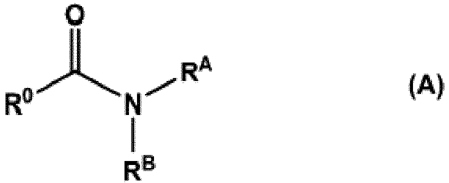 dans laquelle R⁰ est un groupe propyle ou isopropyle, et R^{A} et R^{B} sont chacun indépendamment un groupe alkyle de 1 à 4 atomes de carbone.

2. Vernis de transport de charge selon la revendication 1, dans lequel le dérivé d'amide d'acide est le N,N-diméthylisobutyramide.

3. Vernis de transport de charge selon la revendication 1 ou 2, dans lequel la substance de transport de charge comprend au moins un composé choisi parmi les dérivés de l'aniline et les dérivés du thiophène.

4. Vernis de transport de charges selon l'une quelconque des revendications 1 à 3, dans lequel la substance de transport de charge est un dérivé de l'aniline représenté par la formule (1) ou (2), 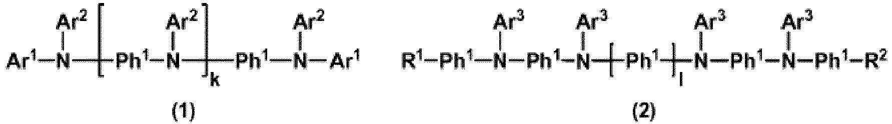 dans laquelle
R¹ et R² sont chacun indépendamment un atome d'hydrogène, un atome d'halogène, un groupe nitro, un groupe cyano ou un groupe alkyle de 1 à 20 atomes de carbone, un groupe alcényle de 2 à 20 atomes de carbone, un groupe alcynyle de 2 à 20 atomes de carbone, un groupe aryle de 6 à 20 atomes de carbone ou un groupe hétéroaryle de 2 à 20 atomes de carbone qui peut être substitué par un atome d'halogène ;
Ph¹ représente un groupe de formule (P1), 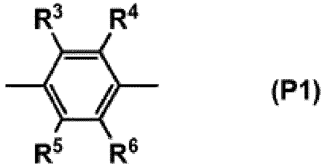 dans laquelle R³ à R⁶ sont chacun indépendamment un atome d'hydrogène, un atome d'halogène, un groupe nitro, un groupe cyano ou un groupe alkyle de 1 à 20 atomes de carbone, un groupe alcényle de 2 à 20 atomes de carbone, un groupe alcynyle de 2 à 20 atomes de carbone, un groupe aryle de 6 à 20 atomes de carbone ou un groupe hétéroaryle de 2 à 20 atomes de carbone qui peut être substitué par un atome d'halogène ;
chaque Ar¹ est indépendamment un groupe représenté par l'une quelconque des formules (B1) à (B11), 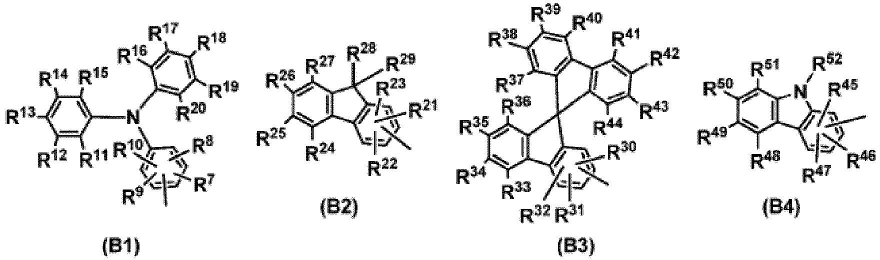 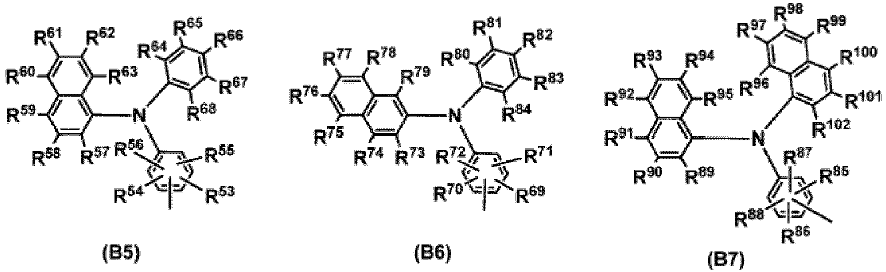 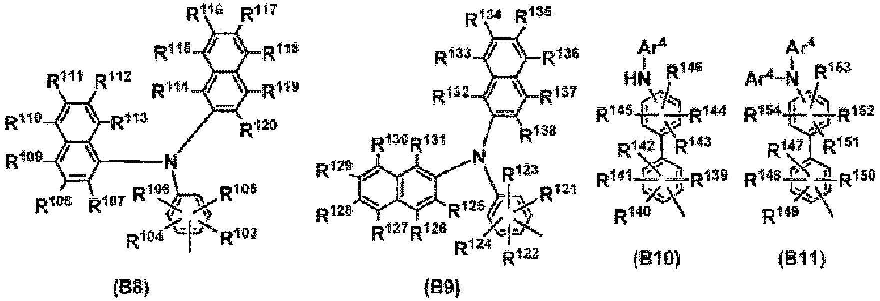 dans lesquelles R⁷ à R²⁷, R³⁰ à R⁵¹ et R⁵³ à R¹⁵⁴ sont chacun indépendamment un atome d'hydrogène, un atome d'halogène, un groupe nitro, un groupe cyano ou un groupe diphénylamino, un groupe alkyle de 1 à 20 atomes de carbone, un groupe alcényle de 2 à 20 des atomes de carbone, un groupe alcynyle de 2 à 20 atomes de carbone, un groupe aryle de 6 à 20 atomes de carbone ou un groupe hétéroaryle de 2 à 20 atomes de carbone qui peut être substitué par un atome d'halogène ; R²⁸ et R²⁹ sont chacun indépendamment un groupe aryle de 6 à 20 atomes de carbone ou un groupe hétéroaryle de 2 à 20 atomes de carbone qui peut être substitué par Z¹ ; R⁵² est un atome d'hydrogène, un groupe alkyle de 1 à 20 atomes de carbone, un groupe alcényle de 2 à 20 atomes de carbone ou un groupe alcynyle de 2 à 20 atomes de carbone qui peut être substitué par Z⁴, ou un groupe aryle de 6 à 20 atomes de carbone ou un groupe hétéroaryle de 2 à 20 atomes de carbone qui peut être substitué par Z¹ ; Z¹ est un atome d'halogène, un groupe nitro, un groupe cyano ou un groupe alkyle de 1 à 20 atomes de carbone, un groupe alcényle de 2 à 20 atomes de carbone ou un groupe alcynyle de 2 à 20 atomes de carbone qui peut être substitué par Z² ; Z² est un atome d'halogène, un groupe nitro, un groupe cyano ou un groupe aryle de 6 à 20 atomes de carbone ou un groupe hétéroaryle de 2 à 20 atomes de carbone qui peut être substitué par Z³ ; Z³ est un atome d'halogène, un groupe nitro ou un groupe cyano ; Z⁴ est un atome d'halogène, un groupe nitro, un groupe cyano ou un groupe aryle de 6 à 20 atomes de carbone ou un groupe hétéroaryle de 2 à 20 atomes de carbone qui peut être substitué par Z⁵ ; Z⁵ est un atome d'halogène, un groupe nitro, un groupe cyano ou un groupe alkyle de 1 à 20 atomes de carbone, un groupe alcényle de 2 à 20 atomes de carbone ou un groupe alcynyle de 2 à 20 atomes de carbone qui peut être substitué par Z³ ; et Ar⁴ est chacun indépendamment un groupe aryle de 6 à 20 atomes de carbone qui peut être substitué par un groupe diarylamino dans lequel chaque groupe aryle est un groupe aryle de 6 à 20 atomes de carbone ;
Ar² est chacun indépendamment un groupe de l'une quelconque des formules (Al) à (A18), 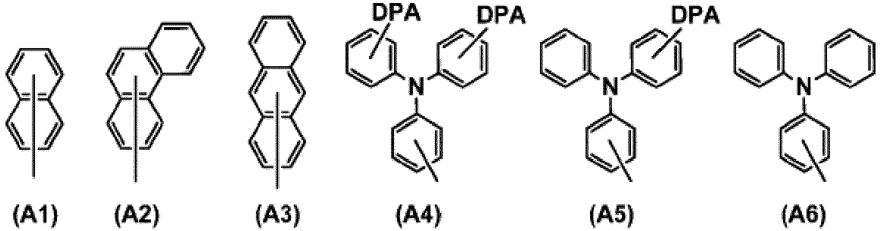 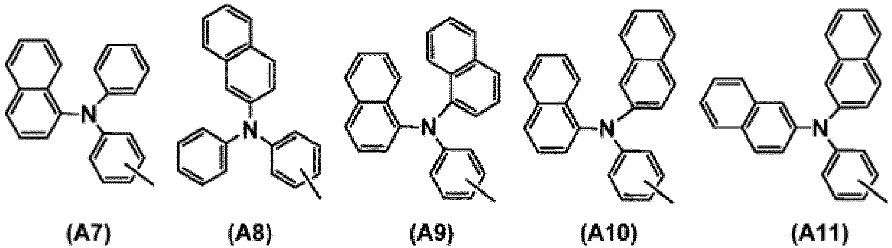 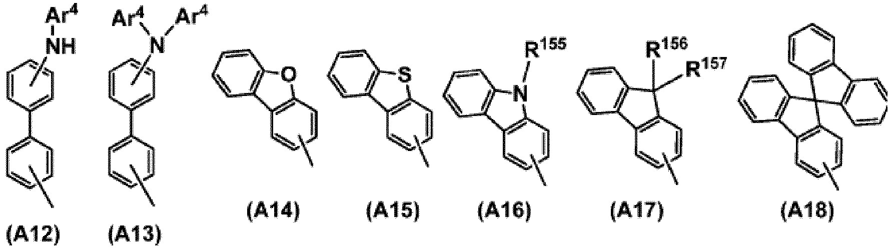 dans lesquelles R¹⁵⁵ est un atome d'hydrogène, un groupe alkyle de 1 à 20 atomes de carbone, un groupe alcényle de 2 à 20 atomes de carbone ou un groupe alcynyle de 2 à 20 atomes de carbone qui peut être substitué par Z⁴, ou un groupe aryle de 6 à 20 atomes de carbone ou un groupe hétéroaryle de 2 à 20 atomes de carbone qui peut être substitué par Z¹ ; R¹⁵⁶ et R¹⁵⁷ sont chacun indépendamment un groupe aryle de 6 à 20 atomes de carbone ou un groupe hétéroaryle de 2 à 20 atomes de carbone qui peut être substitué par Z¹ ; DPA représente un groupe diphénylamino ; et Ar⁴, Z¹ et Z⁴ sont tels que définis ci-dessus ;
Ar³ est un groupe de l'une quelconque des formules (C1) à (C8), 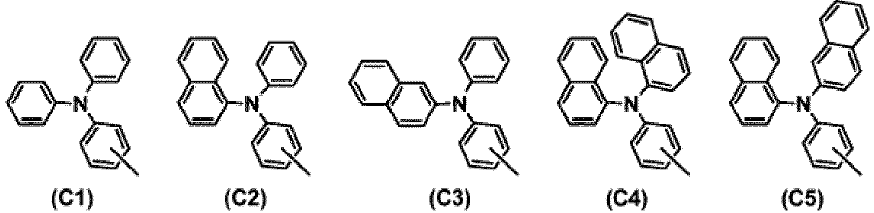 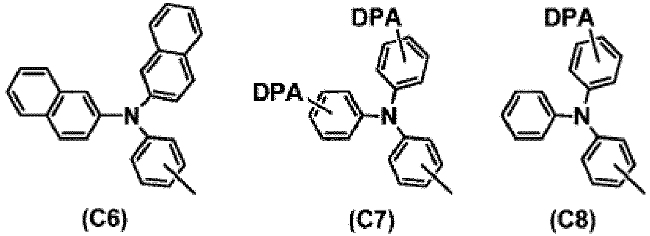
dans lesquelles DPA est tel que défini ci-dessus ;
k est un nombre entier de 1 à 10 ; et
la lettre « 1 » représente 1 ou 2.

5. Vernis de transport de charges selon l'une quelconque des revendications 1 à 3, dans lequel la substance de transport de charge est un dérivé de l'aniline représenté par la formule (13), 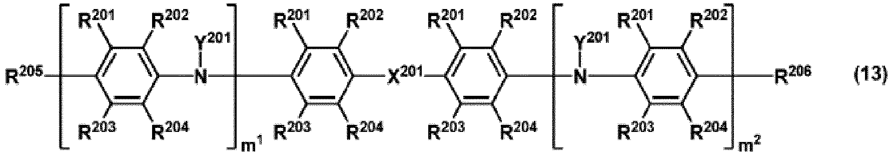 dans laquelle
X²⁰¹ est -NY²⁰¹-, -O-, -S-, - (CR²⁰⁷R²⁰⁸) L- ou une liaison simple, à condition que lorsque m¹ ou m² vaut 0, X²⁰¹ est - NY²⁰¹- ; chaque Y²⁰¹ est indépendamment un atome d'hydrogène, un groupe alkyle de 1 à 20 atomes de carbone, un groupe alcényle de 2 à 20 atomes de carbone ou un groupe alcynyle de 2 à 20 atomes de carbone qui peut être substitué par Z²⁰¹, ou un groupe aryle de 6 à 20 atomes de carbone ou groupe hétéroaryle de 2 à 20 atomes de carbone qui peuvent être substitués par Z²⁰² ; R²⁰⁷ et R²⁰⁸ sont chacun indépendamment un atome d'hydrogène, un atome d'halogène, un groupe nitro, un groupe cyano, un groupe amino, un groupe aldéhyde, un groupe hydroxyle, un groupe thiol, un groupe acide sulfonique, un groupe acide carboxylique, un groupe alkyle un groupe de 1 à 20 atomes de carbone, un groupe alcényle de 2 à 20 atomes de carbone ou un groupe alcynyle de 2 à 20 atomes de carbone qui peut être substitué par Z¹, un groupe aryle de 6 à 20 atomes de carbone ou un groupe hétéroaryle de 2 à 20 atomes de carbone qui peut être remplacé par Z², ou un groupe -NHY²⁰², -NY²⁰³Y²⁰⁴, -C(O)Y²⁰⁵, -OY²⁰⁶, -SY²⁰⁷, -SO₃Y²⁰⁸, -C (O) OY²⁰⁹, -OC (O) Y²¹⁰, -C (O) NHY²¹¹ ou -C (O) NY²¹²Y²¹³ ;
R²⁰¹ à R²⁰⁶ sont chacun indépendamment un atome d'hydrogène, un atome d'halogène, un groupe nitro, un groupe cyano, un groupe amino, un groupe aldéhyde, un groupe hydroxyle, un groupe thiol, un groupe acide sulfonique, un groupe acide carboxylique, un alkyle un groupe de 1 à 20 atomes de carbone, un groupe alcényle de 2 à 20 atomes de carbone ou un groupe alcynyle de 2 à 20 atomes de carbone qui peut être substitué par Z²⁰¹, un groupe aryle de 6 à 20 atomes de carbone ou un groupe hétéroaryle de 2 à 20 atomes de carbone qui peut être substitué par Z²⁰², ou un groupe -NHY²⁰², -NY²⁰³Y²⁰⁴, -C(O)Y²⁰⁵, -OY²⁰⁶, -SY²⁰⁷, -SO₃Y²⁰⁸, -C(O)OY²⁰⁹,-OC(O)Y²¹⁰, -C(O)NHY²¹¹ ou -C(O)NY²¹²Y²¹³ ;
Y²⁰² à Y²¹³ sont chacun indépendamment un groupe alkyle de 1 à 20 atomes de carbone, un groupe alcényle de 2 à 20 atomes de carbone ou un groupe alcynyle de 2 à 20 atomes de carbone qui peut être substitué par Z²⁰¹ ou un groupe aryle de 6 à 20 atomes de carbone ou un groupe hétéroaryle de 2 à 20 atomes de carbone qui peut être substitué par Z²⁰² ; Z¹ est un atome d'halogène, un groupe nitro, un groupe cyano ou un groupe alkyle de 1 à 20 atomes de carbone, un groupe alcényle de 2 à 20 atomes de carbone ou un groupe alcynyle de 2 à 20 atomes de carbone qui peut être substitué par Z² ; Z² est un atome d'halogène, un groupe nitro, un groupe cyano ou un groupe aryle de 6 à 20 atomes de carbone ou un groupe hétéroaryle de 2 à 20 atomes de carbone qui peut être substitué par Z³ ; Z³ est un atome d'halogène, un groupe nitro ou un groupe cyano ; Z²⁰¹ est un atome d'halogène, un groupe nitro, un groupe cyano, un groupe amino, un groupe aldéhyde, un groupe hydroxyle, un groupe thiol, un groupe acide sulfonique, un groupe acide carboxylique ou un groupe aryle de 6 à 20 atomes de carbone ou un groupe hétéroaryle de 2 à 20 atomes de carbone qui peut être substitué par Z²⁰³ ; Z²⁰² est un atome d'halogène, un groupe nitro, un groupe cyano, un groupe amino, un groupe aldéhyde, un groupe hydroxyle, un groupe thiol, un groupe acide sulfonique, un groupe acide carboxylique ou un groupe alkyle de 1 à 20 atomes de carbone , un groupe alcényle de 2 à 20 atomes de carbone ou un groupe alcynyle de 2 à 20 atomes de carbone qui peut être substitué par Z²⁰³ ; Z²⁰³ est un atome d'halogène, un groupe nitro, un groupe cyano, un groupe amino, un groupe aldéhyde, un groupe hydroxyle, un groupe thiol, un groupe acide sulfonique ou un groupe acide carboxylique ; et L est un nombre entier de 1 à 20 ; et
m¹ et m² représentent indépendamment un nombre entier égal ou supérieur à 0 et satisfont à la condition 1 ≤ m¹ + m² ≤ 20.

6. Vernis de transport de charges selon l'une quelconque des revendications 1 à 3, dans lequel la substance de transport de charge est un dérivé du thiophène représenté par la formule (14), 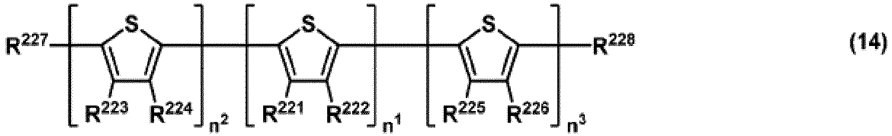 dans laquelle
R²²¹ à R²²⁶ sont chacun indépendamment un atome d'hydrogène, un groupe alkyle de 1 à 20 atomes de carbone, un groupe alcényle de 2 à 20 atomes de carbone ou un groupe alcynyle de 2 à 20 atomes de carbone qui peut être substitué par Z²⁰⁴, un groupe aryle de 6 à 20 atomes de carbone ou groupe hétéroaryle de 2 à 20 atomes de carbone qui peuvent être substitués par Z²⁰⁵, ou -OY²²¹, -SY²²², -NHY²²³, -NY²²⁴Y²²⁵ ou-NHC(O)Y²²⁶ dans les cas où R²²¹ à R²²⁶ ne sont pas des atomes d'hydrogène, R²²¹ et R²²², R²²³ et R²²⁴ et/ou R²²⁵ et R²²⁶ peuvent se lier mutuellement pour former des groupes divalents ;
R²²⁷ et R²²⁸ sont chacun indépendamment un atome d'hydrogène, un groupe alkyle de 1 à 20 atomes de carbone, un groupe alcényle de 2 à 20 atomes de carbone ou un groupe alcynyle de 2 à 20 atomes de carbone qui peut être substitué par Z²⁰⁴, un groupe aryle de 6 à 20 atomes de carbone ou un groupe hétéroaryle de 2 à 20 atomes de carbone qui peuvent être substitués par Z²⁰⁶, ou -OY²²¹, -SY²²², -NHY²²³, -NY²²⁴Y²²⁵ ou -NHC(O)Y²²⁶ ;
Y²²¹ à Y²²⁶ sont chacun indépendamment un groupe alkyle de 1 à 20 atomes de carbone, un groupe alcényle de 2 à 20 atomes de carbone ou un groupe alcynyle de 2 à 20 atomes de carbone qui peut être substitué par Z²⁰⁴, ou un groupe aryle de 6 à 20 atomes de carbone ou un groupe hétéroaryle de 2 à 20 atomes de carbone qui peut être substitué par Z²⁰⁵ ;
Z²⁰⁴ est un groupe aryle de 6 à 20 atomes de carbone ou un groupe hétéroaryle de 2 à 20 atomes de carbone ; Z²⁰⁵ est un groupe alkyle de 1 à 20 atomes de carbone, un groupe alcényle de 2 à 20 atomes de carbone ou un groupe alcynyle de 2 à 20 atomes de carbone ; Z²⁰⁶ est un groupe alkyle de 1 à 20 atomes de carbone, un groupe alcényle de 2 à 20 atomes de carbone, un groupe alcynyle de 2 à 20 atomes de carbone, un groupe dialkylamino dans lequel chaque alkyle est un groupe alkyle de 1 à 20 atomes de carbone ou un groupe diarylamino dans lequel chaque aryle est un groupe aryle de 6 à 20 atomes de carbone ; et
les indices n¹ à n³ représentent indépendamment un nombre entier positif et satisfont à la condition 4 ≤ n¹ + n² + n³ ≤ 20.

7. Vernis de transport de charge selon la revendication 1, dans lequel le solvant organique comprend en outre au moins un choisi dans le groupe constitué par les glycols, les triols, les alkylène glycols, les éthers monoalkyliques d'alkylène glycol, les éthers dialkyliques d'alkylène glycol, les éthers monoalkyliques de dialkylène glycol et les éthers dialkyliques de dialkylène glycol.

8. Procédé de production d'un film mince de transport de charges, lequel procédé est **caractérisé par** l'application d'un vernis de transport de charges selon l'une quelconque des revendications 1 à 7 sur un substrat et sa cuisson.

9. Procédé de fabrication d'un dispositif électroluminescent organique, lequel procédé est **caractérisé par** la fourniture d'une paire d'électrodes et la production d'un film mince de transport de charge en utilisant le procédé selon la revendication 8 entre les électrodes.

10. Procédé pour augmenter la planéité d'un film mince de transport de charge, le procédé comprenant l'application d'un vernis de transport de charges selon l'une quelconque des revendications 1 à 7 sur un substrat et sa cuisson **caractérisé en ce que** le solvant organique est un dérivé d'amide d'acide de formule (A) ci-dessous 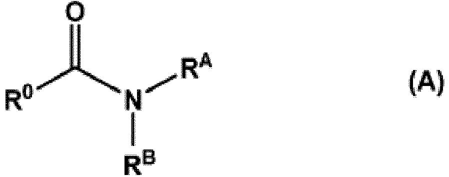 dans laquelle R⁰ est un groupe propyle ou isopropyle, et R^{A} et R^{B} sont chacun indépendamment un groupe alkyle de 1 à 4 atomes de carbone.
